(19) Europäisches Patentamt
European Patent Office
Office européen des brevets

(11) EP 3 168 223 B1

(12) **EUROPEAN PATENT SPECIFICATION**

(45) Date of publication and mention of the grant of the patent:
**16.10.2019 Bulletin 2019/42**

(21) Application number: **15818212.1**

(22) Date of filing: **02.07.2015**

(51) Int Cl.:
***C07F 15/00*** *(2006.01)* ***C09K 11/06*** *(2006.01)*
***H01L 51/00*** *(2006.01)* ***H01L 51/50*** *(2006.01)*

(86) International application number:
**PCT/JP2015/069108**

(87) International publication number:
**WO 2016/006523 (14.01.2016 Gazette 2016/02)**

(54) **METAL COMPLEX AND LIGHT EMITTING ELEMENT USING SAME**

METALLKOMPLEX UND LICHTEMITTIERENDES ELEMENT DAMIT

COMPLEXE MÉTALLIQUE ET ÉLÉMENT ÉLECTROLUMINESCENT L'UTILISANT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **08.07.2014 JP 2014140241**

(43) Date of publication of application:
**17.05.2017 Bulletin 2017/20**

(73) Proprietor: **Sumitomo Chemical Company, Limited**
**Tokyo 104-8260 (JP)**

(72) Inventors:
- **ABE, Taichi**
**Tsukuba-shi**
**Ibaraki 300-3294 (JP)**
- **ASADA, Kohei**
**Tsukuba-shi**
**Ibaraki 300-3294 (JP)**
- **OHUCHI, Kazuei**
**Tsukuba-shi**
**Ibaraki 300-3294 (JP)**

(74) Representative: **J A Kemp**
**14 South Square**
**Gray's Inn**
**London WC1R 5JJ (GB)**

(56) References cited:
**WO-A1-2014/156922** **WO-A1-2015/046452**
**JP-A- 2008 210 941** **JP-A- 2009 102 533**
**JP-A- 2014 196 258** **US-A1- 2014 167 001**

Remarks:
The file contains technical information submitted after the application was filed and not included in this specification

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 168 223 B1

## Description

Technical Field

The present invention relates to a metal complex, a composition comprising the metal complex, and a light emitting device produced by using the metal complex.

Background Art

As a light emitting material used in a light emitting layer of a light emitting device, a phosphorescent compound showing light emission from the triplet excited state, and the like, are under study. For example, Patent document 1 discloses metal complex A represented by the following formula. Patent document 2 discloses metal complex B and metal complex C represented by the following formulae. These metal complexes are metal complexes the ligand of which has a phenyltriazole structure.

[Chemical Formula 1]

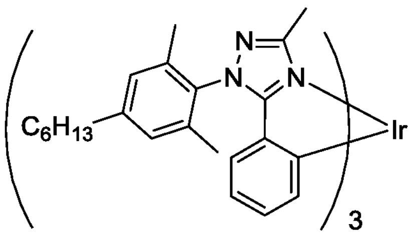

Metal complex A

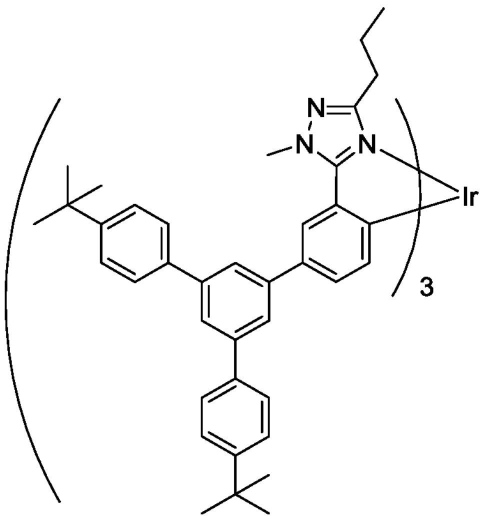

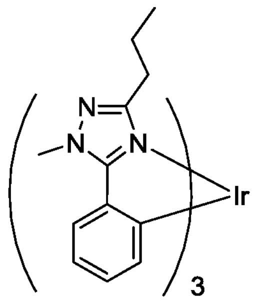

Metal complex C

Metal complex B

Patent document 3 discloses Metal complex D, a blue phosphorescence compound represented by the following formula.

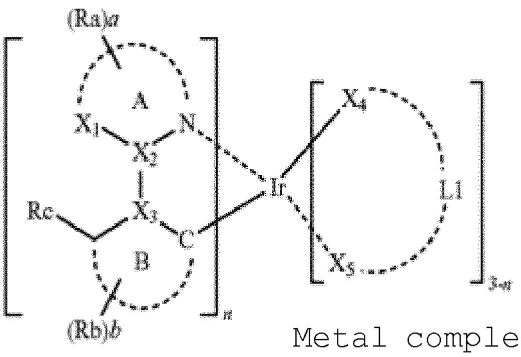

Metal complex D

[Prior Art Document]

[Patent Document]

[Patent document 1] US Patent Application Publication No. 2014/0151659
[Patent document 2] JP-A No. 2013-147551
[Patent document 3] US Patent Application Publication No. 2014/167001

Summary of the Invention

Problem to be Solved by the Invention

However, the above-described metal complexes had no sufficient light emission stability.

Then, the present invention has an object of providing a metal complex excellent in light emission stability. Further, the present invention has an object of providing a composition comprising the metal complex and a light emitting device produced by using the metal complex.

In this specification, "a metal complex excellent in light emission stability" means that when a metal complex is excited continuously under certain excitation conditions, the luminance of light emission from the triplet excited state of the metal complex is less likely to low. The method for exciting a metal complex may be any of photoexcitation and current excitation.

Means for Solving the Problem

The present invention provides:

[1] A metal complex represented by the following formula (1-b) :

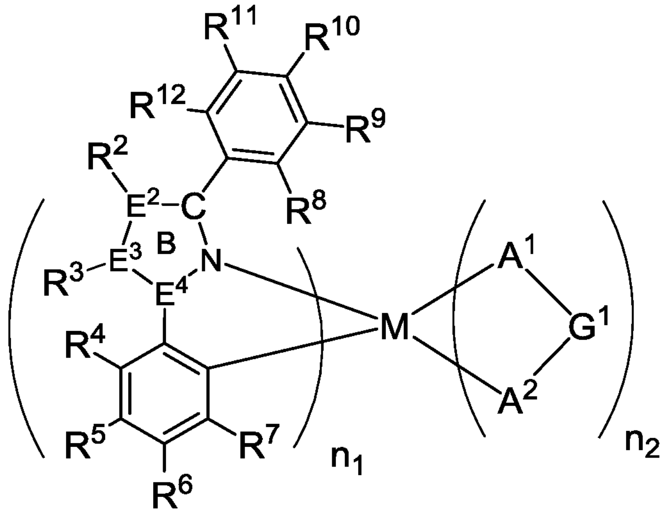

(1-b)

[wherein,

M represents an iridium atom or a platinum atom.

$n_1$ represents 1, 2 or 3. $n_2$ represents 0, 1 or 2. $n_1$+$n_2$ is 3 when M is an iridium atom, while $n_1$+$n_2$ is 2 when M is a platinum atom.

$E^2$ and $E^3$ represent a nitrogen atom, and $E^4$ represents a carbon atom. $R^2$ and $R^3$ may be either present or not present.

$R^2$ and $R^3$ each independently represent a hydrogen atom, an alkyl group, a cycloalkyl group, an alkoxy group, a cycloalkoxy group, an aryl group, an aryloxy group, a monovalent heterocyclic group or a halogen atom, and these groups each optionally have a substituent. When a plurality of $R^2$ and $R^3$ are present, they may be the same or different at each occurrence.

$R^4$, $R^5$, $R^6$ and $R^7$ each independently represent a hydrogen atom, an alkyl group, a cycloalkyl group, an alkoxy group, a cycloalkoxy group, an aryl group, an aryloxy group, a monovalent heterocyclic group or a halogen atom, and these groups each optionally have a substituent. When a plurality of $R^4$, $R^5$, $R^6$ and $R^7$ are present, they may be the same or different at each occurrence. $R^4$ and $R^5$ may be combined together to form a ring together with the carbon atoms to which they are attached, $R^5$ and $R^6$ may be combined together to form a ring together with the carbon atoms to which they are attached, and $R^6$ and $R^7$ may be combined together to form a ring together with the carbon atoms to which they are attached.

$R^8$, $R^{10}$ and $R^{12}$ each independently represent a hydrogen atom, an alkyl group, a cycloalkyl group, an alkoxy group, a cycloalkoxy group, an aryl group, an aryloxy group, a monovalent heterocyclic group or a halogen atom, and these groups each optionally have a substituent.

$R^9$ and $R^{11}$ each independently represent an alkyl group and this alkyl group optionally has a substituent.

When a plurality of $R^8$, $R^9$, $R^{10}$, $R^{11}$ and $R^{12}$ are present, they may be the same or different at each occurrence.
The ring B represents a triazole ring.
$A^1$-$G^1$-$A^2$ represents an anionic bidentate ligand. $A^1$ and $A^2$ each independently represent a carbon atom, an oxygen atom or a nitrogen atom, and these atoms each may be an atom constituting a ring. $G^1$ represents a single bond or an atomic group constituting the bidentate ligand together with $A^1$ and $A^2$ . When a plurality of $A^1$-$G^1$-$A^2$ are present, they may be the same or different.].
[2] The metal complex according to [1] represented by the following formula (1-c):

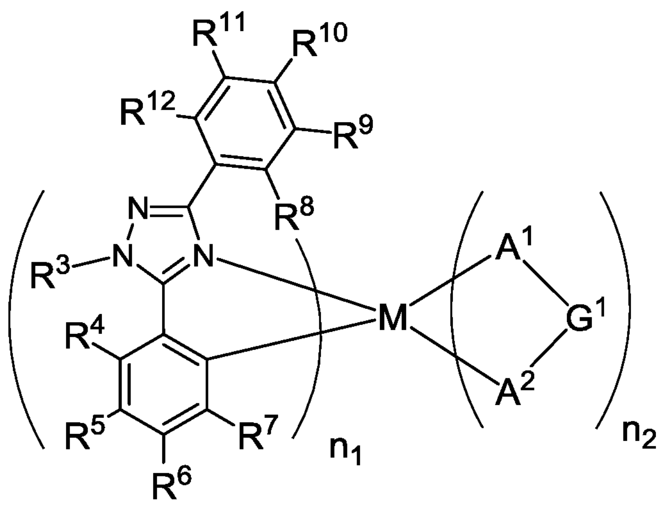

(1-c)

[wherein, M, $n_1$, $n_2$, $R^3$, $R^4$, $R^5$, $R^6$, $R^7$, $R^8$, $R^9$, $R^{10}$, $R^{11}$, $R^{12}$ and $A^1$-$G^1$-$A^2$ are as defined in [1].].
[3] The metal complex according to [1] represented by the following formula (1-d):

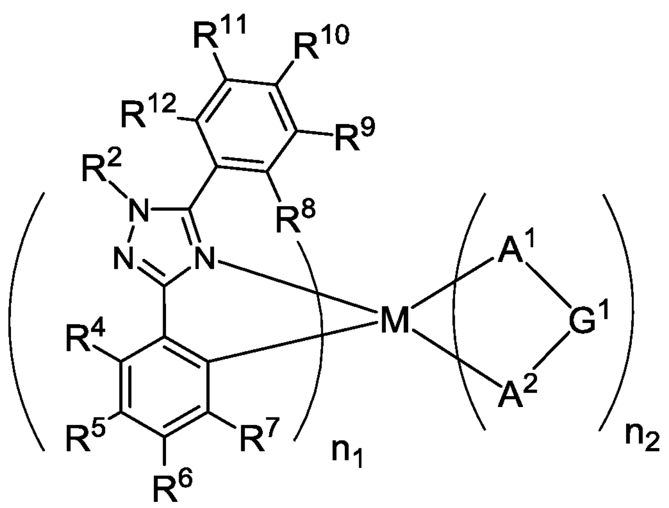

(1-d)

[wherein, M, $n_1$, $n_2$, $R^2$, $R^4$, $R^5$, $R^6$, $R^7$, $R^8$, $R^9$, $R^{10}$, $R^{11}$, $R^{12}$ and $A^1$-$G^1$-$A^2$ are as defined in [1].].

[4] The metal complex according to [2] represented by the following formula (1-e):

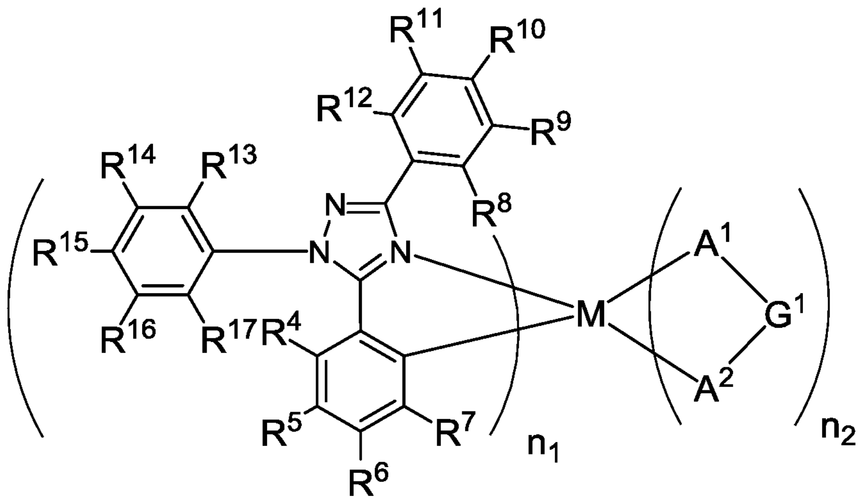

(1-e)

[wherein,

M, $n_1$, $n_2$, $R^4$, $R^5$, $R^6$, $R^7$, $R^8$, $R^9$, $R^{10}$, $R^{11}$, $R^{12}$ and $A^1$-$G^1$-$A^2$ are as defined in [1].

$R^{13}$, $R^{14}$, $R^{15}$, $R^{16}$ and $R^{17}$ each independently represent a hydrogen atom, an alkyl group, a cycloalkyl group, an alkoxy group, a cycloalkoxy group, an aryl group, an aryloxy group, a monovalent heterocyclic group or a halogen atom, and these groups each optionally have a substituent. When a plurality of $R^{13}$, $R^{14}$, $R^{15}$, $R^{16}$ and $R^{17}$ are present, they may be the same or different at each occurrence. $R^{13}$ and $R^{14}$ may be combined together to form a ring together with the carbon atoms to which they are attached, $R^{14}$ and $R^{15}$ may be combined together to form a ring together with the carbon atoms to which they are attached, $R^{15}$ and $R^{16}$ may be combined together to form a ring together with the carbon atoms to which they are attached, and $R^{16}$ and $R^{17}$ may be combined together to form a ring together with the carbon atoms to which they are attached.].

[5] The metal complex according to any one of [1] to [4], wherein at least one selected from the group consisting of $R^2$, $R^3$, $R^5$, $R^6$, $R^{10}$ and $R^{15}$ is a dendron.

[6] The metal complex according to [5], wherein at least one selected from the group consisting of $R^2$, $R^3$, $R^5$, $R^6$, $R^{10}$ and $R^{15}$ is a group represented by the following formula (D-A) or (D-B):

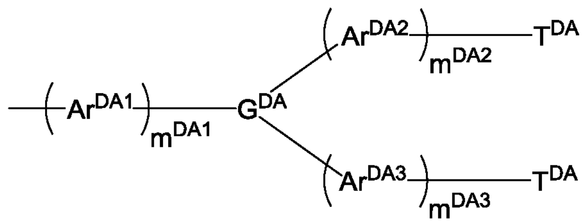

**(D-A)**

[wherein,

$m^{DA1}$, $m^{DA2}$ and $m^{DA3}$ each independently represent an integer of 0 or more.

$G^{DA}$ represents an aromatic hydrocarbon group or a heterocyclic group, and these groups each optionally have a substituent.

$Ar^{DA1}$, $Ar^{DA2}$ and $Ar^{DA3}$ each independently represent an arylene group or a divalent heterocyclic group, and these groups each optionally have a substituent. When a plurality of $Ar^{DA1}$, $Ar^{DA2}$ and $Ar^{DA3}$ are present, they may be the same or different at each occurrence.

$T^{DA}$ represents an aryl group or a monovalent heterocyclic group, and these groups each optionally have a substituent. The plurality of $T^{DA}$ may be the same or different.]

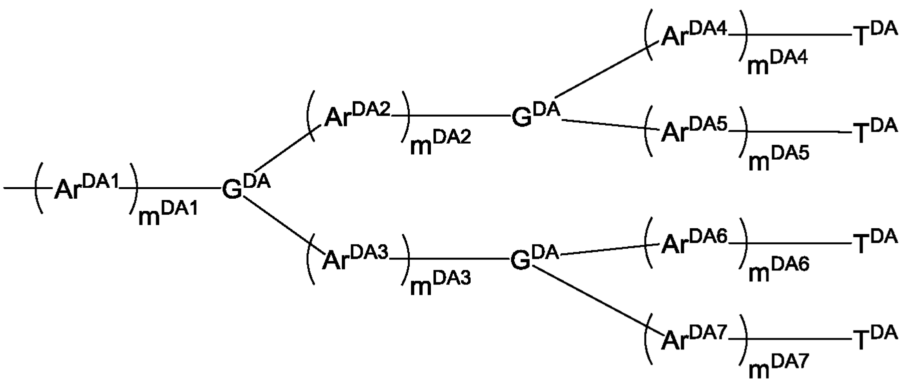

(D-B)

[wherein,

$m^{DA1}$, $m^{DA2}$, $m^{DA3}$, $m^{DA4}$, $m^{DA5}$, $m^{DA6}$ and $m^{DA7}$ each independently represent an integer of 0 or more.
$G^{DA}$ represents an aromatic hydrocarbon group or a heterocyclic group, and these groups each optionally have a substituent. The plurality of $G^{DA}$ maybe the same or different.
$Ar^{DA1}$, $Ar^{DA2}$, $Ar^{DA3}$, $Ar^{DA4}$, $Ar^{DA5}$, $Ar^{DA6}$ and $Ar^{DA7}$ each independently represent an arylene group or a divalent heterocyclic group, and these groups each optionally have a substituent. When a plurality of $Ar^{DA1}$, $Ar^{DA2}$, $Ar^{DA3}$, $Ar^{DA4}$, $Ar^{DA5}$, $Ar^{DA6}$ and $Ar^{DA7}$ are present, they may be the same or different at each occurrence.
$T^{DA}$ represents an aryl group or a monovalent heterocyclic group, and these groups each optionally have a substituent. The plurality of $T^{DA}$ may be the same or different.].

[7] The metal complex according to [6], wherein the group represented by the formula (D-A) is a group represented by the following formula (D-A1), (D-A2) or (D-A3):

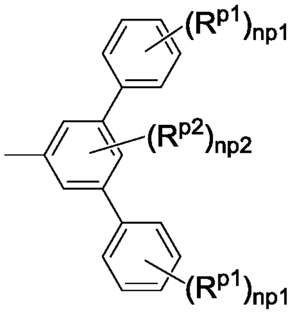

(D-A1)

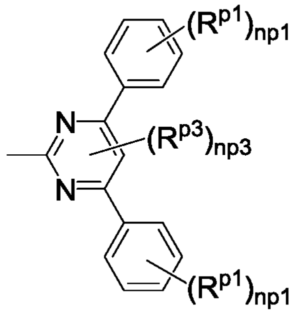

(D-A2)

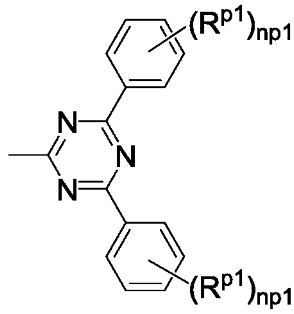

(D-A3)

[wherein,

$R^{p1}$, $R^{p2}$ and $R^{p3}$ each independently represent an alkyl group, a cycloalkyl group or a halogen atom. When a plurality of $R^{p1}$ and $R^{p2}$ are present, they may be the same or different at each occurrence. At least one selected from among a plurality of $R^{p1}$ is an alkyl group having 4 or more carbon atoms .
np1 represents an integer of 1 to 5, np2 represents an integer of 0 to 3, and np3 represents 0 or 1. The plurality of np1 may be the same or different.].

[8] The metal complex according to [7], wherein the group represented by the formula (D-A) is a group represented by the formula (D-A1).
[9] The metal complex according to any one of [1] to [8], wherein M is an iridium atom.
[10] The metal complex according to [9], wherein $n_1$ is 3.
[11] A composition comprising the metal complex according to any one of [1] to [10] and either a compound represented by the following formula (H-1):

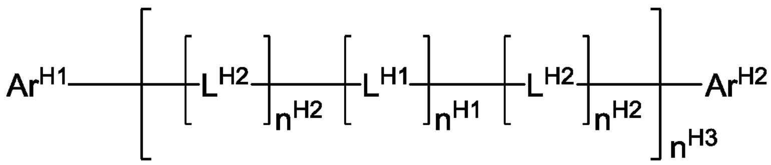 **(H-1)**

[wherein,

$Ar^{H1}$ and $Ar^{H2}$ each independently represent an aryl group or a monovalent heterocyclic group, and these groups each optionally have a substituent.
$n^{H1}$ and $n^{H2}$ each independently represent 0 or 1. When a plurality of $n^{H1}$ are present, they may be the same or different. The plurality of $n^{H2}$ may be the same or different.
$n^{H3}$ represents an integer of 0 or more.
$L^{H1}$ represents an arylene group, a divalent heterocyclic group or a group represented by $-[C(R^{H11})_2]n^{H11}-$, and these groups each optionally have a substituent. When a plurality of $L^{H1}$ are present, they may be the same or different.
$n^{H11}$ represents an integer of 1 to 10. $R^{H11}$ represents a hydrogen atom, an alkyl group, a cycloalkyl group, an alkoxy group, a cycloalkoxy group, an aryl group or a monovalent heterocyclic group, and these groups each optionally have a substituent. The plurality of $R^{H11}$ may be the same or different and may be combined together to form a ring together with the carbon atoms to which they are attached.
$L^{H2}$ represents a group represented by $-N(-L^{H21}-R^{H21})-$. When a plurality of $L^{H2}$ are present, they may be the same or different.
$L^{H21}$ represents a single bond, an arylene group or a divalent heterocyclic group, and these groups each optionally have a substituent. $R^{H21}$ represents a hydrogen atom, an alkyl group, a cycloalkyl group, an aryl group or a monovalent heterocyclic group, and these groups each optionally has a substituent.]; or
a polymer compound comprising a constitutional unit represented by the following formula (Y):

$$\left[ Ar^{Y1} \right] \qquad (Y)$$

[in the formula (Y), $Ar^{Y1}$ represents an arylene group, a divalent heterocyclic group or a divalent group in which at least one arylene group and at least one divalent heterocyclic group are bonded directly, and these groups each optionally have a substituent.]; or
at least one material selected from the group consisting of a hole transporting material, a hole injection material, an electron transporting material, an electron injection material, a light emitting material, an antioxidant and a solvent.

[12] A light emitting device produced by using the metal complex according to any one of [1] to [10].

Also described herein are the following [1*] to [17*]:

[1*] A metal complex represented by the following formula (1):

[Chemical Formula 2]

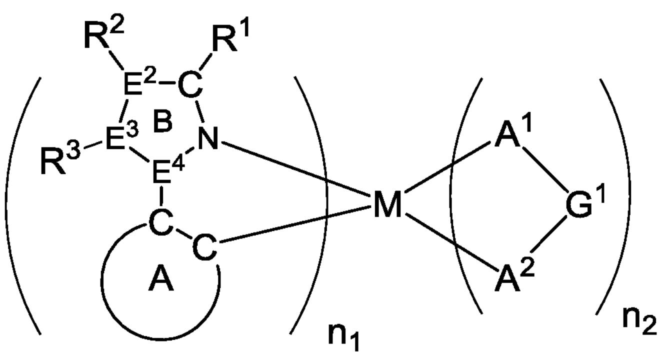 (1)

[wherein,

M represents an iridium atom or a platinum atom.

$n_1$ represents 1, 2 or 3. $n_2$ represents 0, 1 or 2. $n_1+n_2$ is 3 when M is an iridium atom, while $n_1+n_2$ is 2 when M is a platinum atom.

$E^2$, $E^3$ and $E^4$ each independently represent a nitrogen atom or a carbon atom. When a plurality of $E^2$ , $E^3$ and $E^4$ are present, they may be the same or different at each occurrence. $R^2$ and $R^3$ may be either present or not present when $E^2$ and $E^3$ are nitrogen atoms. Two selected from the group consisting of $E^2$, $E^3$ and $E^4$ are nitrogen atoms, and the remaining one is a carbon atom.

$R^1$ represents an aryl group or a monovalent heterocyclic group, and these groups each optionally have a substituent. When a plurality of $R^1$ are present, they may be the same or different.

$R^2$ and $R^3$ each independently represent a hydrogen atom, an alkyl group, a cycloalkyl group, an alkoxy group, a cycloalkoxy group, an aryl group, an aryloxy group, a monovalent heterocyclic group or a halogen atom, and these groups each optionally have a substituent. When a plurality of $R^2$ and $R^3$ are present, they may be the same or different at each occurrence.

The ring B represents a triazole ring.

The ring A represents an aromatic hydrocarbon ring or an aromatic heterocyclic ring, and these rings each optionally have a substituent.

$A^1$-$G^1$-$A^2$ represents an anionic bidentate ligand. $A^1$ and $A^2$ each independently represent a carbon atom, an oxygen atom or a nitrogen atom, and these atoms each may be an atom constituting a ring. $G^1$ represents a single bond or an atomic group constituting the bidentate ligand together with $A^1$ and $A^2$. When a plurality of $A^1$-$G^1$-$A^2$ are present, they may be the same or different.].

[2*] The metal complex according to [1*] represented by the following formula (1-a):

[Chemical Formula 3]

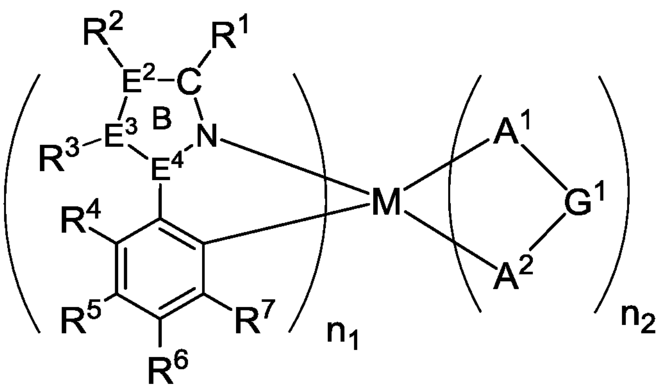

(1-a)

[wherein,

M, $n_1$, $n_2$ , $E^2$, $E^3$, $E^4$, $R^1$ , $R^2$, $R^3$, the ring B and $A^1$-$G^1$-$A^2$ represent the same meaning as described above.

$R^4$, $R^5$, $R^6$ and $R^7$ each independently represent a hydrogen atom, an alkyl group, a cycloalkyl group, an alkoxy group, a cycloalkoxy group, an aryl group, an aryloxy group, a monovalent heterocyclic group or a halogen atom, and these groups each optionally have a substituent. When a plurality of $R^4$, $R^5$, $R^6$ and $R^7$ are present, they may be the same or different at each occurrence. $R^4$ and $R^5$ may be combined together to form a ring together with the carbon atoms to which they are attached, $R^5$ and $R^6$ may be combined together to form a ring together with the carbon atoms to which they are attached, and $R^6$ and $R^7$ may be combined together to form a ring together with the carbon atoms to which they are attached.].

[3*] The metal complex according to [2*] represented by the following formula (1-b'):

[Chemical Formula 4]

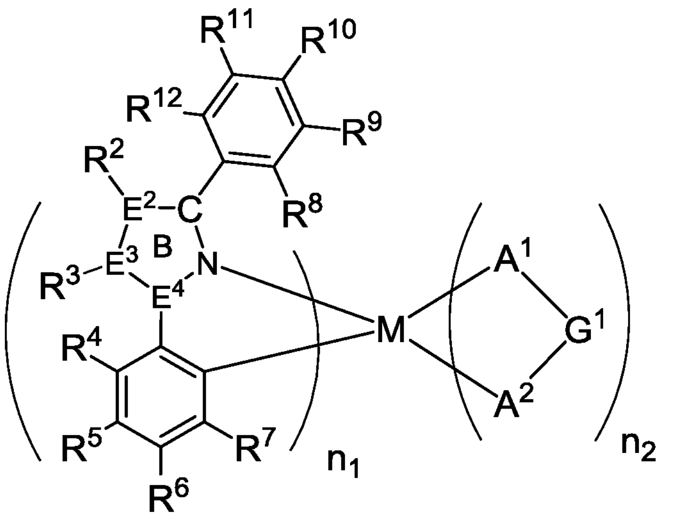

(1-b′)

[wherein,

M, $n_1$, $n_2$, $E^2$, $E^3$, $E^4$, $R^2$, $R^3$, $R^4$, $R^5$, $R^6$, $R^7$, the ring B and $A^1$-$G^1$-$A^2$ represent the same meaning as described above.

$R^8$, $R^9$, $R^{10}$, $R^{11}$ and $R^{12}$ each independently represent a hydrogen atom, an alkyl group, a cycloalkyl group, an alkoxy group, a cycloalkoxy group, an aryl group, an aryloxy group, a monovalent heterocyclic group or a halogen atom, and these groups each optionally have a substituent. When a plurality of $R^8$, $R^9$, $R^{10}$, $R^{11}$ and $R^{12}$ are present, they may be the same or different at each occurrence. $R^8$ and $R^9$ may be combined together to form a ring together with the carbon atoms to which they are attached, $R^9$ and $R^{10}$ may be combined together to form a ring together with the carbon atoms to which they are attached, $R^{10}$ and $R^{11}$ may be combined together to form a ring together with the carbon atoms to which they are attached, and $R^{11}$ and $R^{12}$ may be combined together to form a ring together with the carbon atoms to which they are attached.].

[4*] The metal complex according to [3*] represented by the following formula (1-c):

[Chemical Formula 5]

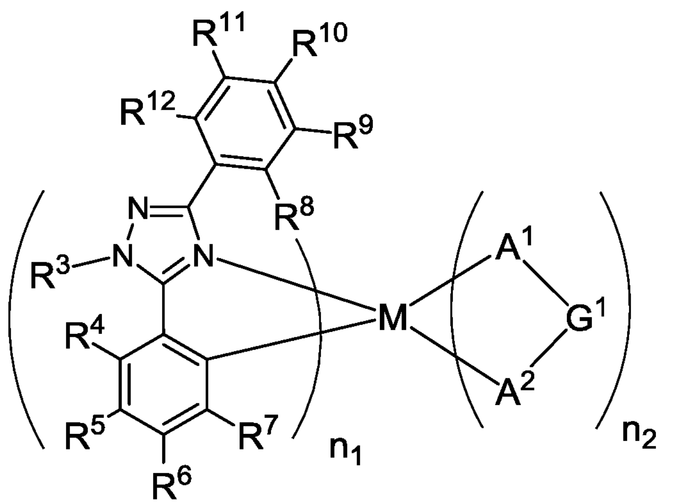

(1-c)

[wherein, M, $n_1$, $n_2$, $R^3$, $R^4$, $R^5$, $R^6$, $R^7$, $R^8$, $R^9$, $R^{10}$, $R^{11}$, $R^{12}$ and $A^1$-$G^1$-$A^2$ represent the same meaning as described

above.].

[5*] The metal complex according to [3*] represented by the following formula (1-d):

[Chemical Formula 6]

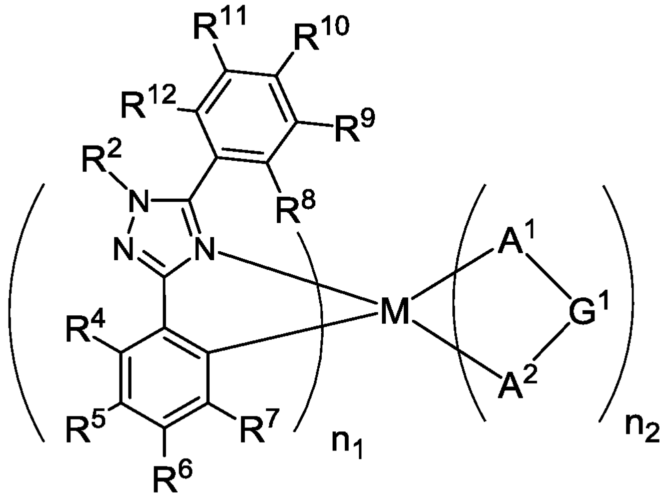

(1-d)

[wherein, M, $n_1$, $n_2$, $R^2$, $R^4$, $R^5$, $R^6$, $R^7$, $R^8$, $R^9$, $R^{10}$, $R^{11}$, $R^{12}$ and $A^1$-$G^1$-$A^2$ represent the same meaning as described above.].

[6*] The metal complex according to [4*] represented by the following formula (1-e):

[Chemical Formula 7]

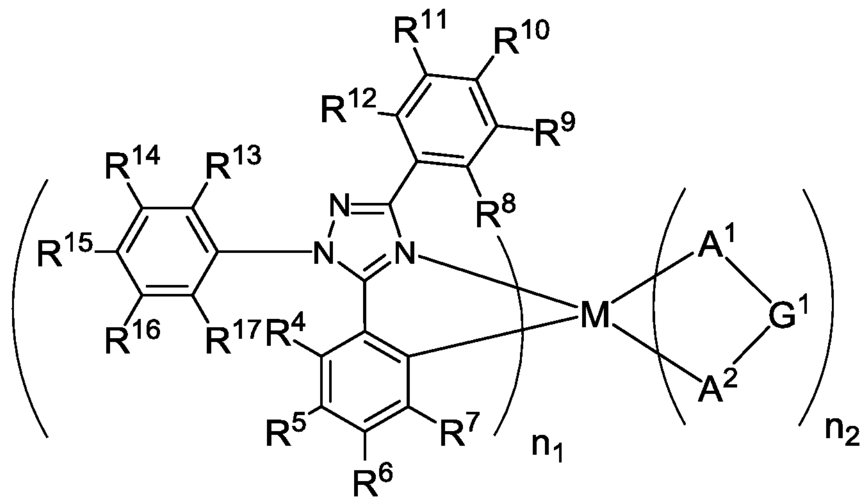

(1-e)

[wherein,

M, $n_1$, $n_2$, $R^4$, $R^5$, $R^6$, $R^7$, $R^8$, $R^9$, $R^{10}$, $R^{11}$, $R^{12}$ and $A^1$-$G^1$-$A^2$ represent the same meaning as described above. $R^{13}$, $R^{14}$, $R^{15}$, $R^{16}$ and $R^{17}$ each independently represent a hydrogen atom, an alkyl group, a cycloalkyl group, an alkoxy group, a cycloalkoxy group, an aryl group, an aryloxy group, a monovalent heterocyclic group or a halogen atom, and these groups each optionally have a substituent. When a plurality of $R^{13}$, $R^{14}$, $R^{15}$, $R^{16}$ and $R^{17}$ are present, they may be the same or different at each occurrence. $R^{13}$ and $R^{14}$ may be combined together to form a ring together with the carbon atoms to which they are attached, $R^{14}$ and $R^{15}$ may be combined together to form a ring together with the carbon atoms to which they are attached, $R^{15}$ and $R^{16}$ may be combined together to form a ring together with the carbon atoms to which they are attached, and $R^{16}$ and $R^{17}$ may be combined together to form a ring together with the carbon atoms to which they are attached.].

[7*] The metal complex according to any one of [3*] to [6*] , wherein $R^9$ and $R^{11}$ represent an alkyl group or an aryl group.

[8*] The metal complex according to any one of [1*] to [6*] , wherein at least one selected from the group consisting of $R^1$, $R^2$, $R^3$, $R^5$, $R^6$, $R^{10}$ and $R^{15}$ is a dendron.

[9*] The metal complex according to [8*], wherein at least one selected from the group consisting of $R^1$, $R^2$, $R^3$, $R^5$, $R^6$, $R^{10}$ and $R^{15}$ is a group represented by the following formula (D-A) or (D-B):

[Chemical Formula 8]

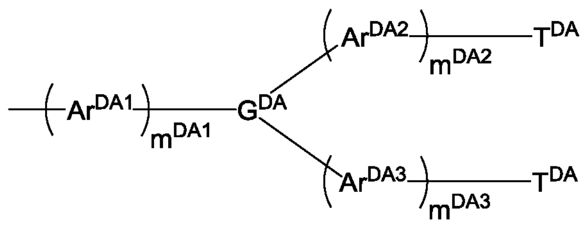

(D-A)

[wherein,

$m^{DA1}$ , $m^{DA2}$ and $m^{DA3}$ each independently represent an integer of 0 or more.

$G^{DA}$ represents an aromatic hydrocarbon group or a heterocyclic group, and these groups each optionally have a substituent.

$Ar^{DA1}$, $Ar^{DA2}$ and $Ar^{DA3}$ each independently represent an arylene group or a divalent heterocyclic group, and these groups each optionally have a substituent. When a plurality of $Ar^{DA1}$, $Ar^{DA2}$ and $Ar^{DA3}$ are present, they may be the same or different at each occurrence.

$T^{DA}$ represents an aryl group or a monovalent heterocyclic group, and these groups each optionally have a substituent. The plurality of $T^{DA}$ may be the same or different.]

[Chemical Formula 9]

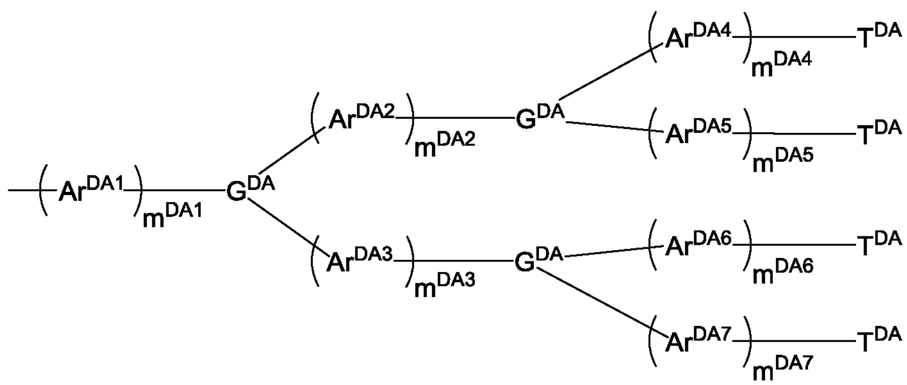

(D-B)

[wherein,

$m^{DA1}$, $m^{DA2}$, $m^{DA3}$, $m^{DA4}$, $m^{DA5}$, $m^{DA6}$ and $m^{DA7}$ each independently represent an integer of 0 or more.

$G^{DA}$ represents an aromatic hydrocarbon group or a heterocyclic group, and these groups each optionally have a substituent. The plurality of $G^{DA}$ may be the same or different.

$Ar^{DA1}$, $Ar^{DA2}$, $Ar^{DA3}$, $Ar^{DA4}$, $Ar^{DA5}$, $Ar^{DA6}$ and $Ar^{DA7}$ each independently represent an arylene group or a divalent heterocyclic group, and these groups each optionally have a substituent. When a plurality of $Ar^{DA1}$, $Ar^{DA2}$, $Ar^{DA3}$, $Ar^{DA4}$, $Ar^{DA5}$, $Ar^{DA6}$ and $Ar^{DA7}$ are present, they may be the same or different at each occurrence.

$T^{DA}$ represents an aryl group or a monovalent heterocyclic group, and these groups each optionally have a substituent. The plurality of $T^{DA}$ may be the same or different.].

[10*] The metal complex according to [9*], wherein the group represented by the formula (D-A) is a group represented by the following formula (D-A1), (D-A2) or (D-A3):

[Chemical Formula 10]

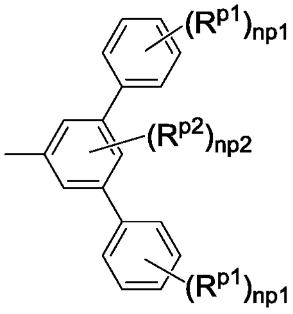

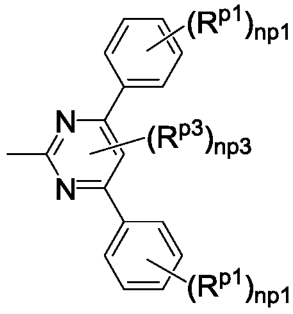

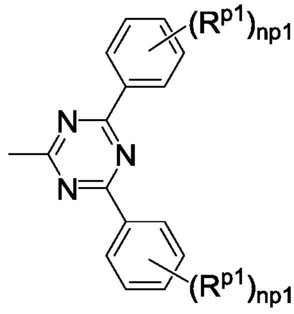

(D-A1) (D-A2) (D-A3)

[wherein,

$R^{p1}$, $R^{p2}$ and $R^{p3}$ each independently represent an alkyl group, a cycloalkyl group or a halogen atom. When a plurality of $R^{p1}$ and $R^{p2}$ are present, they may be the same or different at each occurrence. At least one selected from among a plurality of $R^{p1}$ is an alkyl group having 4 or more carbon atoms.

np1 represents an integer of 1 to 5, np2 represents an integer of 0 to 3, and np3 represents 0 or 1. The plurality of np1 may be the same or different.].

[11*] The metal complex according to [10*], wherein the group represented by the formula (D-A) is a group represented by the formula (D-A1).

[12*] The metal complex according to any one of [1*] to [11*], wherein M is an iridium atom.

[13*] The metal complex according to [12*], wherein $n_1$ is 3.

[14*] A composition comprising the metal complex according to any one of [1*] to [13*] and a compound represented by the following formula (H-1):

[Chemical Formula 11]

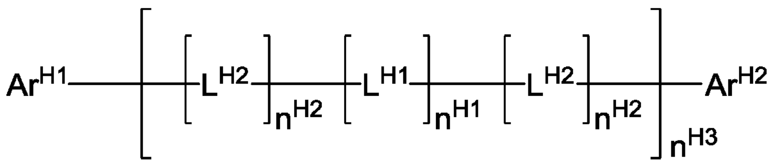

(H-1)

[wherein,

$Ar^{H1}$ and $Ar^{H2}$ each independently represent an aryl group or a monovalent heterocyclic group, and these groups each optionally have a substituent.

$n^{H1}$ and $n^{H2}$ each independently represent 0 or 1. When a plurality of $n^{H1}$ are present, they may be the same or different. The plurality of $n^{H2}$ may be the same or different.

$n^{H3}$ represents an integer of 0 or more.

$L^{H1}$ represents an arylene group, a divalent heterocyclic group or a group represented by $-[C(R^{H11})_2]n^{H11}-$, and these groups each optionally have a substituent. When a plurality of $L^{H1}$ are present, they may be the same or different.

$n^{H11}$ represents an integer of 1 to 10. $R^{H11}$ represents a hydrogen atom, an alkyl group, a cycloalkyl group, an alkoxy group, a cycloalkoxy group, an aryl group or a monovalent heterocyclic group, and these groups each optionally have a substituent. The plurality of $R^{H11}$ may be the same or different and may be combined together to form a ring together with the carbon atoms to which they are attached.

$L^{H2}$ represents a group represented by $-N(-L^{H21}-R^{H21})-$. When a plurality of $L^{H2}$ are present, they may be the same or different.

$L^{H21}$ represents a single bond, an arylene group or a divalent heterocyclic group, and these groups each optionally have a substituent. $R^{H21}$ represents a hydrogen atom, an alkyl group, a cycloalkyl group, an aryl group or a monovalent heterocyclic group, and these groups each optionally has a substituent.].

[15*] A composition comprising the metal complex according to any one of [1*] to [13*] and a polymer compound comprising a constitutional unit represented by the following formula (Y) :
[Chemical Formula 12]

$$\left[ Ar^{Y1} \right] \qquad (Y)$$

[in the formula (Y), $Ar^{Y1}$ represents an arylene group, a divalent heterocyclic group or a divalent group in which at least one arylene group and at least one divalent heterocyclic group are bonded directly, and these groups each optionally have a substituent.].
[16*] A composition comprising the metal complex according to any one of [1*] to [13*] and at least one material selected from the group consisting of a hole transporting material, a hole injection material, an electron transporting material, an electron injection material, a light emitting material, an antioxidant and a solvent.
[17*] A light emitting device produced by using the metal complex according to any one of [1*] to [13*].

Effect of the Invention

According to the present invention, a metal complex excellent in light emission stability can be provided. Further, according to the present invention, a composition comprising the metal complex and a light emitting device produced by using the metal complex can be provided. A light emitting device produced by using the metal complex is excellent in luminance life because the metal complex of the present invention is excellent in light emission stability.

Modes for Carrying Out the Invention

Suitable embodiments of the present invention will be illustrated in detail below.

<Explanation of common term>

Terms commonly used in the present specification have th e following meanings unless otherwise stated.
Me represents a methyl group, Et represents an ethyl group, Bu represents a butyl group, i-Pr represents an isopropyl group, and t-Bu represents a tert-butyl group.
A hydrogen atom may be a heavy hydrogen atom or a light hydrogen atom.
A solid line representing a bond to a central metal in a formula representing a metal complex denotes a covalent bond or a coordinate bond.
"Polymer compound" denotes a polymer having molecular weight distribution and having a polystyrene-equivalent number average molecular weight of $1\times10^3$ to $1\times10^8$.
A polymer compound may be any of a block copolymer, a random copolymer, an alternating copolymer and a graft copolymer, and may also be another embodiment.
An end group of a polymer compound is preferably a stable group because if a polymerization active group remains intact at the end, when the polymer compound is used for fabrication of a light emitting device, the light emitting property or luminance life possibly becomes lower. This end group is preferably a group having a conjugated bond to the main chain, and includes, for example, groups bonding to an aryl group or a monovalent heterocyclic group via a carbon-carbon bond.
"Low molecular weight compound" denotes a compound having no molecular weight distribution and having a molecular weight of $1\times10^4$ or less.
"Constitutional unit" denotes a unit structure found once or more in a polymer compound.
"Alkyl group" may be any of linear or branched. The number of carbon atoms of the linear alkyl group is, not including the number of carbon atoms of a substituent, usually 1 to 50, preferably 3 to 30, more preferably 4 to 20. The number of carbon atoms of the branched alkyl groups is, not including the number of carbon atoms of a substituent, usually 3 to 50, preferably 3 to 30, more preferably 4 to 20.
The alkyl group optionally has a substituent, and examples thereof include a methyl group, an ethyl group, a propyl group, an isopropyl group, a butyl group, an isobutyl group, a tert-butyl group, a pentyl group, an isoamyl group, a 2-ethylbutyl group, a hexyl group, a heptyl group, an octyl group, a 2-ethylhexyl group, a 3-propylheptyl group, a decyl group, a 3,7-dimethyloctyl group, a 2-ethyloctyl group, a 2-hexyldecyl group and a dodecyl group, and groups obtained by substituting a hydrogen atom in these groups with a cycloalkyl group, an alkoxy group, a cycloalkoxy group, an aryl group, a fluorine atom or the like, and the alkyl group having a substituent includes a trifluoromethyl group, a pentafluoroethyl group, a perfluorobutyl group, a perfluorohexyl group, a perfluorooctyl group, a 3-phenylpropyl group, a 3-(4-methylphenyl)propyl group, a 3-(3,5-di-hexylphenyl) propyl group and a 6-ethyloxyhexyl group.
The number of carbon atoms of "Cycloalkyl group" is, not including the number of carbon atoms of a substituent,

usually 3 to 50, preferably 3 to 30, more preferably 4 to 20.

The cycloalkyl group optionally has a substituent, and examples thereof include a cyclohexyl group, a cyclohexylmethyl group and a cyclohexylethyl group.

"Aryl group" denotes an atomic group remaining after removing from an aromatic hydrocarbon one hydrogen atom linked directly to a carbon atom constituting the ring. The number of carbon atoms of the aryl group is, not including the number of carbon atoms of a substituent, usually 6 to 60, preferably 6 to 20, more preferably 6 to 10.

The aryl group optionally has a substituent, and examples thereof include a phenyl group, a 1-naphthyl group, a 2-naphthyl group, a 1-anthracenyl group, a 2-anthracenyl group, a 9-anthracenyl group, a 1-pyrenyl group, a 2-pyrenyl group, a 4-pyrenyl group, a 2-fluorenyl group, a 3-fluorenyl group, a 4-fluorenyl group, a 2-phenylphenyl group, a 3-phenylphenyl group, a 4-phenylphenyl group, and groups obtained by substituting a hydrogen atom in these groups with an alkyl group, a cycloalkyl group, an alkoxy group, a cycloalkoxy group, an aryl group, a fluorine atom or the like.

"Alkoxy group" may be any of linear or branched. The number of carbon atoms of the linear alkoxy group is, not including the number of carbon atoms of a substituent, usually 1 to 40, preferably 4 to 10. The number of carbon atoms of the branched alkoxy group is, not including the number of carbon atoms of a substituent, usually 3 to 40, preferably 4 to 10.

The alkoxy group optionally has a substituent, and examples thereof include a methoxy group, an ethoxy group, a propyloxy group, an isopropyloxy group, a butyloxy group, an isobutyloxy group, a tert-butyloxy group, a pentyloxy group, a hexyloxy group, a heptyloxy group, an octyloxy group, a 2-ethylhexyloxy group, a nonyloxy group, a decyloxy group, a 3,7-dimethyloctyloxy group and a lauryloxy group, and groups obtained by substituting a hydrogen atom in these groups with a cycloalkyl group, an alkoxy group, a cycloalkoxy group, an aryl group, a fluorine atom or the like.

The number of carbon atoms of "Cycloalkoxy group" is, not including the number of carbon atoms of a substituent, usually 3 to 40, preferably 4 to 10.

The cycloalkoxy group optionally has a substituent, and examples thereof include a cyclohexyloxy group.

The number of carbon atoms of "Aryloxy group" is, not including the number of carbon atoms of a substituent, usually 6 to 60, preferably 7 to 48.

The aryloxy group optionally has a substituent, and examples thereof include a phenoxy group, a 1-naphthyloxy group, a 2-naphthyloxy group, a 1-anthracenyloxy group, a 9-anthracenyloxy group, a 1-pyrenyloxy group, and groups obtained by substituting a hydrogen atom in these groups with an alkyl group, a cycloalkyl group, an alkoxy group, a cycloalkoxy group, a fluorine atom or the like.

"p-Valent heterocyclic group" (p represents an integer of 1 or more) denotes an atomic group remaining after removing from a heterocyclic compound p hydrogen atoms among hydrogen atoms directly linked to a carbon atom or a hetero atom constituting the ring. Of p-valent heterocyclic groups, "p-valent aromatic heterocyclic groups" as an atomic group remaining after removing from an aromatic heterocyclic compound p hydrogen atoms among hydrogen atoms directly linked to a carbon atom or a hetero atom constituting the ring are preferable.

"Aromatic heterocyclic compound" denotes a compound in which the heterocyclic ring itself shows aromaticity such as oxadiazole, thiadiazole, thiazole, oxazole, thiophene, pyrrole, phosphole, furan, pyridine, pyrazine, pyrimidine, triazine, pyridazine, quinoline, isoquinoline, carbazole and dibenzophosphole, and a compound in which an aromatic ring is condensed to the heterocyclic ring even if the heterocyclic ring itself shows no aromaticity such as phenoxazine, phenothiazine, dibenzoborole, dibenzosilole and benzopyran.

The number of carbon atoms of the monovalent heterocyclic group is, not including the number of carbon atoms of a substituent, usually 2 to 60, preferably 4 to 20.

The monovalent heterocyclic group optionally has a substituent, and examples thereof include a thienyl group, a pyrrolyl group, a furyl group, a pyridyl group, a piperidyl group, a quinolinyl group, an isoquinolinyl group, a pyrimidinyl group, a triazinyl group, and groups obtained by substituting a hydrogen atom in these groups with an alkyl group, a cycloalkyl group, an alkoxy group, a cycloalkoxy group or the like.

"Halogen atom" denotes a fluorine atom, a chlorine atom, a bromine atom or an iodine atom.

"Amino group" optionally has a substituent, and a substituted amino group is preferable. The substituent which an amino group has is preferably an alkyl group, a cycloalkyl group, an aryl group or a monovalent heterocyclic group.

The substituted amino group includes, for example, a dialkylamino group, a dicycloalkylamino group and a diarylamino group.

The amino group includes, for example, a dimethylamino group, a diethylamino group, a diphenylamino group, a bis(4-methylphenyl)amino group, a bis(4-tert-butylphenyl)amino group and a bis(3,5-di-tert-butylphenyl)amino group.

"Alkenyl group" may be any of linear or branched. The number of carbon atoms of the linear alkenyl group, not including the number of carbon atoms of the substituent, is usually 2 to 30, preferably 3 to 20. The number of carbon atoms of the branched alkenyl group, not including the number of carbon atoms of the substituent, is usually 3 to 30, preferably 4 to 20.

The number of carbon atoms of "Cycloalkenyl group", not including the number of carbon atoms of the substituent, is usually 3 to 30, preferably 4 to 20.

The alkenyl group and cycloalkenyl group each optionally have a substituent, and examples thereof include a vinyl group, a 1-propenyl group, a 2-propenyl group, a 2-butenyl group, a 3-butenyl group, a 3-pentenyl group, a 4-pentenyl group, a 1-hexenyl group, a 5-hexenyl group, a 7-octenyl group, and these groups having a substituent.

"Alkynyl group" may be any of linear or branched. The number of carbon atoms of the alkynyl group, not including the number of carbon atoms of the substituent, is usually 2 to 20, preferably 3 to 20. The number of carbon atoms of the branched alkynyl group, not including the number of carbon atoms of the substituent, is usually 4 to 30, preferably 4 to 20.

The number of carbon atoms of "Cycloalkynyl group", not including the number of carbon atoms of the substituent, is usually 4 to 30, preferably 4 to 20.

The alkynyl group and cycloalkynyl group each optionally have a substituent, and examples thereof include an ethynyl group, a 1-propynyl group, a 2-propynyl group, a 2-butynyl group, a 3-butynyl group, a 3-pentynyl group, a 4-pentynyl group, a 1-hexynyl group, a 5-hexynyl group, and these groups having a substituent.

"Arylene group" denotes an atomic group remaining after removing from an aromatic hydrocarbon two hydrogen atoms linked directly to carbon atoms constituting the ring. The number of carbon atoms of the arylene group is, not including the number of carbon atoms of a substituent, usually 6 to 60, preferably 6 to 30, more preferably 6 to 18.

The arylene group optionally has a substituent, and examples thereof include a phenylene group, a naphthalenediyl group, an anthracenediyl group, a phenanthrenediyl group, a dihydrophenanthrenediyl group, a naphthacenediyl group, a fluorenediyl group, a pyrenediyl group, a perylenediyl group, a chrysenediyl group, and these groups having a substituent, preferably, groups represented by the formulae (A-1) to (A-20). The arylene group includes groups obtained by linking a plurality of these groups.

[Chemical Formula 13]

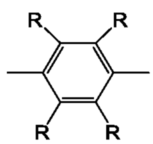
(A-1)

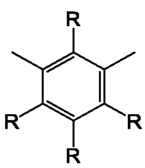
(A-2)

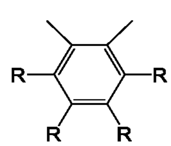
(A-3)

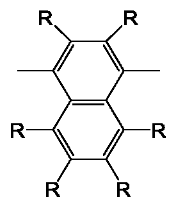
(A-4)

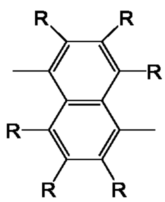
(A-5)

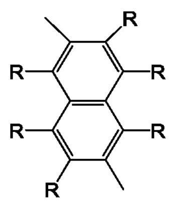
(A-6)

[Chemical Formula 14]

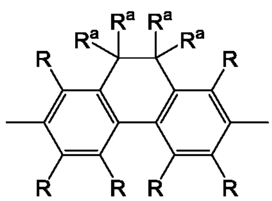
(A-7)

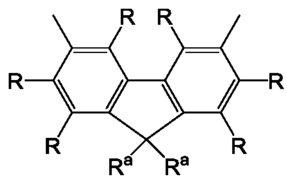
(A-8)

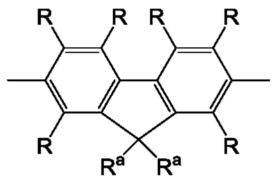
(A-9)

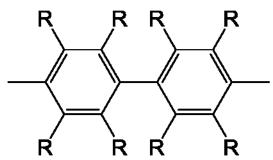
(A-10)

[Chemical Formula 15]

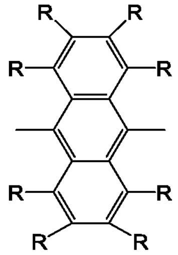
(A-11)

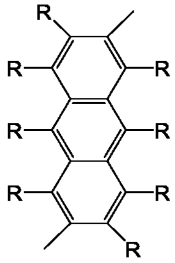
(A-12)

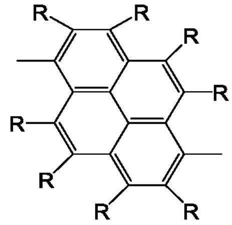
(A-13)

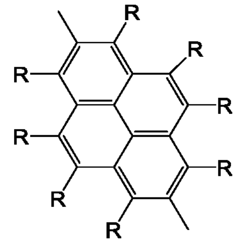
(A-14)

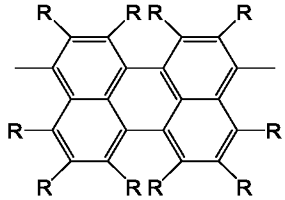
(A-15)

[Chemical Formula 16]

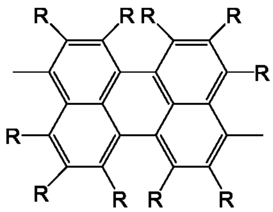
(A-16)

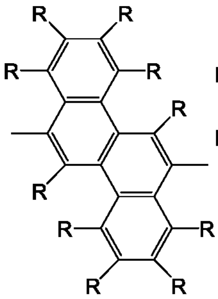
(A-17)

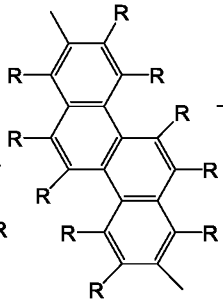
(A-18)

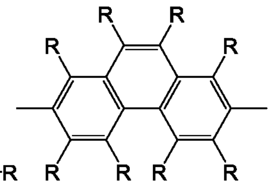
(A-19)

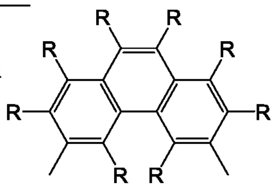
(A-20)

[wherein, R and $R^a$ each independently represent a hydrogen atom, an alkyl group, a cycloalkyl group, an aryl group or a monovalent heterocyclic group. The plurality of R and $R^a$ each may be the same or different, and groups $R^a$ may be combined together to form a ring together with the atoms to which they are attached.]

The number of carbon atoms of the divalent heterocyclic group is, not including the number of carbon atoms of a substituent, usually 2 to 60, preferably 3 to 20, more preferably 4 to 15.

The divalent heterocyclic group optionally has a substituent, and examples thereof include divalent groups obtained by removing from pyridine, diazabenzene, triazine, azanaphthalene, diazanaphthalene, carbazole, dibenzofuran, dibenzothiophene, dibenzosilole, phenoxazine, phenothiazine, acridine, dihydroacridine, furan, thiophene, azole, diazole and triazole two hydrogen atoms among hydrogen atoms linking directly to a carbon atom or a hetero atom constituting the ring, preferably groups represented by the formulae (AA-1) to (AA-34). The divalent heterocyclic group includes groups obtained by linking a plurality of these groups.

[Chemical Formula 17]

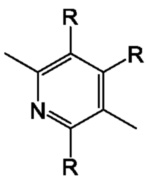
(AA-1)

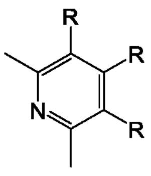
(AA-2)

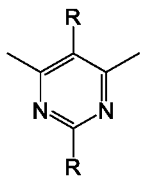
(AA-3)

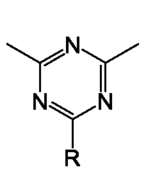
(AA-4)

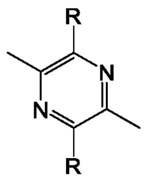
(AA-5)

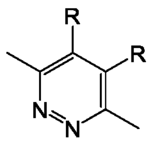
(AA-6)

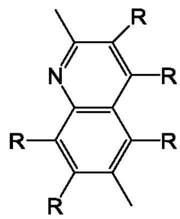
(AA-7)

[Chemical Formula 18]

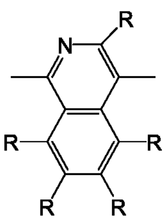
(AA-8)

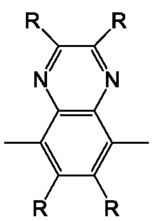
(AA-9)

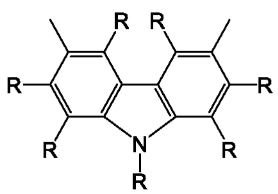
(AA-10)

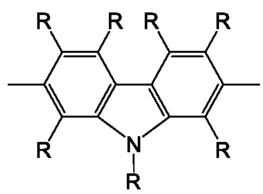
(AA-11)

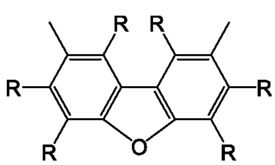
(AA-12)

[Chemical Formula 19]

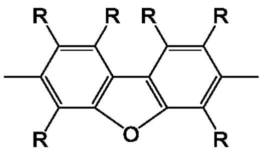
(AA-13)
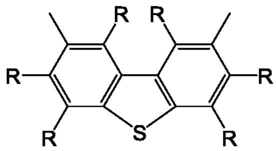
(AA-14)
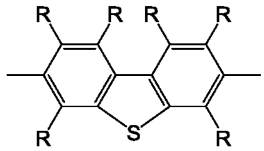
(AA-15)
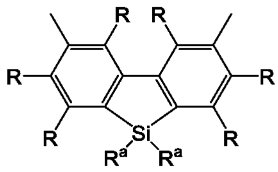
(AA-16)

[Chemical Formula 20]

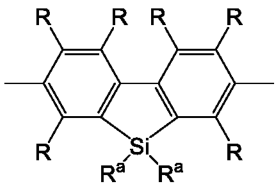
(AA-17)
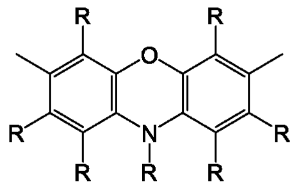
(AA-18)
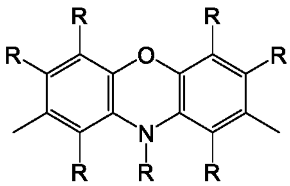
(AA-19)
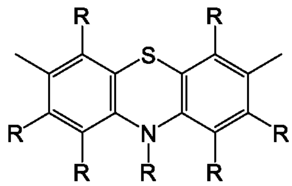
(AA-20)

[Chemical Formula 21]

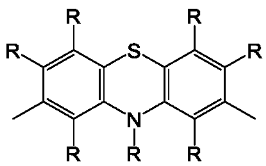
(AA-21)
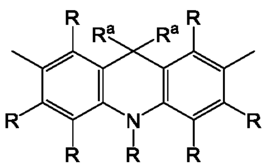
(AA-22)
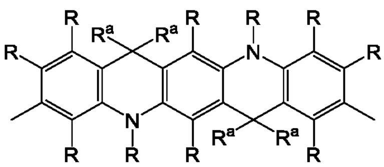
(AA-23)
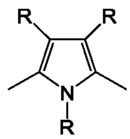
(AA-24)
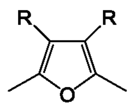
(AA-25)

[Chemical Formula 22]

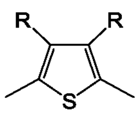
(AA-26)
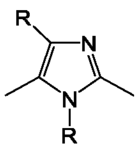
(AA-27)
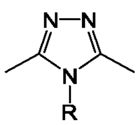
(AA-28)
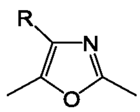
(AA-29)
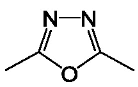
(AA-30)
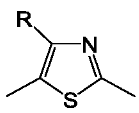
(AA-31)
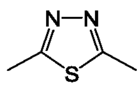
(AA-32)

[Chemical Formula 23]

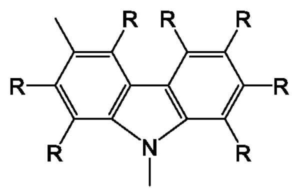
(AA-33)
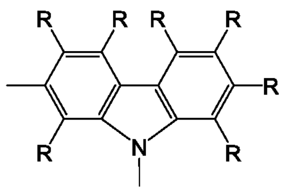
(AA-34)

[wherein, R and $R^a$ represent the same meaning as described above.]

"Crosslinkable group" is a group capable of forming a new bond by being subjected to a heating treatment, an ultraviolet irradiation treatment, a radical reaction and the like, and the crosslinkable group is preferably any one of

groups represented by the formulae (B-1) to (B-17). These groups each optionally have a substituent.

[Chemical Formula 24]

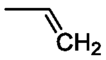
(B-1)
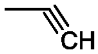
(B-2)
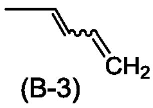
(B-3)
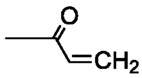
(B-4)
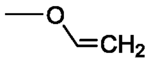
(B-5)
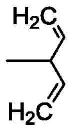
(B-6)
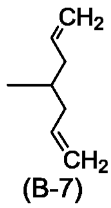
(B-7)
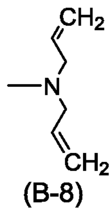
(B-8)

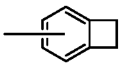
(B-9)
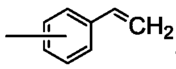
(B-10)
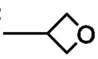
(B-11)
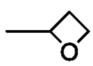
(B-12)
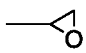
(B-13)
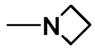
(B-14)
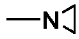
(B-15)
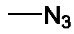
(B-16)
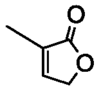
(B-17)

"Substituent" represents a halogen atom, a cyano group, an alkyl group, a cylcoalkyl group, an aryl group, a monovalent heterocyclic group, an alkoxy group, a cycloalkoxy group, an aryloxy group, an amino group, a substituted amino group, an alkenyl group, a cycloalkenyl group, an alkynyl group or a cycloalkynyl group. The substutuent may be a crosslinkable group.

"Dendron" is a group having a regular dendritic branched structure having a branching point at an atom or ring (that is, a dendrimer structure). A compound having a dendron (hereinafter, referred to as "dendrimer".) includes, for example, structures described in literatures such as International Publication WO 02/067343, JP-A No. 2003-231692, International Publication WO 2003/079736, and International Publication WO 2006/097717.

The dendron is preferably a group represented by the formula (D-A) or (D-B) .

$m^{DA1}$, $m^{DA2}$, $m^{DA3}$, $m^{DA4}$, $m^{DA5}$, $m^{DA6}$ and $m^{DA7}$ are usually an integer of 10 or less, preferably an integer of 5 or less, more preferably 0 or 1. It is preferable that $m^{DA1}$, $m^{DA2}$, $m^{DA3}$, $m^{DA4}$, $m^{DA5}$, $m^{DA6}$ and $m^{DA7}$ are the same integer.

$G^{DA}$ is preferably a group represented by the formula (GDA-11) to (GDA-15), and these groups each optionally have a substituent.

[Chemical Formula 25]

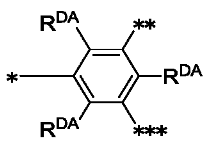
(GDA-11)
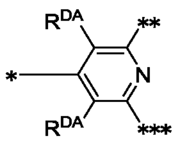
(GDA-12)
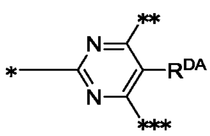
(GDA-13)
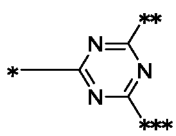
(GDA-14)
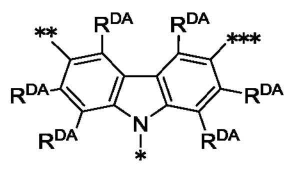
(GDA-15)

[wherein,

* represents a linkage to $Ar^{DA1}$ in the formula (D-A), $Ar^{DA1}$ in the formula (D-B), $Ar^{DA2}$ in the formula (D-B) or $Ar^{DA3}$ in the formula (D-B).
** represents a linkage to $Ar^{DA2}$ in the formula (D-A), $Ar^{DA2}$ in the formula (D-B), $Ar^{DA4}$ in the formula (D-B) or $Ar^{DA6}$ in the formula (D-B).
*** represents a linkage to $Ar^{DA3}$ in the formula (D-A), $A^3$ in the formula (D-B), $Ar^{DA5}$ in the formula (D-B) or $Ar^{DA7}$ in the formula (D-B).
$R^{DA}$ represents a hydrogen atom, an alkyl group, a cycloalkyl group, an alkoxy group, a cycloalkoxy group, an aryl group or a monovalent heterocyclic group, and these groups each optionally have a substituent. When a plurality of $R^{DA}$ are present, they may be the same or different.]

$R^{DA}$ is preferably a hydrogen atom, an alkyl group, a cycloalkyl group, an alkoxy group or a cycloalkoxy group, more preferably a hydrogen atom, an alkyl group or cycloalkyl group, and these groups each optionally have a substituent.

It is preferable that $Ar^{DA1}$, $Ar^{DA2}$, $Ar^{DA3}$, $Ar^{DA4}$, $Ar^{DA5}$, $Ar^{DA6}$ and $Ar^{DA7}$ are groups represented by the formulae (ArDA-1) to (ArDA-3).

[Chemical Formula 26]

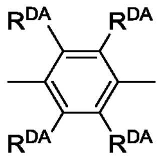

**(ArDA-1)**

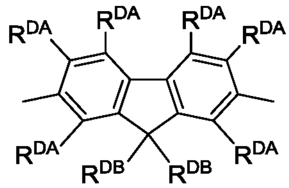

**(ArDA-2)**

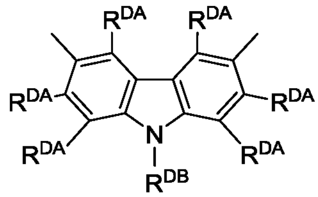

**(ArDA-3)**

[wherein,

$R^{DA}$ represents the same meaning as described above.

$R^{DB}$ represents a hydrogen atom, an alkyl group, a cycloalkyl group, an aryl group or a monovalent heterocyclic group, and these groups each optionally have a substituent. When a plurality of $R^{DB}$ are present, they may be the same or different at each occurrence.]

$R^{DB}$ is preferably an alkyl group, a cycloalkyl group, an aryl group or a monovalent heterocyclic group, more preferably an aryl group or a monovalent heterocyclic group, further preferably an aryl group.

$T^{DA}$ is preferably groups represented by the formulae (TDA-1) to (TDA-3).

[Chemical Formula 27]

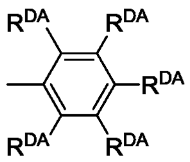

**(TDA-1)**

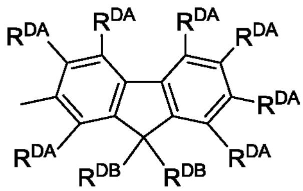

**(TDA-2)**

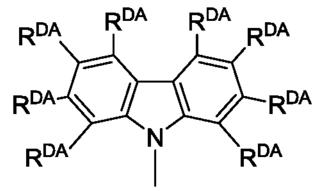

**(TDA-3)**

[wherein, $R^{DA}$ and $R^{DB}$ represent the same meaning described above.]

In the groups represented by the formulae (TDA-1) to (TDA-3), at least one selected from among the plurality of $R^{DA}$ and $R^{DB}$ is preferably an alkyl group having 4 or more carbon atoms or a cycloalkyl group having 4 or more carbon atoms, and at least one selected from among the plurality of $R^{DA}$ is preferably an alkyl group having 4 or more carbon atoms or a cycloalkyl group having 4 or more carbon atoms.

The group represented by the formula (D-A) is preferably a group represented by the formula (D-A1) to (D-A3).

The group represented by the formula (D-B) is preferably a group represented by the formula (D-B1) to (D-B3).

[Chemical Formula 28]

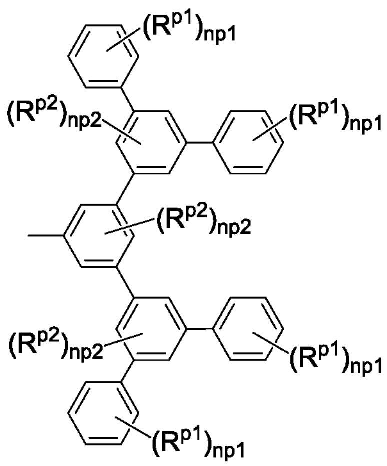

(D-B1)

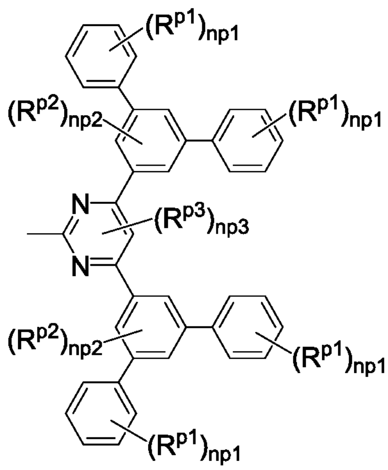

(D-B2)

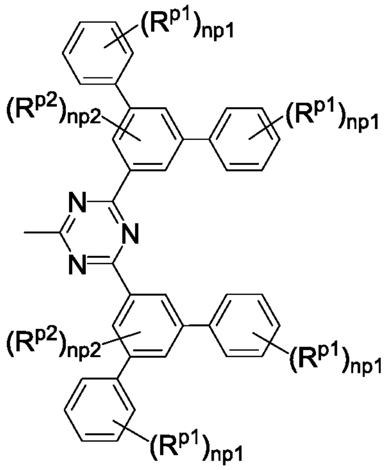

(D-B3)

[wherein,

$R^{p1}$, $R^{p2}$ and $R^{p3}$ each independently represent an alkyl group, a cycloalkyl group, an alkoxy group, a cycloalkoxy group or a halogen atom. When a plurality of $R^{p1}$ and $R^{p2}$ are present, they may be the same or different at each occurrence.

np1 represents an integer of 0 to 5, np2 represents an integer of 0 to 3, and np3 represents 0 or 1. When a plurarity of np1 and np2 are present, they may be the same or different at each occurrence.]

np1 is preferably 0 or 1, more preferably 1. np2 is preferably 0 or 1, more preferably 0. np3 is preferably 0.

$R^{p1}$, $R^{p2}$ and $R^{p3}$ are preferably an alkyl group or a cycloalkyl group.

<Metal complex>

Next, the metal complex of the present disclosure will be explained. The metal complex of the present disclosure is a metal complex represented by the formula (1).

The metal complex represented by the formula (1) is constituted of M (an iridium atom or a platinum atom), a ligand the number of which is prescribed by a subscript $n_1$ and a ligand the number of which is prescribed by a subscript $n_2$.

In the formula (1), M is preferably an iridium atom.

In the formula (1), $n_1$ is preferably 2 or 3, more preferably 3, when M is an iridium atom.

In the formula (1), $n_1$ is preferably 2, when M is a platinum atom.

In the formula (1), the combination of $E^2$, $E^3$ and $E^4$ is preferably a combination in which $E^2$ and $E^3$ are nitrogen atoms and $E^4$ is a carbon atom or a combination in which $E^2$ and $E^4$ are nitrogen atoms and $E^3$ is a carbon atom, more preferably a combination in which $E^2$ and $E^3$ are nitrogen atoms and $E^4$ is a carbon atom.

In the formula (1), $R^1$ is preferably an aryl group, because synthesis of the metal complex of the present disclosure is easy.

In the formula (1), the aryl group or monovalent heterocyclic group represented by $R^1$ includes, for example, groups represented by the formulae (L-1) to (L-19), preferably groups represented by the formulae (L-1) to (L-16), more preferably groups represented by the formulae (L-1) to (L-10), further preferably groups represented by the formulae (L-1) to (L-5), particularly preferably a group represented by the formula (L-1).

[Chemical Formula 29]

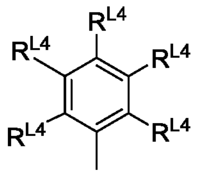

(L-1)

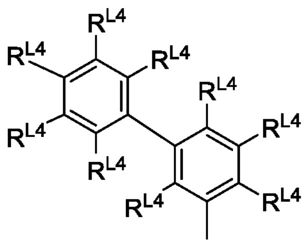

(L-2)

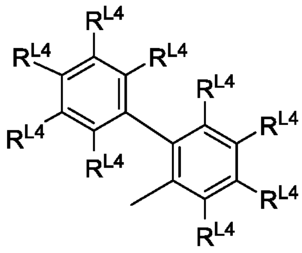

(L-3)

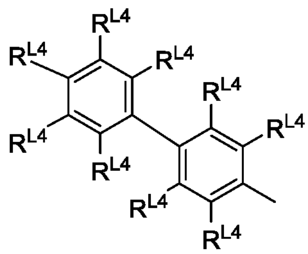

(L-4)

[Chemical Formula 30]

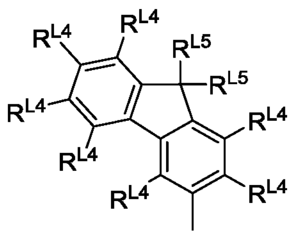

(L-5)

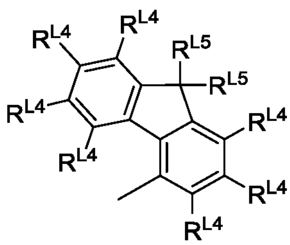

(L-6)

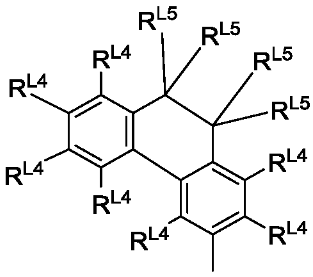

(L-7)

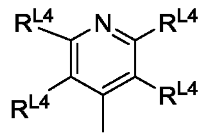

(L-8)

[Chemical Formula 31]

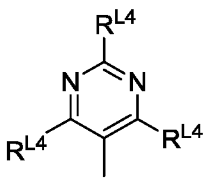

(L-9)

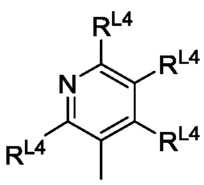

(L-10)

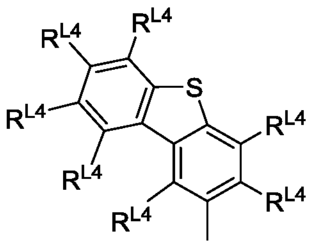

(L-11)

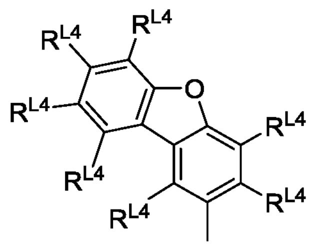

(L-12)

[Chemical Formula 32]

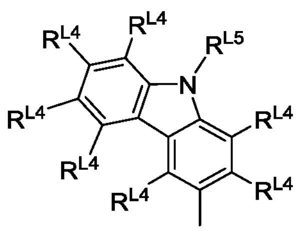

(L-13)

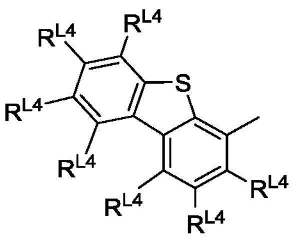

(L-14)

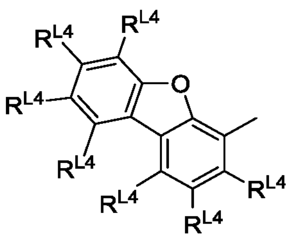

(L-15)

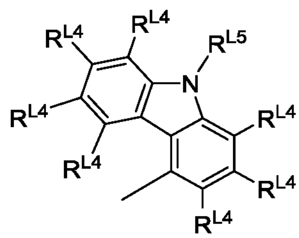

(L-16)

[Chemical Formula 33]

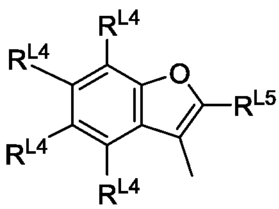

(L-17)

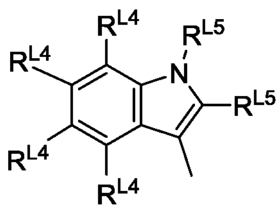

(L-18)

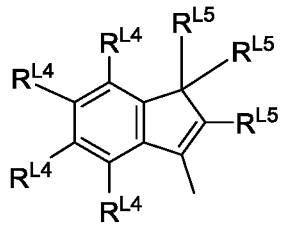

(L-19)

[wherein,

$R^{L4}$ represents a hydrogen atom, an alkyl group, a cycloalkyl group, an aryl group or a monovalent heterocyclic group, and these groups each optionally have a substituent. The plurality of $R^{L4}$ may be the same or different, and adjacent grups $R^{L4}$ may be combined together to form a ring together with the carbon atoms to which they are attached.

$R^{L5}$ represents an alkyl group, a cycloalkyl group, an aryl group or a monovalent heterocyclic group, and these groups each optionally have a substituent. The plurality of $R^{L5}$ may be the same or different and may be combined together to form a ring together with the carbon atoms to which they are attached.]

In the formulae (L-1) to (L-19), $R^{L4}$ is preferably a hydrogen atom, an alkyl group or a cycloalkyl group. The alkyl group or cycloalkyl group represented by $R^{L4}$ is preferably a group selected from groups represented by the formulae (II-01) to (II-010).

[Chemical Formula 34]

—Me (II-01)

—Et (II-02)

—$C_3H_7$ (II-03)

—i-$C_3H_7$ (II-04)

—Bu (II-05)

—t-Bu (II-06)

—$C_6H_{13}$ (II-07)

—$C_8H_{17}$ (II-08)

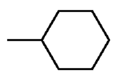

(II-09)

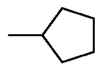

(II-010)

In the formulae (L-1) to (L-19), at least two of the plurality of $R^{L4}$ represent preferably an alkyl group, a cycloalkyl group, an aryl group or a monovalent heterocyclic group, more preferably an alkyl group, a cycloalkyl group or an aryl group, further preferably an alkyl group or a cycloalkyl group, particularly preferably a group selected from groups represented by the formulae (II-01) to (II-010).

In the formulae (L-1) to (L-19), $R^{L5}$ is preferably an alkyl group or a cycloalkyl group, more preferably a group selected from groups represented by the formula (II-01) to the formula (II-010).

In the formula (1), when $E^2$ is a nitrogen atom and $R^2$ is present, $R^2$ is preferably an alkyl group, a cycloalkyl group, an aryl group or a monovalent heterocyclic group, more preferably an aryl group.

In the formula (1), when $E^3$ is a nitrogen atom and $R^3$ is present, $R^3$ is preferably an alkyl group, a cycloalkyl group, an aryl group or a monovalent heterocyclic group, more preferably an aryl group.

In the formula (1), the ring A is preferably a 5-membered or 6-membered aromatic hydrocarbon ring or a 5-membered or 6-membered aromatic heterocyclic ring, more preferably a 5-membered or 6-membered aromatic hydrocarbon ring, further preferably a 6-membered aromatic hydrocarbon ring.

In the formula (1), the ring A includes, for example, a benzene ring, a naphthalene ring, a fluorene ring, an indene ring, a phenanthrene ring, a dibenzofuran ring, a dibenzothiophene ring, a carbazole ring, a pyridine ring, a diazabenzene ring, a triazine ring, a pyrrole ring, a furan ring or a thiophene ring, and is preferably a benzene ring, an indene ring, a fluorene ring, a phenanthrene ring, a dibenzofuran ring, a dibenzothiophene ring, a carbazole ring, a pyridine ring, a diazabenzene ring or a triazine ring, more preferably a benzene ring, a fluorene ring, a phenanthrene

ring, a dibenzofuran ring, a dibenzothiophene ring, a carbazole ring, a pyridine ring, a diazabenzene ring or a triazine ring, further preferably a benzene ring, a fluorene ring, a dibenzofuran ring, a dibenzothiophene ring, a carbazole ring, a pyridine ring or a pyrimidine ring, particularly preferably a benzene ring, a pyridine ring or a pyrimidine ring, especially preferably a benzene ring.

In the formula (1), it is preferable that the aromatic hydrocarbon ring or aromatic heterocyclic ring represented by the ring A has at least one substituent, because the metal complex of the present disclosure is more excellent in light emission stability. The substituent which the ring A optionally has is preferably an alkyl group, a cycloalkyl group, an aryl group, a monovalent heterocyclic group or a halogen atom, more preferably an alkyl group, a cycloalkyl group or an aryl group, further preferably an aryl group.

In the formula (1), the anionic bidentate ligand represented by $A^1$-$G^1$-$A^2$ includes, for example, ligands shown below.

[Chemical Formula 35]

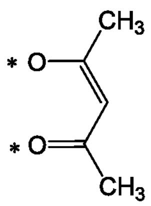
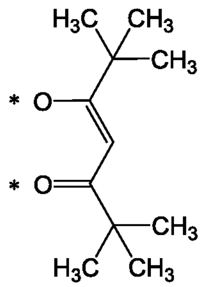
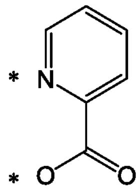
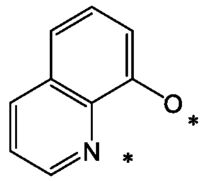
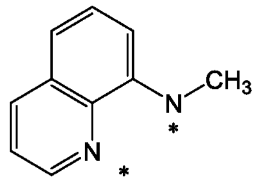

[Chemical Formula 36]

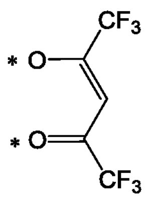
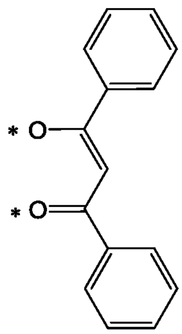
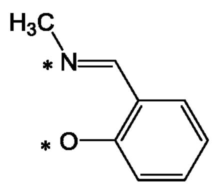
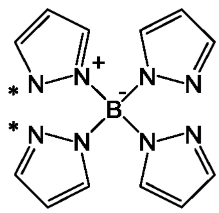

[wherein, * represents a site binding to an iridium atom or a platinum atom.]

In the formula (1), the anionic bidentate ligand represented by $A^1$-$G^1$-$A^2$ may also be a ligand shown below.

[Chemical Formula 37]

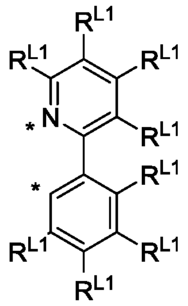
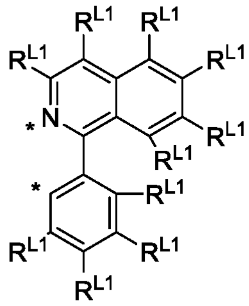
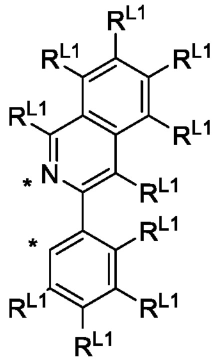
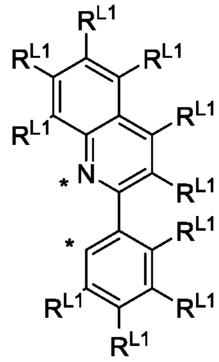

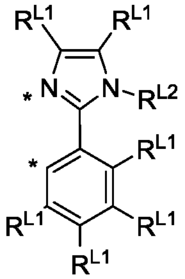
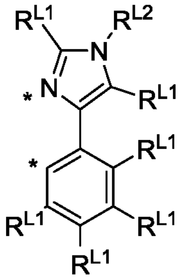
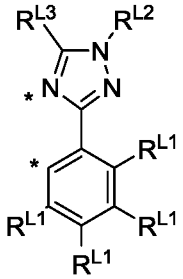
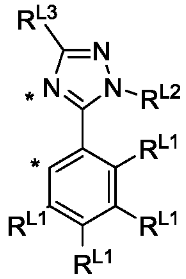
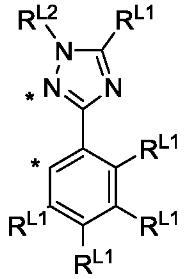
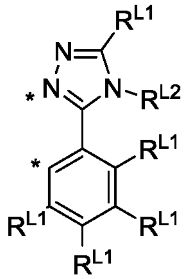

[wherein,

* represents a site binding to an iridium atom or a platinum atom.
$R^{L1}$ represents a hydrogen atom, an alkyl group, a cycloalkyl group, an aryl group, a monovalent heterocyclic group or a halogen atom, and these groups each optionally have a substituent. The plurality of $R^{L1}$ may be the same or different.
$R^{L2}$ represents an alkyl group, a cycloalkyl group, an aryl group, a monovalent heterocyclic group or a halogen atom, and these groups each optionally have a substituent.
$R^{L3}$ represents an alkyl group, a cycloalkyl group or a halogen atom, and these groups each optionally have a substituent.]

The metal complex represented by the formula (1) has a plurality of optical isomers and structural isomers in some cases, from the standpoint of its steric structure. Therefore, the metal complex represented by the formula (1) is produced in the form of a mixture of a plurality of optical isomers and structural isomers in some cases. When the metal complex represented by the formula (1) is produced in the form of a mixture of a plurality of optical isomers and structural isomers, the area percentage of a single component of the metal complex represented by the formula (1) is preferably 90% or more, more preferably 95% or more, further preferably 98% or more, especially preferably 99.5% or more, in high performance liquid chromatography analysis using a column (ODS) filled with achiral silica gel as a stationary phase.

The metal complex represented by the formula (1) is preferably a metal complex represented by the formula (1-a), because light emission stability is more excellent.

In the formula (1-a), $R^4$ and $R^7$ are preferably a hydrogen atom, an alkyl group, a cycloalkyl group, an aryl group, a monovalent heterocyclic group or a halogen atom, more preferably a hydrogen atom, an alkyl group or an aryl group, further preferably a hydrogen atom, because synthesis of the metal complex of the present disclosure is easy.

In the formula (1-a), $R^5$ and $R^6$ are preferably a hydrogen atom, an alkyl group, a cycloalkyl group, an aryl group, a monovalent heterocyclic group or a halogen atom, more preferably a hydrogen atom, an alkyl group, a cycloalkyl group or an aryl group, further preferably a hydrogen atom or an aryl group, and it is particularly preferable that at least one of $R^5$ and $R^6$ is an aryl group, because synthesis of the metal complex of the present disclosure is easy.

The metal complex represented by the formula (1-a) is, according to the present invention, a metal complex represented by the formula (1-b), because light emission stability is more excellent.

In the formula (1-b), $R^8$ and $R^{12}$ are preferably a hydrogen atom, an alkyl group, a cycloalkyl group, an aryl group or a monovalent heterocyclic group, more preferably a hydrogen atom, an alkyl group or an aryl group, further preferably a hydrogen atom or an alkyl group, particularly preferably a hydrogen atom, because synthesis of the metal complex of the present invention is easy.

In the formula (1-b), $R^9$ and $R^{11}$ are an alkyl group, because the metal complex of the present invention is excellent in solubility in a solvent and film formability.

Regarding $R^8$, $R^9$, $R^{11}$ and $R^{12}$ in the formula (1-b), it is more preferable that $R^9$ and $R^{11}$ are the same atom or group, it is more preferable that $R^8$ and $R^{12}$ are the same atom or group and $R^9$ and $R^{11}$ are the same atom or group, because the metal complex of the present invention is more excellent in light emission stability.

In the formula (1-b), $R^{10}$ is preferably a hydrogen atom, an alkyl group, a cycloalkyl group, an aryl group or a monovalent heterocyclic group, more preferably a hydrogen atom, an alkyl group or an aryl group, further preferably a hydrogen atom or an alkyl group, particularly preferably a hydrogen atom, because the metal complex of the present invention is excellent in solubility in a solvent and film formability.

The metal complex represented by the formula (1-b) is preferably a metal complex represented by the formula (1-c) or a metal complex represented by the formula (1-d), more preferably a metal complex represented by the formula (1-c), because light emission stability is more excellent. The metal complex represented by the formula (1-c) is preferably a metal complex represented by the formula (1-e), because light emission stability is further excellent.

In the formula (1-e), $R^{13}$ and $R^{17}$ represent preferably an alkyl group, a cycloalkyl group, an aryl group or a monovalent heterocyclic group, more preferably an alkyl group or an aryl group, further preferably an alkyl group.

In the formula (1-e), $R^{14}$, $R^{15}$ and $R^{16}$ represent preferably a hydrogen atom, an alkyl group, a cycloalkyl group, an aryl group or a monovalent heterocyclic group, more preferably a hydrogen atom, an alkyl group or an aryl group.

In the formula (1), the formula (1-a), the formula (1-b), the formula (1-c), the formula (1-d) and the formula (1-e), at least one selected from the group consisting of $R^1$, $R^2$, $R^3$, $R^5$, $R^6$, $R^{10}$ and $R^{15}$ is preferably an aryl group or a monovalent heterocyclic group, more preferably an aryl group, because the metal complex of the present disclosure is more excellent in light emission stability. As the aryl group and the monovalent heterocyclic group, a dendron is preferable, a group represented by the formula (D-A) or (D-B) is more preferable, a group represented by the formula (D-A) is further preferable, a group represented by the formula (D-A1), (D-A2) or (D-A3) is particularly preferable, a group represented by the formula (D-A1) is especially preferable.

The metal complex represented by the formula (1) includes, for example, metal complexes represented by the formulae (Ir-1) to (Ir-18) and the formulae (Pt-1) to (Pt-3), preferably metal complexes represented by the formulae (Ir-1) to (Ir-12) or the formula (Pt-1), more preferably metal complexes represented by the formulae (Ir-1) to (Ir-8), further preferably metal complexes represented by the formulae (Ir-1) to (Ir-4).

[Chemical Formula 38]

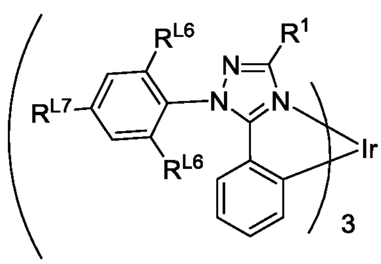

(Ir-1)

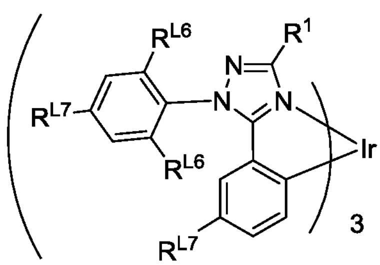

(Ir-2)

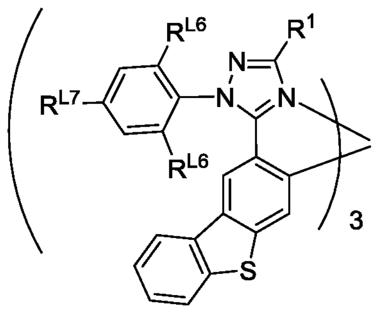

(Ir-3)

[Chemical Formula 39]

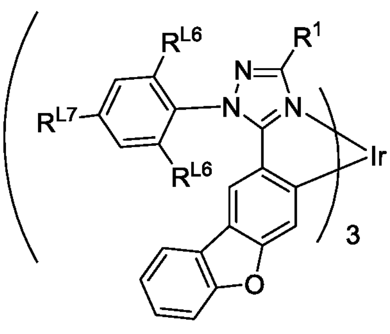

(Ir-4)

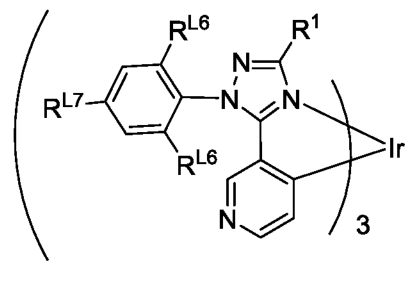

(Ir-5)

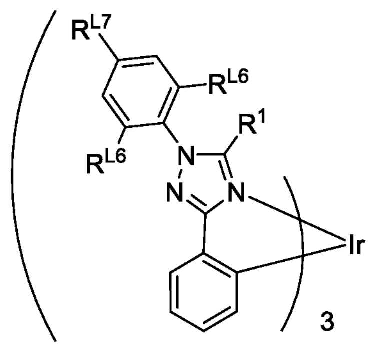

(Ir-6)

[Chemical Formula 40]

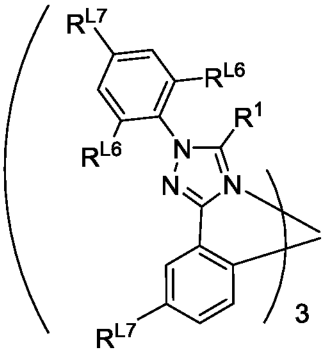

(Ir-7)

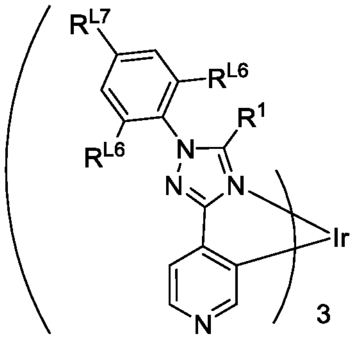

(Ir-8)

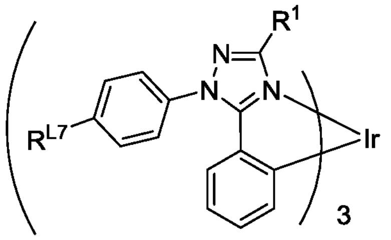

(Ir-9)

[Chemical Formula 41]

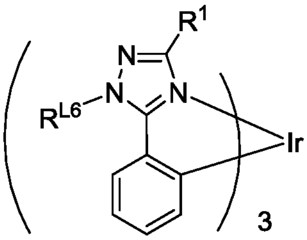

(Ir-10)

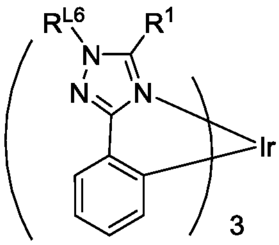

(Ir-11)

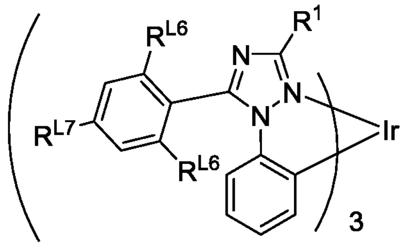

(Ir-12)

[Chemical Formula 42]

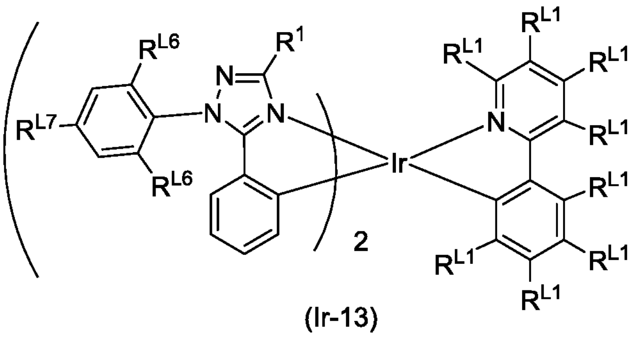

(Ir-13)

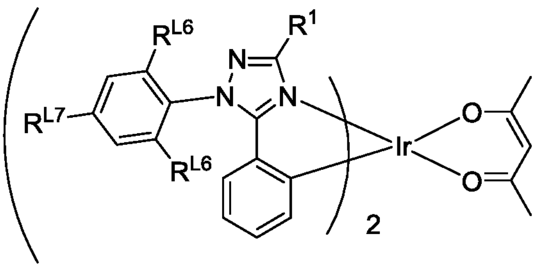

(Ir-14)

[Chemical Formula 43]

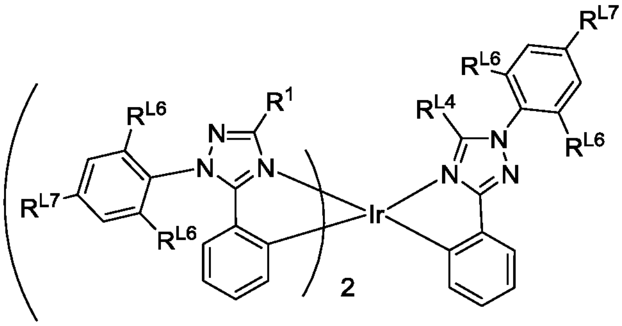

(Ir-15)

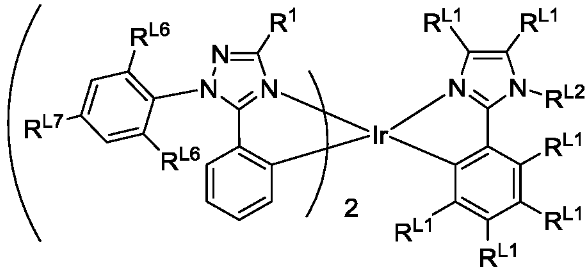

(Ir-16)

[Chemical Formula 44]

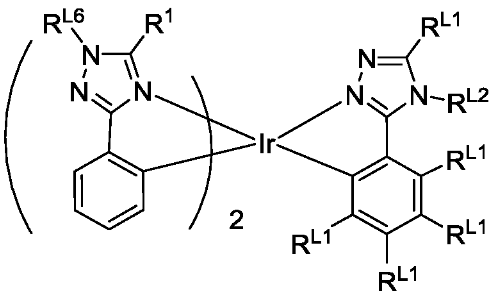

(Ir-17)

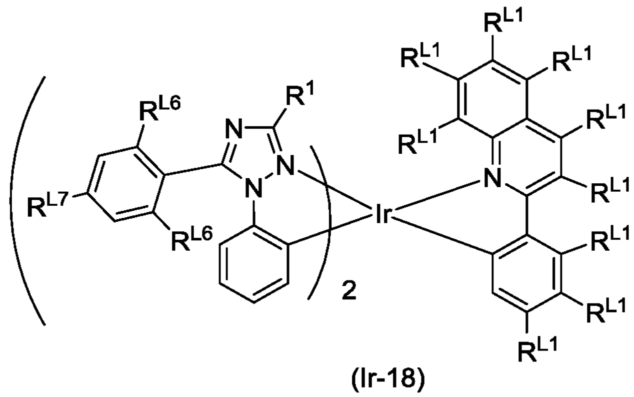

(Ir-18)

[Chemical Formula 45]

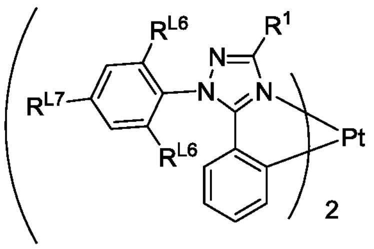

(Pt-1)

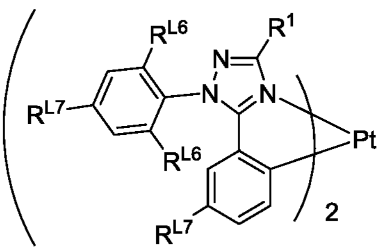

(Pt-2)

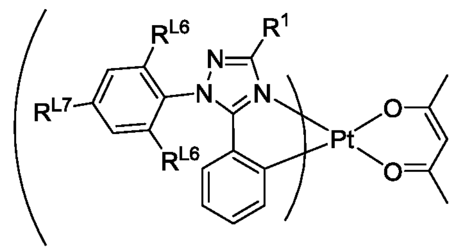

(Pt-3)

[wherein,

$R^1$, $R^{L1}$ and $R^{L2}$ represent the same meaning as described above.

$R^{L6}$ represents an alkyl group or a cycloalkyl group, and these groups each optionally have a substituent. The plurality of $R^{L6}$ may be the same or different.

$R^{L7}$ represents an alkyl group, a cycloalkyl group, an aryl group, a monovalent heterocyclic group or a halogen atom, and these groups each optionally have a substituent. When a plurality of $R^{L7}$ are present, they may be the same or different.]

In the formulae (Ir-1) to (Ir-18) and the formulae (Pt-1) to (Pt-3), $R^{L6}$ is preferably an alkyl group or a cycloalkyl group, more preferably a group selected from groups represented by the formula (II-01) to the formula (II-010), further preferably a group selected from groups represented by the formula (II-01) to the formula (11-04), the formula (11-09)

or the formula (II-010).

In the formulae (Ir-1) to (Ir-18) and the formulae (Pt-1) to (Pt-3), $R^{L7}$ is preferably an alkyl group, an aryl group or a monovalent heterocyclic group, more preferably a group selected from groups represented by the formula (II-01) to the formula (II-010), a group selected from groups represented by the formula (III-01) to the formula (111-09) or a group represented by the formula (D-A).

[Chemical Formula 46]

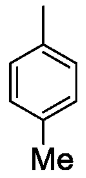
(III-01)

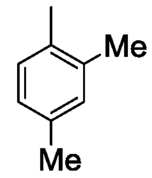
(III-02)

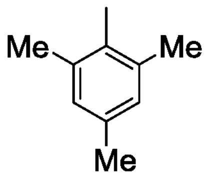
(III-03)

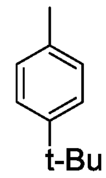
(III-04)

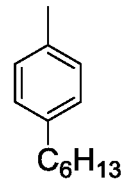
(III-05)

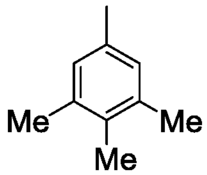
(III-06)

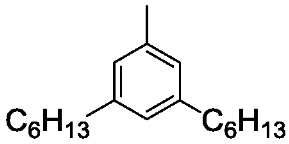
(III-07)

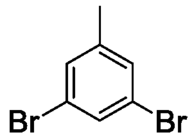
(III-08)

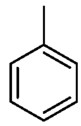
(III-09)

The metal complex represented by the formula (1-b') includes, for example, metal complexes represented by the formula (Ir-100) to the formula (Ir-124) and the formulae (Pt-100) to (Pt-103).

[Chemical Formula 47]

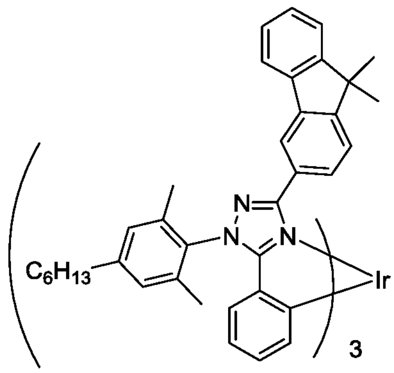
(Ir-100)

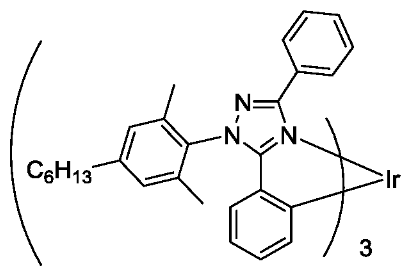
(Ir-101)

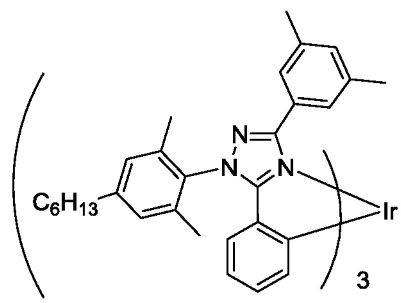
(Ir-102)

[Chemical Formula 48]

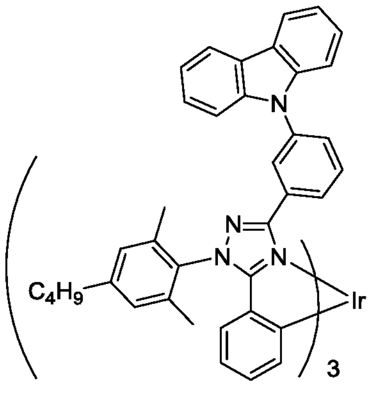
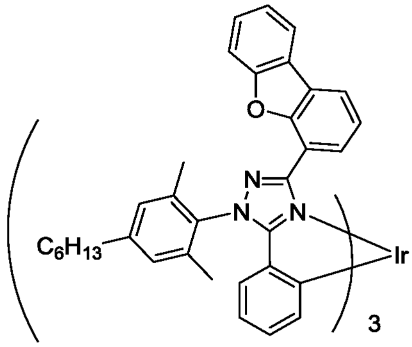
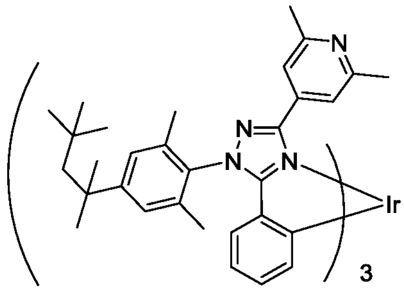

(Ir-103) (Ir-104) (Ir-105)

[Chemical Formula 49]

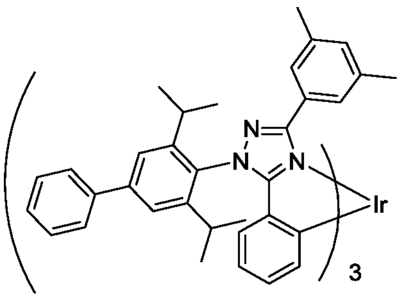
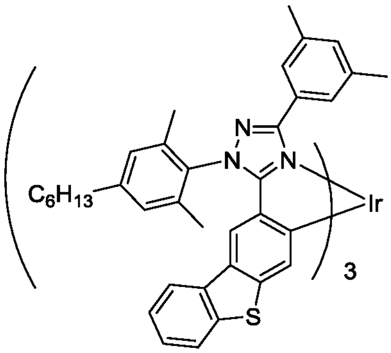
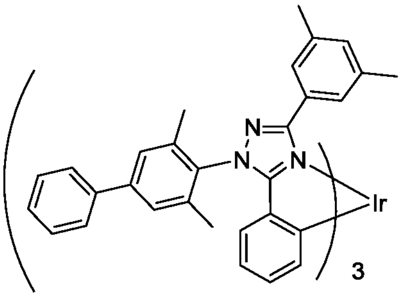

(Ir-106) (Ir-107) (Ir-108)

[Chemical Formula 50]

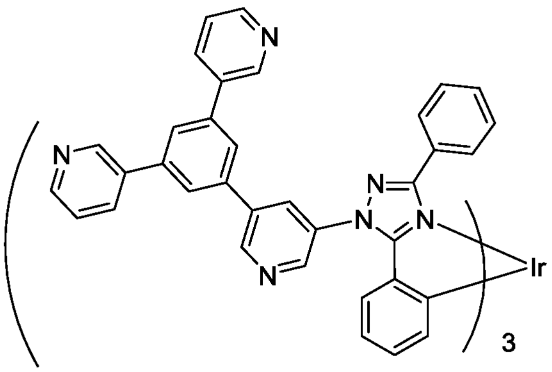
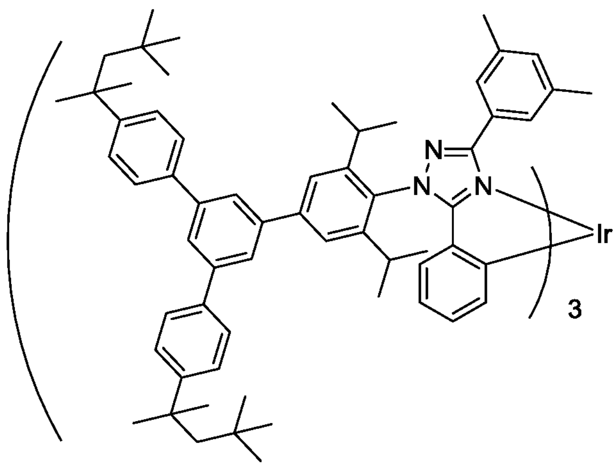

(Ir-109) (Ir-110)

[Chemical Formula 51]

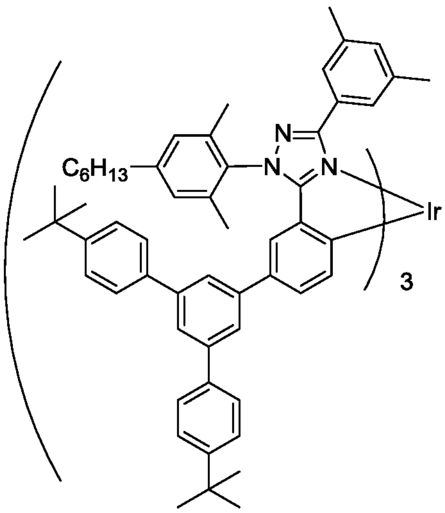

(Ir-111)

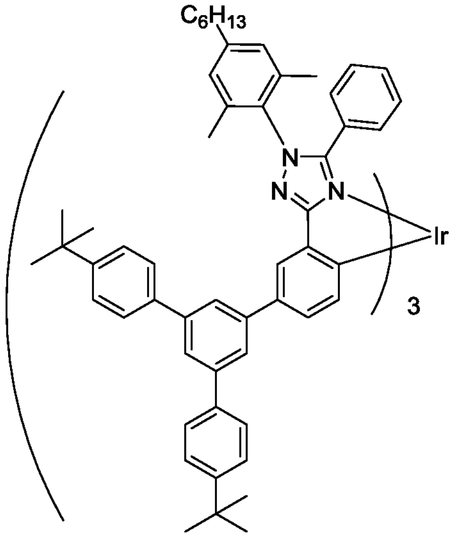

(Ir-112)

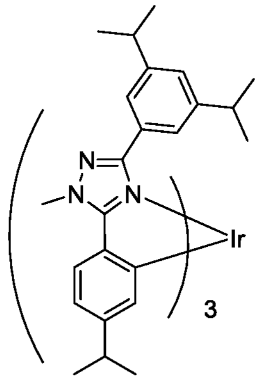

(Ir-113)

[Chemical Formula 52]

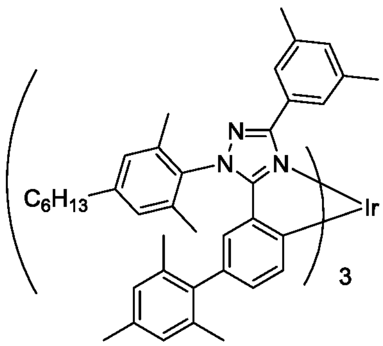

(Ir-114)

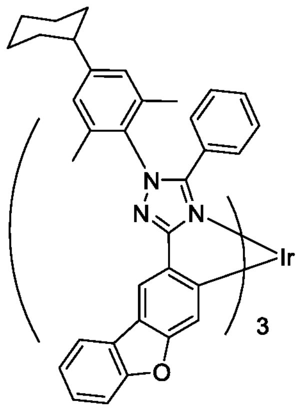

(Ir-115)

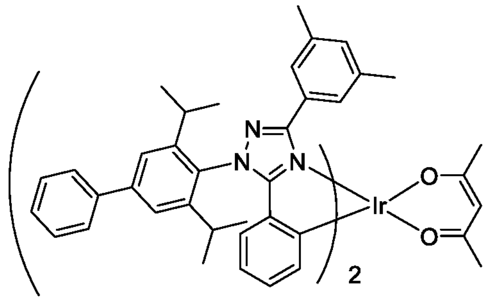

(Ir-116)

[Chemical Formula 53]

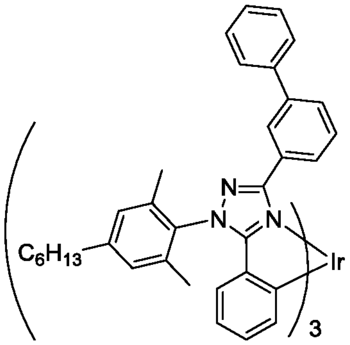

(Ir-117)

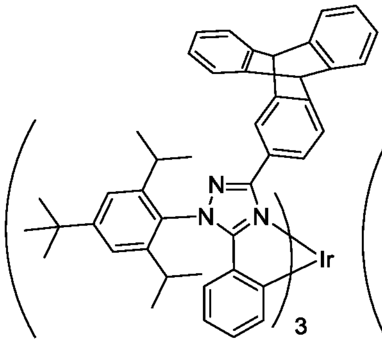

(Ir-118)

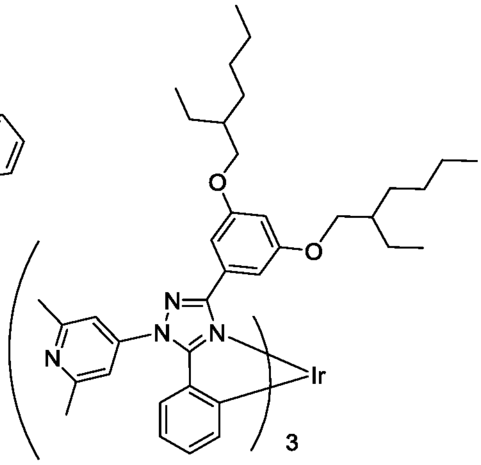

(Ir-119)

[Chemical Formula 54]

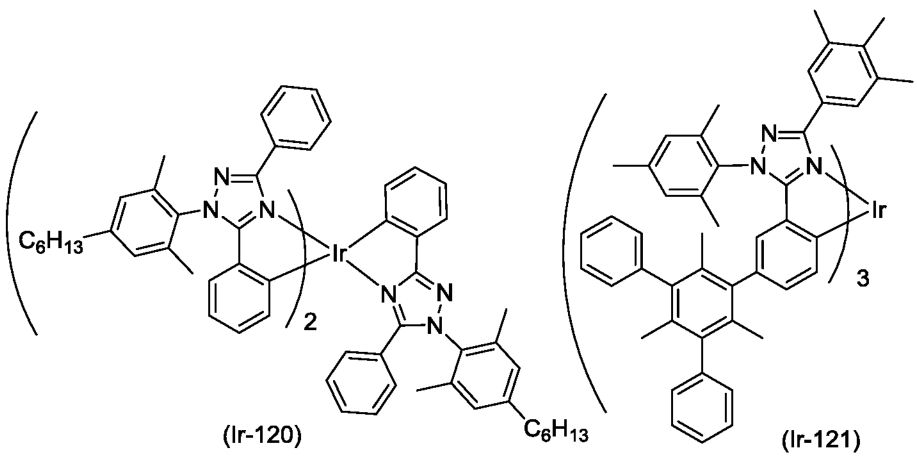

(Ir-120)

(Ir-121)

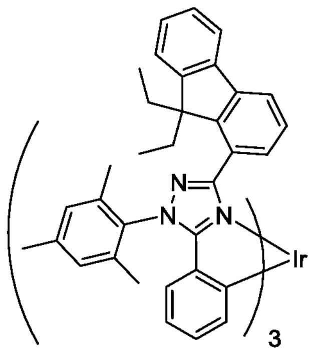

(Ir-122)

[Chemical Formula 55]

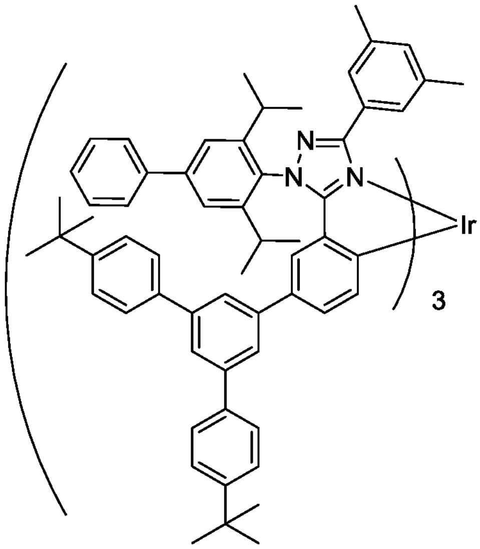

(Ir-123)

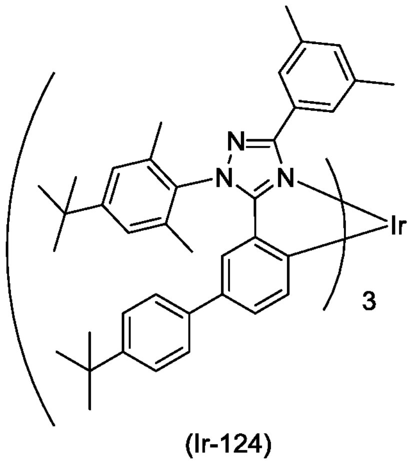

(Ir-124)

[Chemical Formula 56]

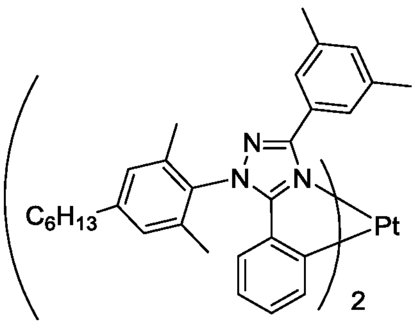

(Pt-100)

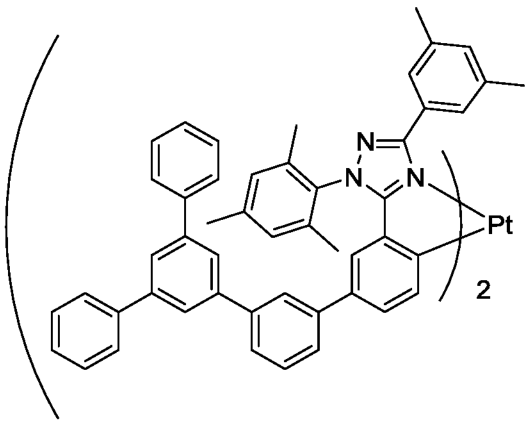

(Pt-101)

[Chemical Formula 57]

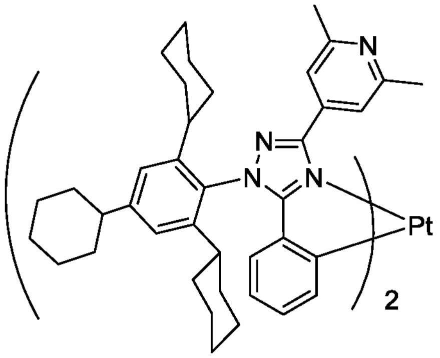

(Pt-102)

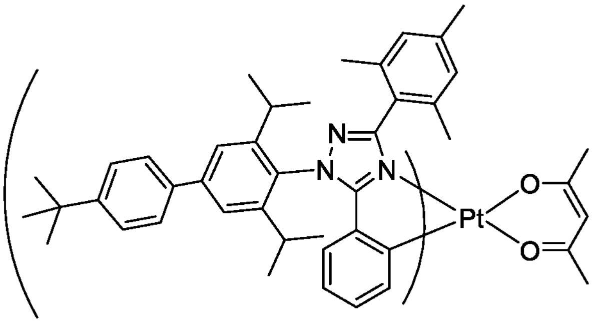

(Pt-103)

The metal complex represented by the formula (1) includes a plurality of presumable geometric isomers and may be any geometric isomer, and a facial form is contained in a proportion of preferably 80 mol% or more, more preferably 90 mol% or more, further preferably 99 mol% or more, particularly preferably 100 mol%, with respect to the whole metal complex of the present disclosure, because a light emitting device produced by using the metal complex of the present disclosure is excellent in luminance life.

In the light emitting device of the present invention, the metal complexes of the present invention may be used each singly, or two or more of them may be used in combination.

<Production method of metal complex>

The metal complex of the present invention can be produced, for example, by a method of reacting a compound acting as a ligand with a metal compound. If necessary, a ligand of a metal complex may be subjected to a functional group conversion reaction.

The metal complex represented by the formula (1) can be produced, for example, by a method comprising a step A of reacting a compound represented by the formula (M-1) with an iridium compound or its hydrate or a platinum compound or its hydrate, and a step B of reacting a metal complex represented by the formula (M-2) with a compound represented by the formula (M-1) or a precursor of a ligand represented by $A^1$-$G^1$-$A^2$.

[Chemical Formula 58]

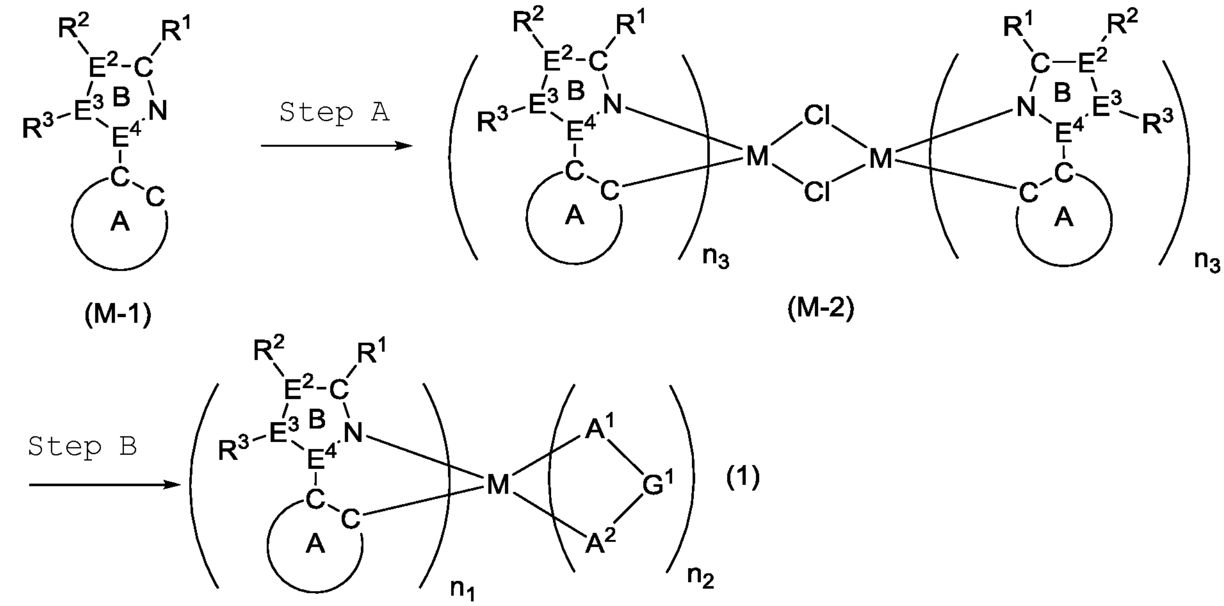


(M-1)

(M-2)

(1)

[wherein,

M, $n_1$, $n_2$, $E^2$, $E^3$, $E^4$, $R^1$, $R^2$, $R^3$, a ring A, a ring B and $A^1$-$G^1$-$A^2$ represent the same meaning as described above. $n_3$ represents 1 or 2. $n_3$ is 2 when M is an iridium atom, while $n_3$ is 1 when M is a platinum atom.]

In the step A, the iridium compound includes, for example, iridium chloride and chloro(cyclooctadiene)iridium(I) dimer. The hydrate of the iridium compound includes, for example, iridium chloride•trihydrate.

In the step A, the platinum compound includes, for example, potassium chloroplatinate.

The step A and the step B are conducted usually in a solvent. The solvent includes alcohol solvents such as methanol, ethanol, propanol, ethylene glycol, glycerin, 2-methoxyethanol and 2-ethoxyethanol; ether solvents such as diethyl ether, tetrahydrofuran (THF), dioxane, cyclopentyl methyl ether and diglyme; halogen-based solvents such as methylene chloride and chloroform; nitrile solvents such as acetonitrile and benzonitrile; hydrocarbon solvents such as hexane, decalin, toluene, xylene and mesitylene; amide solvents such as N,N-dimethylformamide and N,N-dimethylacetamide; acetone, dimethyl sulfoxide, water, and the like.

In the step A and the step B, the reaction time is usually between 30 minutes to 200 hours and the reaction temperature is usually between the melting point and the boiling point of a solvent present in the reaction system.

In the step A, the amount of a compound represented by the formula (M-1) is usually 2 to 20 mol with respect to 1 mol of an iridium compound or its hydrate or 1 mol of a platinum compound or its hydrate.

In the step B, the amount of a compound represented by the formula (M-1) or a precursor of a ligand represented by $A^1$-$G^1$-$A^2$ is usually 1 to 100 mol with respect to 1 mol of a metal complex represented by the formula (M-2).

In the step B, the reaction is preferably carried out in the presence of a silver compound such as silver trifluoromethanesulfonate. When a silver compound is used, the amount thereof is usually 2 to 20 mol with respect to 1 mol of a metal complex represented by the formula (M-2).

The compound represented by the formula (M-3) as one embodiment of a compound represented by the formula (M-1) can be synthesized, for example, by a step of subjecting a compound represented by the formula (M-4) and a compound represented by the formula (2) to a coupling reaction such as the Suzuki reaction, the Kumada reaction and the Stille reaction.

[Chemical Formula 59]

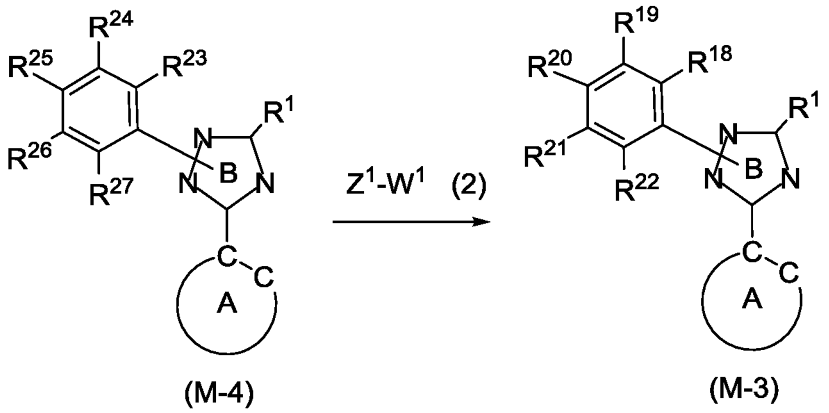

[wherein,

$R^1$, a ring B and a ring A represent the same meaning as described above.
$R^{18}$, $R^{19}$, $R^{20}$, $R^{21}$ and $R^{22}$ each independently represent a hydrogen atom, an alkyl group, a cycloalkyl group, an alkoxy group, a cycloalkoxy group, an aryl group, an aryloxy group, a monovalent heterocyclic group or a halogen atom, and these groups each optionally have a substituent. At least one of $R^{19}$, $R^{20}$ and $R^{21}$ is a group represented by $Z^1$.
$R^{23}$, $R^{24}$, $R^{25}$, $R^{26}$ and $R^{27}$ each independently represent a hydrogen atom, an alkyl group, a cycloalkyl group, an alkoxy group, a cycloalkoxy group, an aryl group, an aryloxy group, a monovalent heterocyclic group, a halogen atom, a group represented by $-B(OR^{W1})_2$, an alkylsulfonyloxy group, a cycloalkylsulfonyloxy group or an arylsulfonyloxy group, and these groups each optionally have a substituent. At least one of $R^{24}$, $R^{25}$ and $R^{26}$ is a group represented by $-B(OR^{W1})_2$, an alkylsulfonyloxy group, a cycloalkylsulfonyloxy group, an arylsulfonyloxy group, a chlorine atom, a bromine atom or an iodine atom.
$Z^1$ represents an alkyl group, a cycloalkyl group, an aryl group or a monovalent heterocyclic group, and these groups each optionally have a substituent.
$W^1$ represents a group represented by $-B(OR^{W1})_2$, a group represented by $-MgX^{W1}$, an alkylsulfonyloxy group, a cycloalkylsulfonyloxy group, an arylsulfonyloxy group, a chlorine atom, a bromine atom or an iodine atom, and these groups each optionally have a substituent.
$X^{W1}$ represents a chlorine atom, a bromine atom or an iodine atom.
$R^{W1}$ represents a hydrogen atom, an alkyl group, a cycloalkyl group, an aryl group or an amino group, and these groups each optionally have a substituent. The plurality of $R^{W1}$ may be the same or different and may be combined together to form a cyclic structure together with the oxygen atoms to which they are attached.]

The group represented by $-B(OR^{W1})_2$ includes, for example, groups represented by the following formulae (W-1)-(W-10).

[Chemical Formula 60]

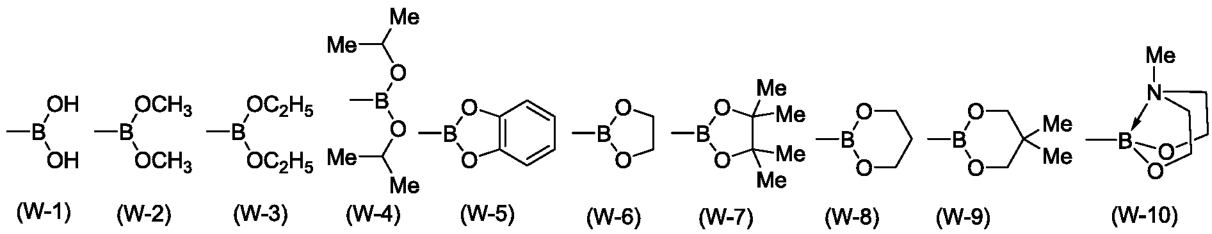

The alkylsulfonyloxy group represented by $W^1$ includes a methanesulfonyloxy group, an ethanesulfonyloxy group, a trifluoromethanesulfonyloxy group and the like.
The arylsulfonyloxy group represented by $W^1$ includes a p-toluenesulfonyloxy group and the like.
$W^1$ is preferably a group represented by $-B(OR^{W1})_2$, a trifluoromethanesulfonyloxy group, a bromine atom or

an iodine atom, more preferably a bromine atom or a group represented by the formula (W-7), because a coupling reaction of a compound represented by the formula (2) and a compound represented by the formula (M-4) progresses easily.

The examples of the alkylsulfonyloxy group, the cycloalkylsulfonyloxy group and the arylsulfonyloxy group represented by $R^{24}$, $R^{25}$ and $R^{26}$ are respectively the same as the examples of the alkylsulfonyloxy group, the cycloalkylsulfonyloxy group and the arylsulfonyloxy group represented by $W^1$.

$R^{24}$, $R^{25}$ and $R^{26}$ represent preferably a bromine atom, an iodine atom or a group represented by the formula (W-7).

$Z^1$ is preferably an alkyl group or an aryl group, more preferably a group selected from groups represented by the above-described formula (II-01) to formula (II-010), a group selected from groups represented by the above-described formula (III-01) to formula (111-08), or a group represented by the above-described formula (D-A).

This reaction is conducted usually in a solvent. The solvent, the reaction time and the reaction temperature are the same as those explained for the step A and the step B.

In this reaction, the amount of a compound represented by the formula (2) is usually 0.05 to 20 mol with respect to 1 mol of a compound represented by the formula (M-4).

The compound represented by the formula (2) can be synthesized, for example, according to methods described in documents such as International Publication WO2002/067343, JP-A No. 2003-231692, International Publication WO2003/079736 and International Publication WO2006/097717.

The compound represented by the formula (M-5) as one embodiment of a compound represented by the formula (M-4) can be synthesized, for example, by a method of condensing a benzoylimidic acid ester compound represented by the formula (M-7) and an arylhydrazine compound represented by the formula (M-6) .

[Chemical Formula 61]

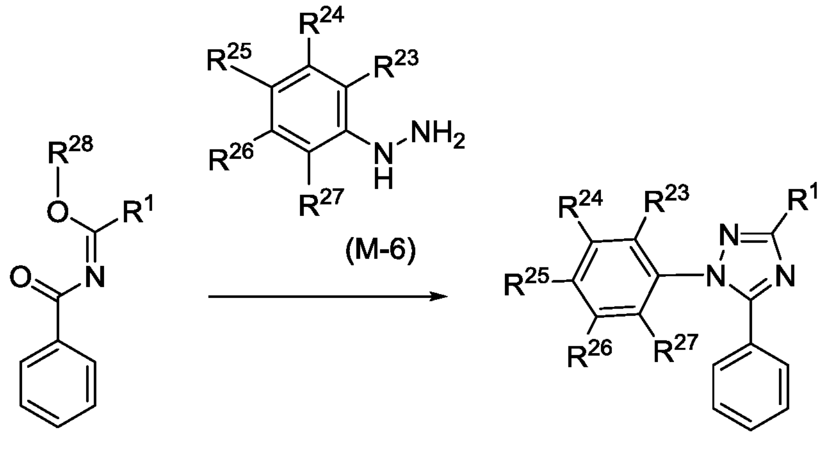

(M-6)

(M-7)

(M-5)

[wherein,

$R^1$, $R^{23}$, $R^{24}$, $R^{25}$, $R^{26}$ and $R^{27}$ represent the same meaning as described above.
$R^{28}$ represents an alkyl group, and this alkyl group optionally has a substituent.]

This reaction is conducted usually in a solvent. The solvent, the reaction time and the reaction temperature are the same as those explained for the step A and the step B. If necessary, a base may be used together.

In this reaction, the amount of a compound represented by the formula (M-6) is usually 0.05 to 20 mol with respect to 1 mol of a compound represented by the formula (M-7).

The compound represented by the formula (M-6) can be synthesized, for example, by methods described in documents such as JP-A No. 2013-147551 and "Journal of the American Chemical Society, Vol. 131, p. 16681 (2009)". The compound represented by the formula (M-6) may be a salt such as a hydrochloride.

The compound represented by the formula (M-7) can be synthesized, for example, according to methods described in documents such as "Tetrahedron Letters, No. 3, p. 325 (1968)", "Bioorganic & Medicinal Chemistry, 12, p. 2013 (2004)" and "European Journal of Organic Chemistry, p. 3197 (2011)".

The metal complex represented by the formula (3) as one embodiment of a metal complex represented by the formula (1) can be produced, for example, by coupling-reacting a compound represented by the formula (2) and a metal complex represented by the formula (4) (as one embodiment of a metal complex represented by the formula (1)). This coupling reaction is the same as that explained for a compound represented by the formula (M-3) .

[Chemical Formula 62]

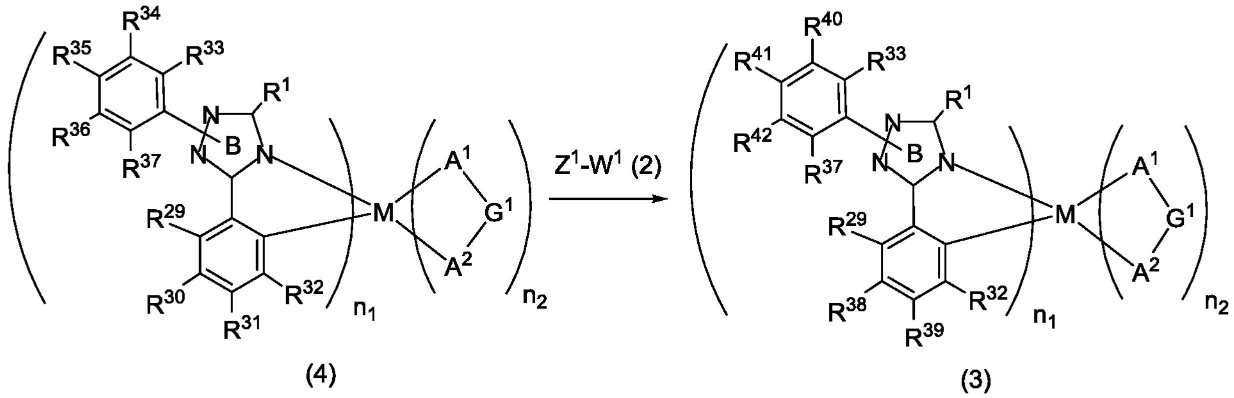


[wherein,

M, $n_1$, $n_2$, $R^1$, a ring B, $Z^1$, $W^1$ and $A^1$-$G^1$-$A^2$ represent the same meaning as described above.

$R^{29}$, $R^{30}$, $R^{31}$, $R^{32}$, $R^{33}$, $R^{34}$, $R^{35}$, $R^{36}$ and $R^{37}$ each independently represent a hydrogen atom, an alkyl group, a cycloalkyl group, an alkoxy group, a cycloalkoxy group, an aryl group, an aryloxy group, a monovalent heterocyclic group, a halogen atom, a group represented by $-B(OR^{W1})_2$, an alkylsulfonyloxy group, a cycloalkylsulfonyloxy group or an arylsulfonyloxy group, and these groups each optionally have a substituent. $R^{W1}$ represents the same meaning as described above. At least one of $R^{30}$, $R^{31}$, $R^{34}$, $R^{35}$ and $R^{36}$ is a group represented by $-B(OR^{W1})_2$, an alkylsulfonyloxy group, a cycloalkylsulfonyloxy group, an arylsulfonyloxy group, a chlorine atom, a bromine atom or an iodine atom.

$R^{38}$, $R^{39}$, $R^{40}$, $R^{41}$ and $R^{42}$ each independently represent a hydrogen atom, an alkyl group, a cycloalkyl group, an alkoxy group, a cycloalkoxy group, an aryl group, an aryloxy group, a monovalent heterocyclic group or a halogen atom, and these groups each optionally have a substituent. At least one of $R^{38}$ , $R^{39}$, $R^{40}$, $R^{41}$ and $R^{42}$ is a group represented by $Z^1$.]

The metal complex represented by the formula (4-a) or the formula (4-b) can be synthesized, for example, from a metal complex represented by the formula (5) as one embodiment of a metal complex represented by the formula (4).

[Chemical Formula 63]

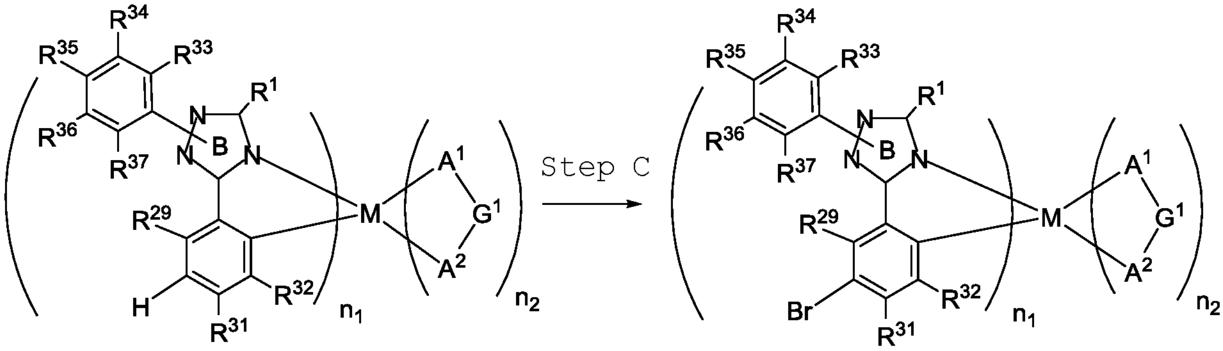


(5)

(4-a)

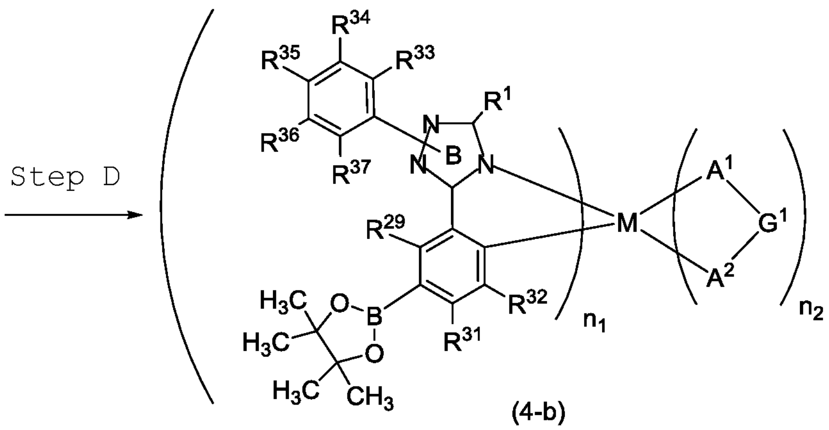


(4-b)

[wherein, M, $n_1$, $n_2$, $R^1$, a ring B, $R^{29}$, $R^{31}$, $R^{32}$, $R^{33}$, $R^{34}$, $R^{35}$, $R^{36}$ and $R^{37}$ and $A^1$-$G^1$-$A^2$ represent the same meaning as described above.]

More specifically, the metal complex represented by the formula (4a) can be synthesized, for example, by a step C of reacting a metal complex represented by the formula (5) and N-bromosuccinimide in an organic solvent.

In the step C, the amount of N-bromosuccinimide is usually 1 to 50 mol with respect to 1 mol of a compound represented by the formula (5).

More specifically, the metal complex represented by the formula (4b) can be synthesized, for example, by a step D of reacting a metal complex represented by the formula (4a) and bis(pinacolato)diboron in an organic solvent.

In the step D, the amount of bis(pinacolato)diboron is usually 1 to 50 mol with respect to 1 mol of a compound represented by the formula (4a).

The step C and the step D are conducted usually in a solvent. The solvent, the reaction time and the reaction temperature are the same as those explained for the step A and the step B.

In the above-described coupling reaction used in the production method of the metal complex of the present disclosure, catalysts such as a palladium catalyst may be used, for promoting the reaction. The palladium catalyst includes palladium acetate, bis(triphenylphosphine)palladium(II) dichloride, tetrakis(triphenylphosphine)palladium(0), [1,1'-bis(diphenylphosphino)ferrocene]dichloropalladium(II) , tris(dibenzylideneacetone)dipalladium(0) and the like.

The palladium catalyst may be used together with a phosphorus compound such as triphenylphosphine, tri(o-tolyl)phosphine, tri(tert-butyl)phosphine, tricyclohexylphosphine and 1,1'-bis(diphenylphosphino)ferrocene.

When the palladium catalyst is used in a coupling reaction, its amount is, for example, usually effective amount, preferably 0.00001 to 10 mol in terms of a palladium element, with respect to 1 mol of a compound represented by the formula (M-4), the formula (4), the formula (4-a) or the formula (4-b) .

In the coupling reaction, if necessary, a base is used together.

The compounds, the catalysts and the solvents used in each reaction explained in <Production method of metal complex> each may be used singly, or two or more of them may be used in combination.

<Composition>

The composition of the present invention comprises at least one material selected from the group consisting of a hole transporting material, a hole injection material, an electron transporting material, an electron injection material, a light emitting material (the light emitting material is different from the metal complex of the present invention), an antioxidant and a solvent, and the metal complex of the present invention.
In the composition of the present invention, the metal complex of the present invention may be contained singly, or the two or more metal complexes of the present invention may be contained.

[Host material]

By a composition comprising the metal complex of the present invention and a host material having at least one function selected from hole injectability, hole transportability, electron injectability and electron transportability, the light emission efficiency of a light emitting device produced by using the metal complex of the present invention is excellent. In the composition of the present invention, a host material may be contained singly or two or more host materials may be contained.
In the composition comprising the metal complex of the present invention and the host material, the content of the metal complex of the present invention is usually 0.05 to 80 parts by weight, preferably 0.1 to 50 parts by weight, more preferably 0.5 to 40 parts by weight, when the total amount of the metal complex of the present invention and the host material is 100 parts by weight.
It is preferable that the lowest excited triplet state ($T_1$) of the host material has energy level equal to or higher than $T_1$ of the metal complex of the present invention because a light emitting device produced by using the composition of the present invention is excellent in light emission efficiency.
It is preferable that the host material shows solubility in a solvent which is capable of dissolving the metal complex of the present invention because the light emitting device produced by using the composition of the present invention can be produced by a solution coating process.
The host materials are classified into low molecular weight compounds and polymer compounds.
The low molecular weight compound which is preferable as a host compound (hereinafter, referred to as "low molecular weight host".) will be explained.

[Low molecular weight host]

The low molecular weight host is preferably a compound represented by the formula (H-1).
$Ar^{H1}$ and $Ar^{H2}$ are preferably a phenyl group, a fluorenyl group, a spirobifluorenyl group, a pyridyl group, a pyrimidinyl group, a triazinyl group, a quinolinyl group, an isoquinolinyl group, a thienyl group, a benzothienyl group, a dibenzothienyl group, a furyl group, a benzofuryl group, a dibenzofuryl group, a pyrrolyl group, an indolyl group, an azaindolyl group, a carbazolyl group, an azacarbazolyl group, a diazacarbazolyl group, a phenoxazinyl group or a phenothiazinyl group, more preferably a phenyl group, a spirobifluorenyl group, a pyridyl group, a pyrimidinyl group, a triazinyl group, a dibenzothienyl group, a dibenzofuryl group, a carbazolyl group or an azacarbazolyl group, further preferably a phenyl group, a pyridyl group, a carbazolyl group or an azacarbazolyl group, particularly preferably a group represented by the formula (TDA-1) or (TDA-3) described above, especially preferably a group represented by the formula (TDA-3) described above, and these groups each optionally have a substituent.
The substituent which $Ar^{H1}$ and $Ar^{H2}$ optionally have is preferably a halogen atom, an alkyl group, a cycloalkyl group, an alkoxy group, a cycloalkoxy group, an aryl group or a monovalent heterocyclic group, more preferably an alkyl group, a cycloalkoxy group, an alkoxy group or cycloalkoxy group, further preferably an alkyl group or cycloalkoxy group, and these groups each optionally further have a substituent.
$n^{H1}$ is preferably 1. $n^{H2}$ is preferably 0.
$n^{H3}$ is usually an integer of 0 to 10, preferably an integer of 0 to 5, further preferably an integer of 1 to 3, particularly preferably 1.
$n^{H11}$ is preferably an integer of 1 to 5, more preferably an integer of 1 to 3, further preferably 1.
$R^{H11}$ is preferably a hydrogen atom, an alkyl group, a cycloalkyl group, an aryl group or a monovalent heterocyclic group, more preferably a hydrogen atom, an alkyl group or a cycloalkyl group, further preferably a hydrogen atom or an alkyl group, and these groups each optionally have a substituent.
$L^{H1}$ is preferably an arylene group or a divalent heterocyclic group.
$L^{H1}$ is preferably a group represented by the formula (A-1) to (A-3), the formula (A-8) to (A-10), the formula (AA-1) to (AA-6), the formula (AA-10) to (AA-21) or the formula (AA-24) to (AA-34), more preferably a group represented by the formula (A-1), the formula (A-2), the formula (A-8), the formula (A-9), the formula (AA-1) to (AA-4), the formula (AA-10) to (AA-15) or the formula (AA-29) to (AA-34), further preferably a group represented by the formula (A-1), the

formula (A-2), the formula (A-8), the formula (A-9), the formula (AA-2), the formula (AA-4) or the formula (AA-10) to (AA-15), particularly preferably a group represented by the formula (A-1), the formula (A-2), the formula (A-8), the formula (AA-2), the formula (AA-4), the formula (AA-10), the formula (AA-12) or the formula (AA-14), especially preferably a group represented by the formula (A-1), the formula (A-2), the formula (AA-2), the formula (AA-4) or the formula (AA-14).

The substituent which $L^{H1}$ optionally has is preferably a halogen atom, an alkyl group, a cycloalkyl group, an alkoxy group, a cycloalkoxy group, an aryl group or a monovalent heterocyclic group, more preferably an alkyl group, an alkoxy group, an aryl group or a monovalent heterocyclic group, further preferably an alkyl group, an aryl group or a monovalent heterocyclic group, and these groups optionally further have a substituent.

$L^{H21}$ is preferably a single bond or an arylene group, more preferably a single bond, and this arylene group optionally has a substituent.

The definition and examples of the arylene group or the divalent heterocyclic group represented by $L^{H21}$ are the same as the definition and examples of the arylene group or the divalent heterocyclic group represented by $L^{H1}$.

$R^{H21}$ is preferably an aryl group or a monovalent heterocyclic group, and these groups each optionally have a substituent.

The definition and examples of the aryl group and the monovalent heterocyclic group represented by $R^{H21}$ are the same as the definition and examples of the aryl group and the monovalent heterocyclic group represented by $Ar^{H1}$ and $Ar^{H2}$.

The definition and examples of the substituent which $R^{H21}$ may optionally has are the same as the definition and examples of the substituent which $Ar^{H1}$ and $Ar^{H2}$ optionally have.

The compound represented by the formula (H-1) is preferably a compound represented by the formula (H-2).

[Chemical Formula 64]

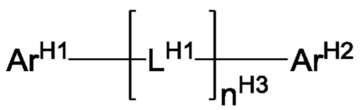

**(H-2)**

[wherein, $Ar^{H1}$, $Ar^{H2}$, $n^{H3}$ and $L^{H1}$ represent the same meaning as described above.]

As the compound represented by the formula (H-1), compounds represented by the following formulae (H-101) to (H-118) are exemplified.

[Chemical Formula 65]

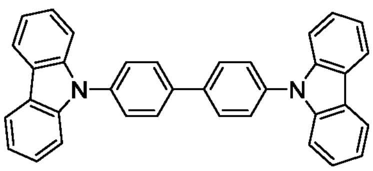

**(H-101)**

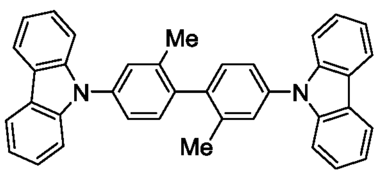

**(H-102)**

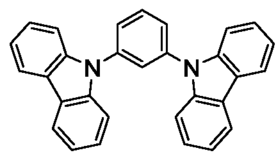

**(H-103)**

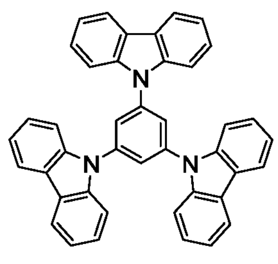

**(H-104)**

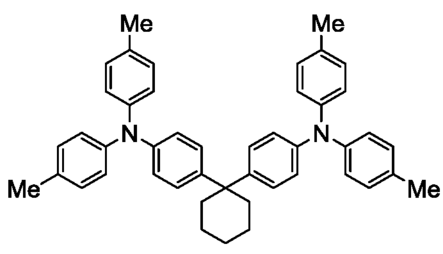

**(H-105)**

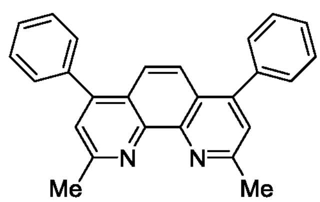

**(H-106)**

[Chemical Formula 66]

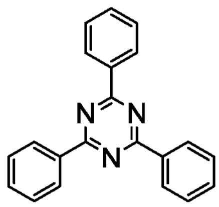

(H-107)

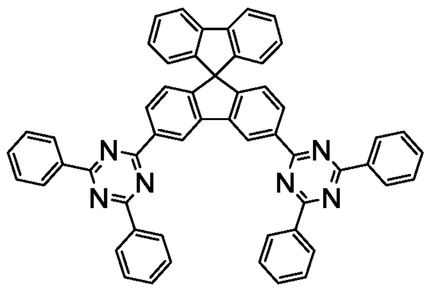

(H-108)

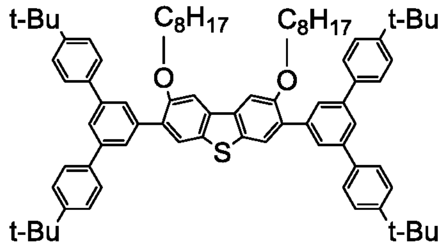

(H-109)

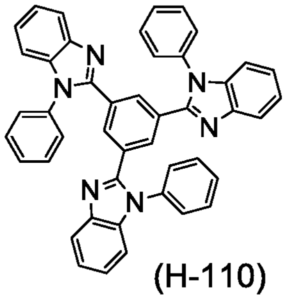

(H-110)

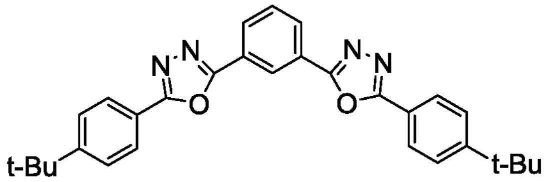

(H-111)

[Chemical Formula 67]

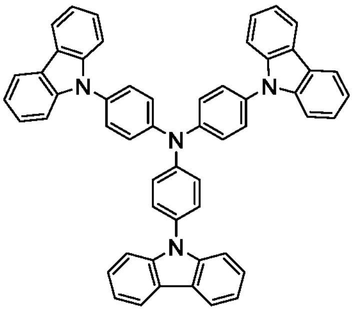

(H-112)

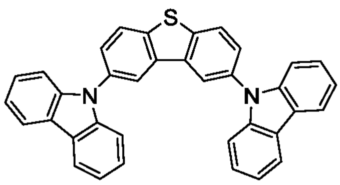

(H-113)

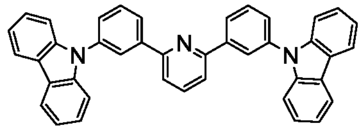

(H-114)

[Chemical Formula 68]

(H-112)

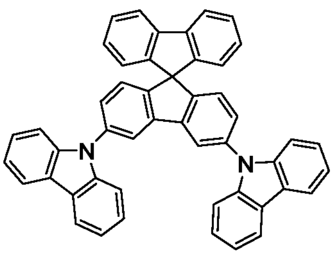

(H-115)

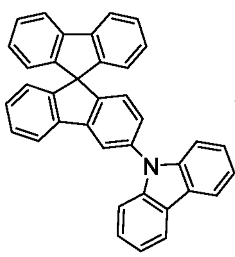

(H-116)

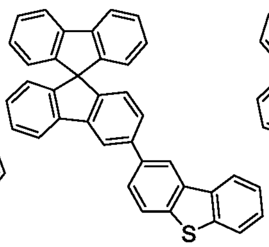

(H-117)

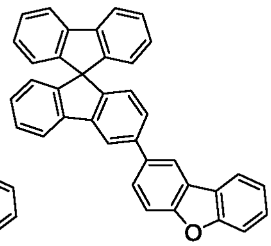

(H-118)

The polymer compound used as a host material includes, for example, polymer compounds as a hole transporting material described later and polymer compounds as an electron transporting material described later.

[Polymer host]

The polymer compound which is preferable as a host compo und (hereinafter, referred to also as "polymer host") will b e explained.

The polymer host is preferably a polymer compound comprising a constitutional unit represented by the formula (Y) .

The arylene group represented by $Ar^{Y1}$ is more preferably a group represented by the formula (A-1), the formula (A-2), the formula (A-6) to (A-10), the formula (A-19) or the formula (A-20), further preferably a group represented by the formula (A-1), the formula (A-2), the formula (A-7), the formula (A-9) or the formula (A-19), and these groups each optionally have a substituent.

The divalent heterocyclic group represented by $Ar^{Y1}$ is more preferably a group represented by the formula (AA-1) to (AA-4), the formula (AA-10) to (AA-15), the formula (AA-18) to (AA-21), the formula (AA-33) or the formula (AA-34), further preferably a group represented by the formula (AA-4), the formula (AA-10), the formula (AA-12), the formula (AA-14) or the formula (AA-33), and these groups each optionally have a substituent.

The more preferable range and the further preferable range of the arylene group and the divalent heterocyclic group in the divalent group in which at least one arylene group and at least one divalent heterocyclic group are bonded directly to each other represented by $Ar^{Y1}$ are the same as the more preferable range and the further preferable range of the arylene group and the divalent heterocyclic group represented by $Ar^{Y1}$ described above, respectively.

"The divalent group in which at least one arylene group and at least one divalent heterocyclic group are bonded directly to each other" includes, for example, groups represented by the following formulae, and each of them optionally has a substituent.

[Chemical Formula 69]

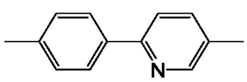
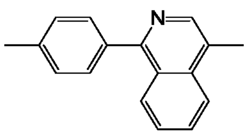
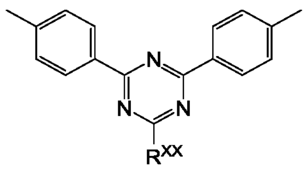
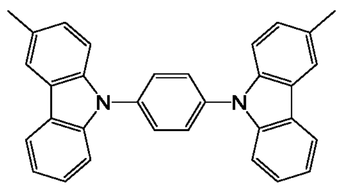

[wherein, $R^{XX}$ represents a hydrogen atom, an alkyl group, a cycloalkyl group, an aryl group or a monovalent heterocyclic group and these groups each optionally have a substituent.]

$R^{XX}$ is preferably an alkyl group, a cycloalkyl group or an aryl group, and these groups each optionally have a substituent.

The substituent which the group represented by $Ar^{Y1}$ optionally has is preferably an alkyl group, a cycloalkyl group or an aryl group, and these groups each optionally further have a substituent.

The constitutional unit represented by the formula (Y) includes, for example, constitutional units represented by the formulae (Y-1) to (Y-10), and from the standpoint of the luminance life of the light emitting device produced by using the composition comprising the polymer host and the metal complex of the present invention preferable are constitutional units represented by the formulae (Y-1) to (Y-3), from the standpoint of electron transportability preferable are constitutional units represented by the formulae (Y-4) to (Y-7), and from the standpoint of hole transportability preferable are constitutional units represented by the formulae (Y-8) to (Y-10).

[Chemical Formula 70]

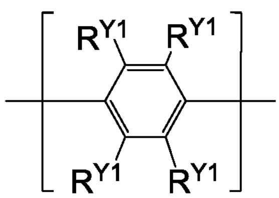
(Y-1)

[wherein, $R^{Y1}$ represents a hydrogen atom, an alkyl group, a cycloalkyl group, an alkoxy group, a cycloalkoxy group, an aryl group or a monovalent heterocyclic group, and these groups each optionally have a substituent. The plurality of $R^{Y1}$ may be the same or different, and adjacent $R^{Y1}$s may be combined together to form a ring together with the carbon atoms to which they are attached.]

$R^{Y1}$ is preferably a hydrogen atom, an alkyl group, a cycloalkyl group or an aryl group, and these groups each

optionally have a substituent.

It is preferable that the constitional unit represented by the formula (Y-1) is a constitutional unit represented by the formula (Y-1').

[Chemical Formula 71]

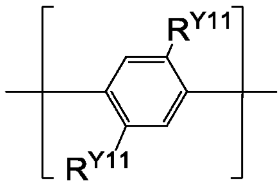

(Y-1')

[wherein, $R^{Y11}$ represents an alkyl group, a cycloalkyl group, an alkoxy group, a cycloalkoxy group, an aryl group or a monovalent heterocyclic group, and these groups each optionally have a substituent. The plurality of $R^{Y11}$ may be the same or different.]

$R^{Y11}$ is preferably an alkyl group, a cycloalkyl group or an aryl group, more preferably an alkyl group or a cycloalkyl group, and these groups each optionally have a substituent.

[Chemical Formula 72]

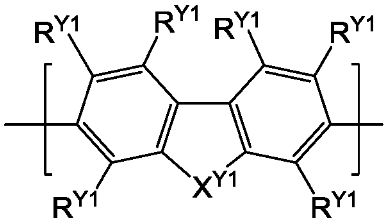

(Y-2)

[wherein, $R^{Y1}$ represents the same meaning as described above. $X^{Y1}$ represents a group represented by $-C(R^{Y2})_2-$, $-C(R^{Y2})=C(R^{Y2})-$ or $-C(R^{Y2})_2-C(R^{Y2})_2-$. $R^{Y2}$ represents a hydrogen atom, an alkyl group, a cycloalkyl group, an alkoxy group, a cycloalkoxy group, an aryl group or a monovalent heterocyclic group and these groups each optionally have a substituent. The plurality of $R^{Y2}$ may be the same or different, and these $R^{Y2}$ s may be combined together to form a ring together with the carbon atoms to which they are attached.]

$R^{Y2}$ is preferably an alkyl group, a cycloalkyl group, an aryl group or a monovalent heterocyclic group, more preferably an alkyl group a cycloalkyl group or an aryl group, and these groups each optionally have a substituent.

Regarding the combination of two $R^{Y2}$s in the group represented by $-C(R^{Y2})_2-$ in $X^{Y1}$, it is preferable that the both are an alkyl group or a cycloalkyl group, the both are an aryl group, the both are a monovalent heterocyclic group, or one is an alkyl group or a cycloalkyl group and the other is an aryl group or a monovalent heterocyclic group, it is more preferable that one is an alkyl group or cycloalkyl group and the other is an aryl group, and these groups each optionally have a substituent. The two groups $R^{Y2}$ may be combined together to form a ring together with the atoms to which they are attached, and when the groups $R^{Y2}$ form a ring, the group represented by $-C(R^{Y2})_2-$ is preferably a group represented by the formula (Y-A1) to (Y-A5), more preferably a group represented by the formula (Y-A4), and these groups each optionally have a substituent.

[Chemical Formula 73]

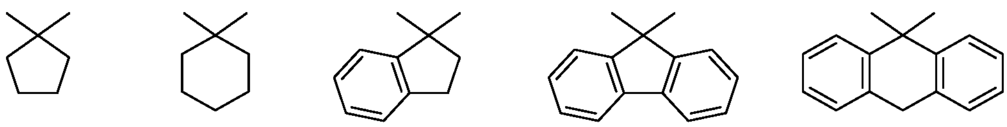

(Y-A1) (Y-A2) (Y-A3) (Y-A4) (Y-A5)

Regarding the combination of two $R^{Y2}$s in the group represented by $-C(R^{Y2})=C(R^{Y2})-$ in $X^{Y1}$, it is preferable that the both are an alkyl group or cycloalkyl group, or one is an alkyl group or a cycloalkyl group and the other is an aryl group, and these groups each optionally have a substituent.

Four $R^{Y2}$s in the group represented by $-C(R^{Y2})_2-C(R^{Y2})_2-$ in $X^{Y1}$ are preferably an alkyl group or a cycloalkyl group each optionally having a substituent. The plurality of $R^{Y2}$ may be combined together to form a ring together with the atoms to which they are attached, and when the groups $R^{Y2}$ form a ring, the group represented by $-C(R^{Y2})_2-C(R^{Y2})_2-$ is preferably a group represented by the formula (Y-B1) to (Y-B5), more preferably a group represented by the formula (Y-B3), and these groups each optionally have a substituent.

[Chemical Formula 74]

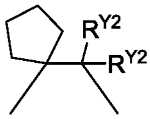
(Y-B1)

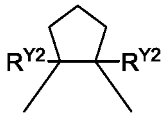
(Y-B2)

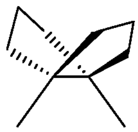
(Y-B3)

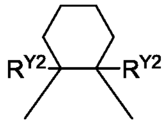
(Y-B4)

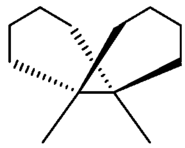
(Y-B5)

[wherein, $R^{Y2}$ represents the same meaning as described above.]

It is preferable that the constitutional unit represented by the formula (Y-2) is a constitutional unit represented by the formula (Y-2').

[Chemical Formula 75]

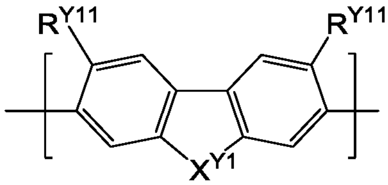
(Y-2')

[wherein, $R^{Y11}$ and $X^{Y1}$ represent the same meaning as described above.]

[Chemical Formula 76]

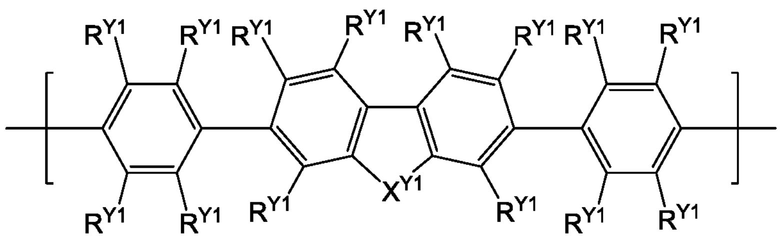
(Y-3)

[wherein, $R^{Y1}$ and $X^{Y1}$ represent the same meaning as described above.]

It is preferable that the constitutional unit represented by the formula (Y-3) is a constitutional unit represented by the formula (Y-3').

[Chemical Formula 77]

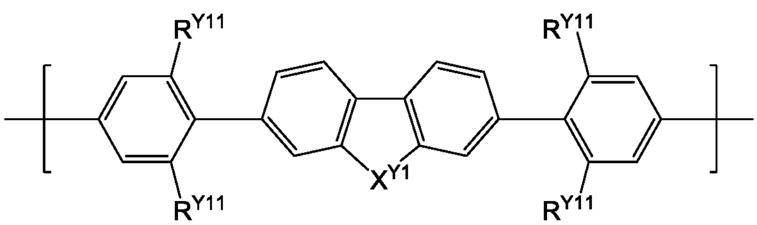
(Y-3')

[wherein, $R^{Y11}$ and $X^{Y1}$ represent the same meaning as described above.]

[Chemical Formula 78]

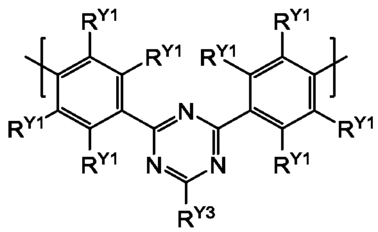

(Y-4)

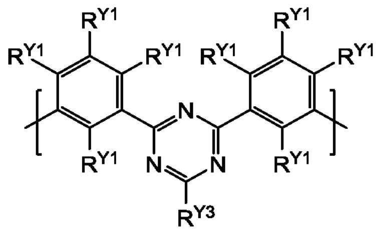

(Y-5)

[Chemical Formula 79]

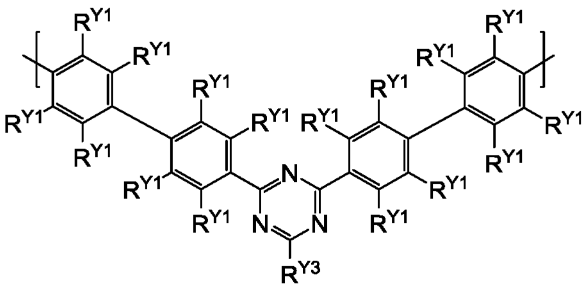

(Y-6)

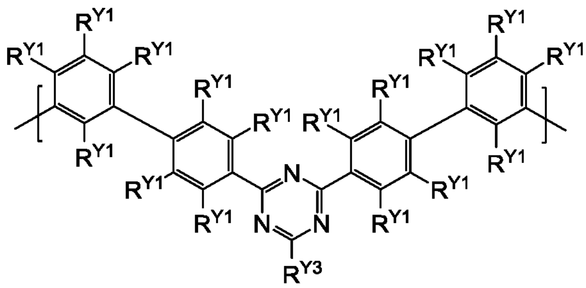

(Y-7)

[wherein, $R^{Y1}$ represents the same meaning as described above. $R^{Y3}$ represents a hydrogen atom, an alkyl group, a cycloalkyl group, an alkoxy group, a cycloalkoxy group, an aryl group or a monovalent heterocyclic group and these groups each optionally have a substituent.]

$R^{Y3}$ is preferably an alkyl group, a cycloalkyl group, an alkoxy group, a cycloalkoxy group, an aryl group or a monovalent heterocyclic group, more preferably an aryl group, and these groups each optionally have a substituent.

It is preferable that the constitutional unit represented by the formula (Y-4) is a constitutional unit represented by the formula (Y-4'), and it is preferable that the constitutional unit represented by the formula (Y-6) is a constitutional unit represented by the formula (Y-6').

[Chemical Formula 80]

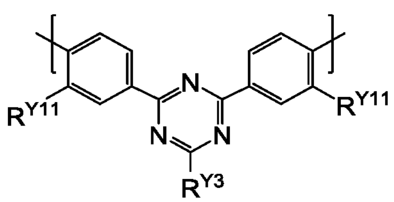

(Y-4')

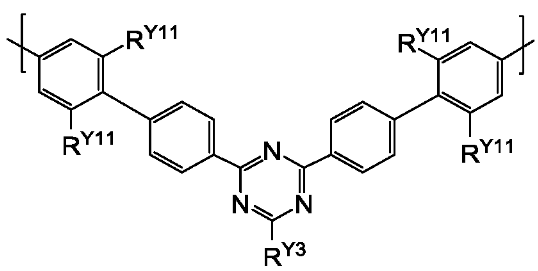

(Y-6')

[wherein, $R^{Y1}$ and $R^{Y3}$ represent the same meaning as described above.]

[Chemical Formula 81]

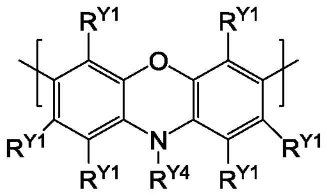
(Y-8)
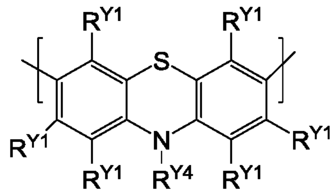
(Y-9)
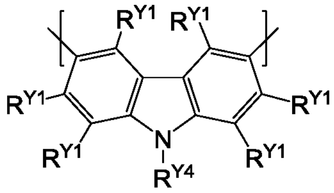
(Y-10)

[wherein, $R^{Y1}$ represents the same meaning as described above. $R^{Y4}$ represents a hydrogen atom, an alkyl group, a cycloalkyl group, an alkoxy group, a cycloalkoxy group, an aryl group or a monovalent heterocyclic group, and these groups each optionally have a substituent.]

$R^{Y4}$ is preferably an alkyl group, a cycloalkyl group, an alkoxy group, a cycloalkoxy group, an aryl group or a monovalent heterocyclic group, more preferably an aryl group, and these groups each optionally have a substituent.

The constitutional unit represented by the formula (Y) includes, for example, a constitutional unit composed of an arylene group represented by the formula (Y-101) to (Y-121), a constitutional unit composed of a divalent heterocyclic group represented by the formula (Y-201) to (Y-206), and a constitutional unit composed of a divalent group in which at least one arylene group and at least one divalent heterocyclic group are bonded directly to each other represented by the formula (Y-301) to (Y-304).

[Chemical Formula 82]

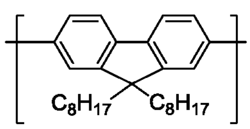
(Y-101)
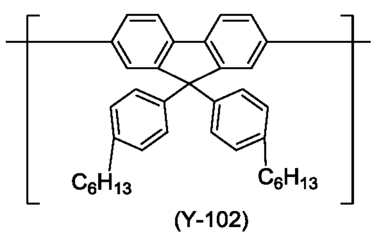
(Y-102)
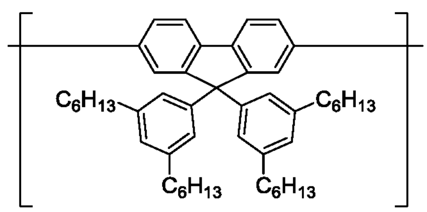
(Y-103)

[Chemical Formula 83]

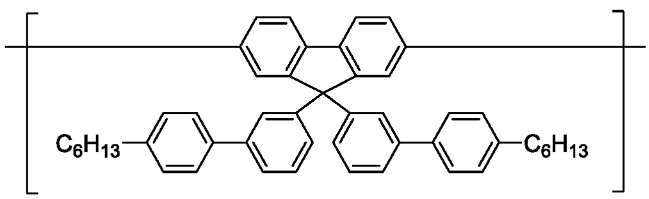
(Y-104)
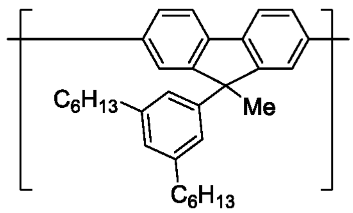
(Y-105)

[Chemical Formula 84]

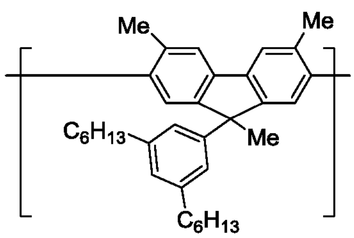
(Y-106)
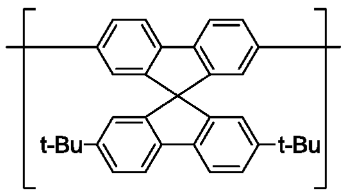
(Y-107)
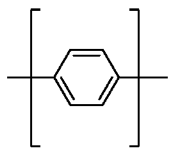
(Y-108)
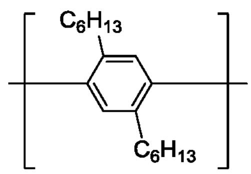
(Y-109)

[Chemical Formula 85]

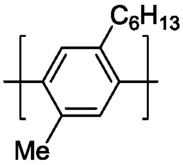

(Y-110)

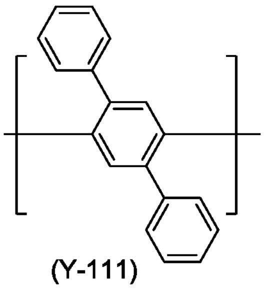

(Y-111)

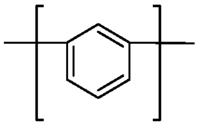

(Y-112)

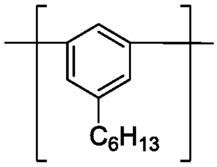

(Y-113)

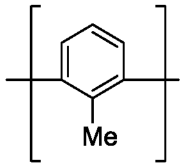

(Y-114)

[Chemical Formula 86]

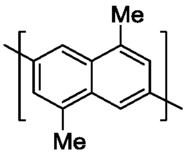

(Y-115)

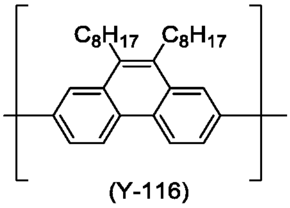

(Y-116)

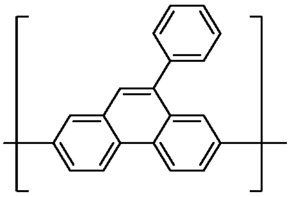

(Y-117)

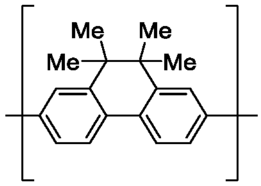

(Y-118)

[Chemical Formula 87]

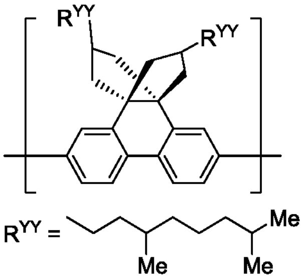

(Y-119)

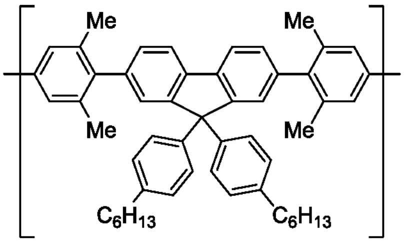

(Y-120)

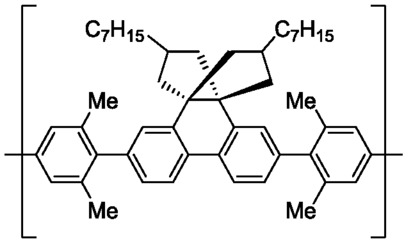

(Y-121)

[Chemical Formula 88]

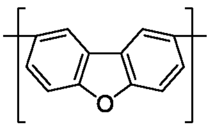

(Y-201)

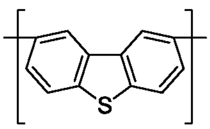

(Y-202)

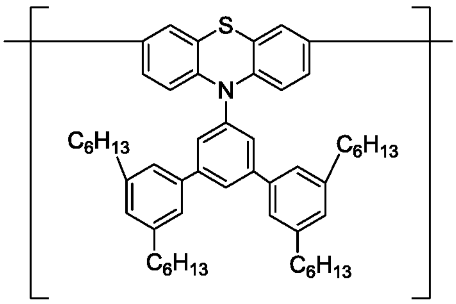

(Y-203)

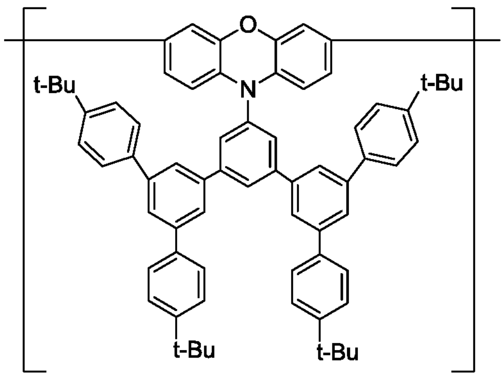

(Y-204)

[Chemical Formula 89]

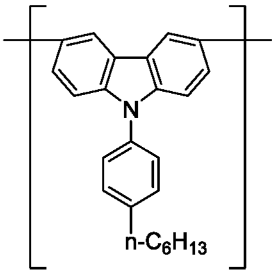

(Y-205)

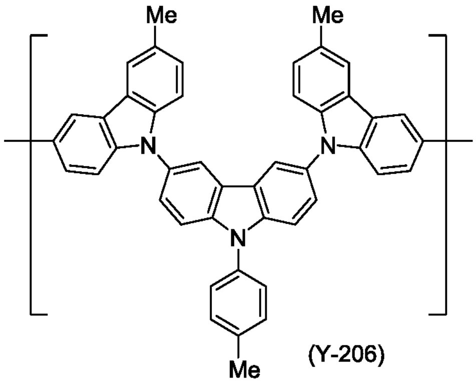

(Y-206)

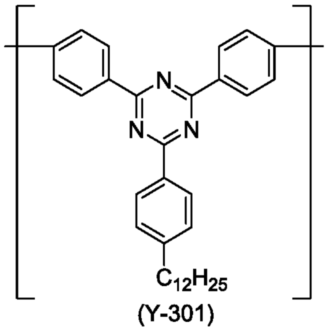

(Y-301)

[Chemical Formula 90]

【化９０】

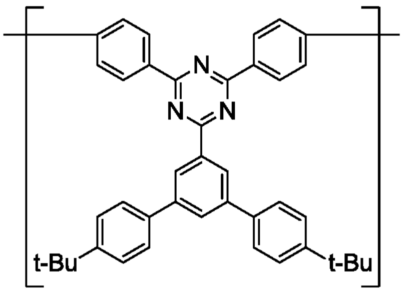

(Y-302)

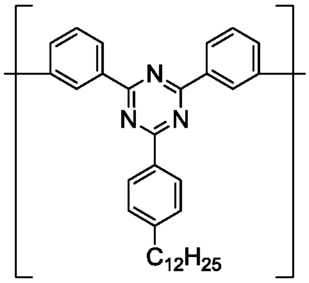

(Y-303)

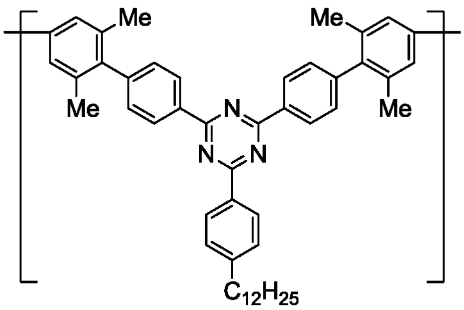

(Y-304)

The amount of the constitutional unit represented by the formula (Y) in which $Ar^{Y1}$ is an arylene group is preferably 0.5 to 80 mol%, more preferably 30 to 60 mol% with respect to the total amount of constitutional units contained in a polymer compound, because the luminance life of a light emitting device produced by using a composition comprising a polymer host and the metal complex of the present invention is excellent.

The amount of the constitutional unit represented by the formula (Y) in which $Ar^{Y1}$ is a divalent heterocyclic group or a divalent group in which at least one arylene group and at least one divalent heterocyclic group are bonded directly to each other is preferably 0.5 to 30 mol%, more preferably 3 to 20 mol% with respect to the total amount of constitutional units contained in a polymer compound, because the charge transportability of a light emitting device produced by using a composition comprising a polymer host and the metal complex of the present invention is excellent.

The constitutional unit represented by the formula (Y) may be contained only singly or two or more units thereof may be contained in the polymer host.

It is preferable that the polymer host further comprises a constitutional unit represented by the following formula (X), because hole transportability is excellent.

[Chemical Formula 91]

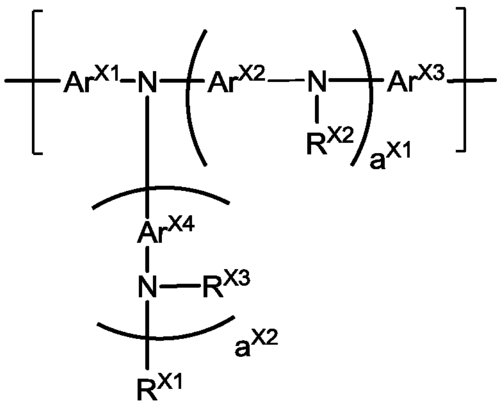

(X)

[wherein, $a^{X1}$ and $a^{X2}$ each independently represent an integer of 0 or more. $Ar^{X1}$ and $Ar^{X3}$ each independently represent an arylene group or a divalent heterocyclic group, and these groups each optionally have a substituent. $Ar^{X2}$ and $Ar^{X4}$ each independently represent an arylene group, a divalent heterocyclic group or a divalent group in which at least one arylene group and at least one divalent heterocyclic group are bonded directly to each other, and these groups each optionally have a substituent. $R^{X1}$, $R^{X2}$ and $R^{X3}$ each independently represent a hydrogen atom, an alkyl group, a cycloalkyl group, an aryl group or a monovalent heterocyclic group, and these groups each optionally have a substituent.]

$a^{X1}$ is preferably 2 or less, more preferably 1, because the luminance life of a light emitting device produced by using a composition comprising a polymer host and the metal complex of the present invention is excellent.

$a^{X2}$ is preferably 2 or less, more preferably 0, because the luminance life of a light emitting device produced by using a composition comprising a polymer host and the metal complex of the present invention is excellent.

$R^{X1}$ , $R^{X2}$ and $R^{X3}$ are preferably an alkyl group, a cycloalkyl group, an aryl group or a monovalent heterocyclic group, more preferably an aryl group, and these groups each optionally have a substituent.

The arylene group represented by $Ar^{X1}$ and $Ar^{X3}$ is more preferably a group represented by the formula (A-1) or the formula (A-9), further preferably a group represented by the formula (A-1), and these groups each optionally have a substituent.

The divalent heterocyclic group represented by $Ar^{X1}$ and $Ar^{X3}$ is more preferably a group represented by the formula (AA-1), the formula (AA-2) or the formula (AA-7) to (AA-26), and these groups each optionally have a substituent.

$Ar^{X1}$ and $Ar^{X3}$ are preferably an arylene group optionally having a substituent.

The arylene group represented by $Ar^{X2}$ and $Ar^{X4}$ is more preferably a group represented by the formula (A-1), the formula (A-6), the formula (A-7), the formula (A-9) to (A-11) or the formula (A-19), and these groups each optionally have a substituent.

The more preferable range of the divalent heterocyclic group represented by $Ar^{X2}$ and $Ar^{X4}$ is the same as the more preferable range of the divalent heterocyclic group represented by $Ar^{X1}$ and $Ar^{X3}$.

The more preferable range and the further preferable range of the arylene group and the divalent heterocyclic group in the divalent group in which at least one arylene group and at least one divalent heterocyclic group are bonded directly to each other represented by $Ar^{X2}$ and $Ar^{X4}$ are the same as the more preferable range and the further preferable range of the arylene group and the divalent heterocyclic group represented by $Ar^{X1}$ and $Ar^{X3}$, respectively.

The divalent group in which at least one arylene group and at least one divalent heterocyclic group are bonded directly to each other represented by $Ar^{X2}$ and $Ar^{X4}$ includes the same groups as the divalent group in which at least one arylene group and at least one divalent heterocyclic group are bonded directly to each other represented by $Ar^{Y1}$ in the formula (Y).

$Ar^{X2}$ and $Ar^{X4}$ are preferably an arylene group optionally having a substituent.

The substituent which the group represented by $Ar^{X1}$ to $Ar^{X4}$ and $R^{X1}$ to $R^{X3}$ optionally has is preferably an alkyl group, a cycloalkyl group or an aryl group, and these groups each optionally further have a substituent.

The constitutional unit represented by the formula (X) is preferably a constitutional unit represented by the formula (X-1) to (X-7), more preferably a constitutional unit represented by the formula (X-1) to (X-6), further preferably a constitutional unit represented by the formula (X-3) to (X-6) .

[Chemical Formula 92]

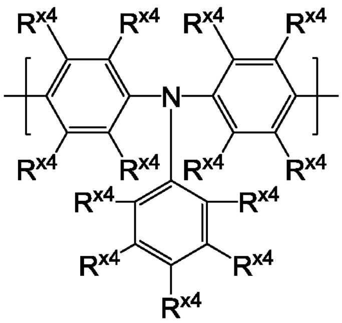
(X-1)

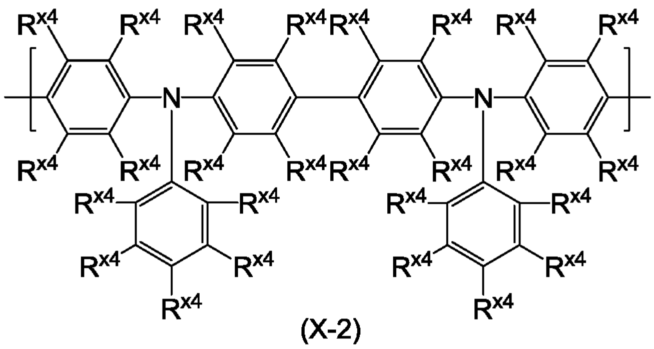
(X-2)

[Chemical Formula 93]

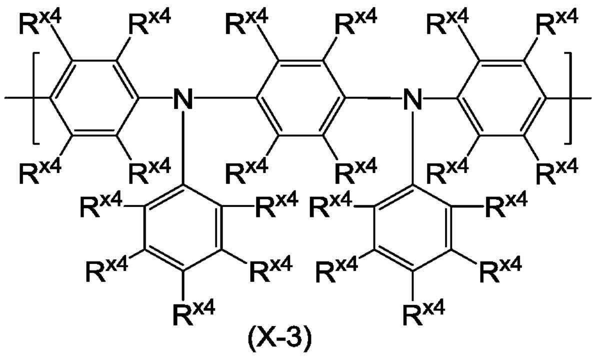
(X-3)

[Chemical Formula 94]

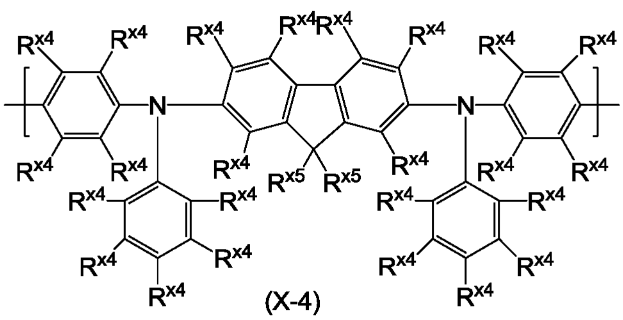
(X-4)

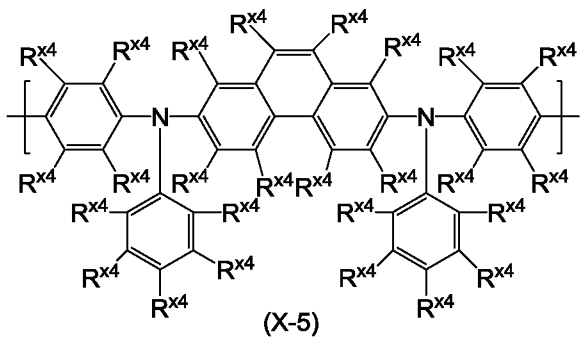
(X-5)

[Chemical Formula 95]

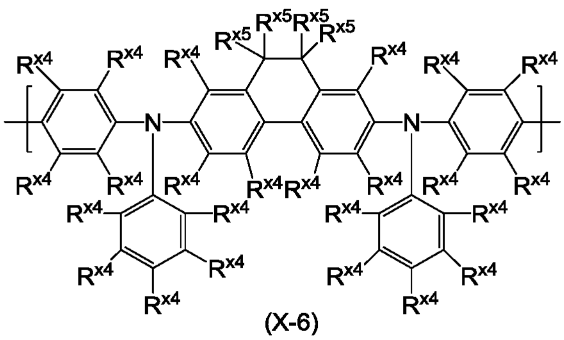
(X-6)

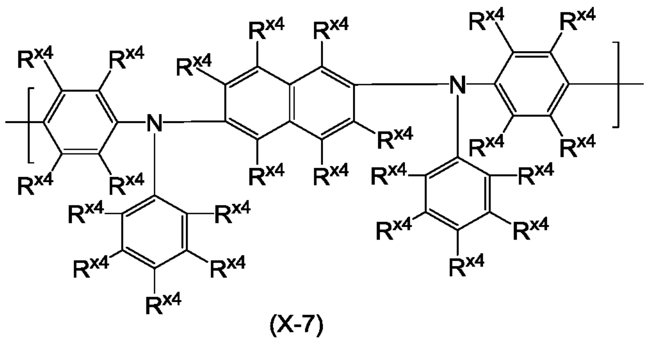
(X-7)

[wherein, $R^{X4}$ and $R^{X5}$ each independently represent a hydrogen atom, an alkyl group, a cycloalkyl group, an alkoxy group, a cycloalkoxy group, an aryl group, an aryloxy group, a halogen atom, a monovalent heterocyclic group or a cyano group, and these groups each optionally have a substituent. The plurality of $R^{X4}$ may be the same or different. The plurality of $R^{X5}$ may be the same or different, and adjacent groups $R^{X5}$ may be combined together to form a ring together with the carbon atoms to which they are attached.]

The amount of the constitutional unit represented by the formula (X) is preferably 0.1 to 50 mol%, more preferably 1 to 40 mol%, further preferably 5 to 30 mol% with respect to the total amount of constitutional units contained in a polymer host, because hole transportability is excellent.

The constitutional unit represented by the formula (X) includes, for example, constitutional units represented by the formulae (X1-1) to (X1-11), preferably constitutional units represented by the formulae (X1-3) to (X1-10).

[Chemical Formula 96]

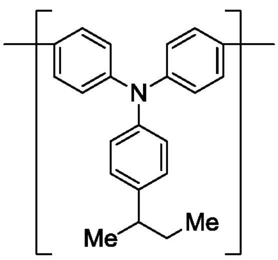
(X1-1)

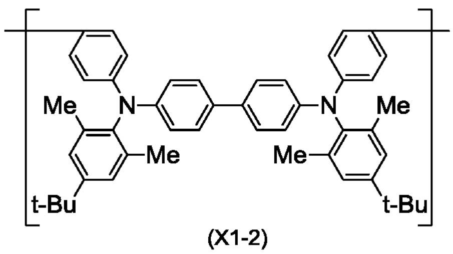
(X1-2)

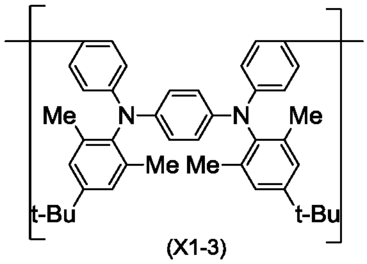
(X1-3)

[Chemical Formula 97]

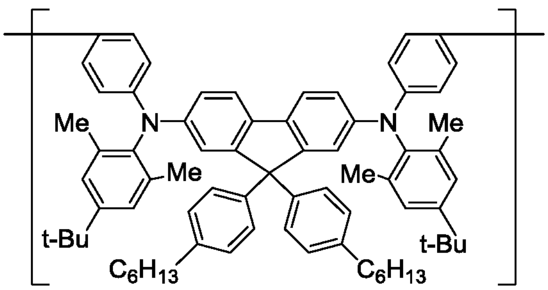
(X1-4)

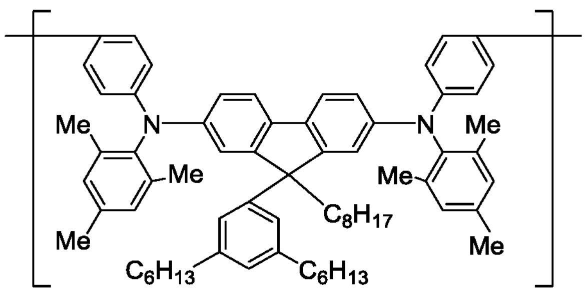
(X1-5)

[Chemical Formula 98]

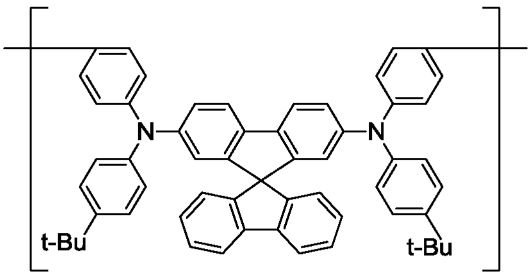

(X1-6)

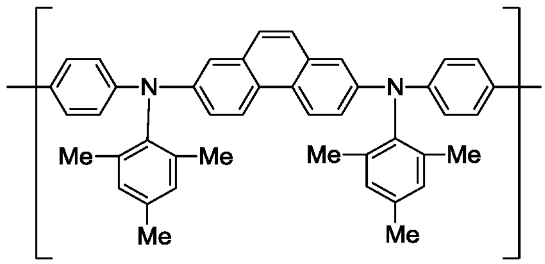

(X1-7)

[Chemical Formula 99]

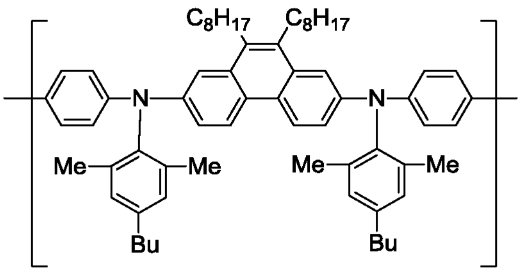

(X1-8)

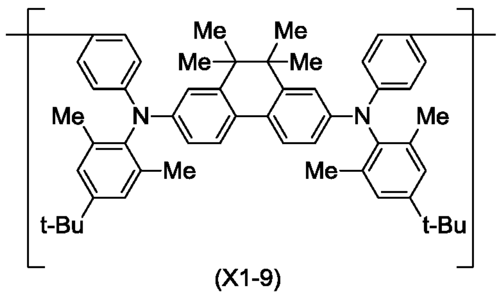

(X1-9)

[Chemical Formula 100]

【化１００】

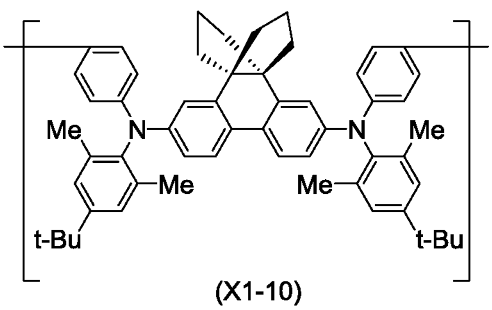

(X1-10)

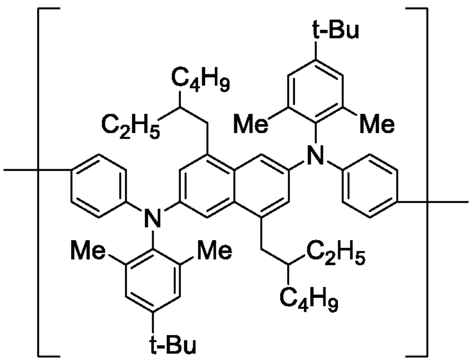

(X1-11)

The constitutional unit represented by the formula (X) may be contained only singly or two or more units thereof may be contained in the polymer host.

Examples of the polymer host include polymer compounds (P-1) to (P-6) in Table 1. "Other" constitutinal unit denotes a constitutional unit other than the constitutional unit represented by the formula (Y) and the constitutional unit represented by the formula (X).

[Table 1]

| polymer compound | constitutional unit and mole fraction thereof | | | | |
|---|---|---|---|---|---|
| | formula (Y) | | | formula (X) | other |
| | formulae (Y-1) to (Y-3) | formulae (Y-4) to (Y-7) | formulae (Y-8) to (Y-10) | formulae (X-1) to (X-7) | |
| | p | q | r | s | t |
| (P-1) | 0.1 to 99.9 | 0.1 to 99.9 | 0 | 0 | 0 to 30 |
| (P-2) | 0.1 to 99.9 | 0 | 0.1 to 99.9 | 0 | 0 to 30 |
| (P-3) | 0.1 to 99.8 | 0.1 to 99.8 | 0 | 0.1 to 99.8 | 0 to 30 |
| (P-4) | 0.1 to 99.8 | 0.1 to 99.8 | 0.1 to 99.8 | 0 | 0 to 30 |
| (P-5) | 0.1 to 99.8 | 0 | 0.1 to 99.8 | 0.1 to 99.8 | 0 to 30 |
| (P-6) | 0.1 to 99.7 | 0.1 to 99.7 | 0.1 to 99.7 | 0.1 to 99.7 | 0 to 30 |

[In the table, p, q, r, s and t represent the mole fraction of each constitutional unit. p+q+r+s+t = 100, and 100 ≥ p+q+r+s ≥ 70. Other constitutional unit denotes a constitutional unit other than the constitutional unit represented by the formula (Y) and the constitutional unit represented by the formula (X).]

The polymer host may be any of a block copolymer, a random copolymer, an alternating copolymer or a graft copolymer, and may also be another embodiment, and is preferably a copolymer produced by copolymerizing a plurality of raw material monomers.

<Production method of polymer host>

The polymer host can be produced by using a known polyme rization method described in Chem. Rev., vol. 109, pp. 897-1 091 (2009) and the like, and examples thereof include method s of causing polymerization by a coupling reaction using a t ransition metal catalyst such as the Suzuki reaction, the Ya mamoto reaction, the Buchwald reaction, the Stille reaction, the Negishi reaction and the Kumada reaction.

In the above-described polymerization method, the method of charging monomers includes a method in which the total amount of monomers is charged in a lump into the reaction system, a method in which monomers are partially charged and reacted, then, the remaining monomers are charged in a lump, continuously or in divided doses, a method in which monomers are charged continuously or in divided doses, and the like.

The transition metal catalyst includes a palladium catalyst, a nicked catalyst and the like.

For the post treatment of the polymerization reaction, known methods, for example, a method of removing water-soluble impurities by liquid-separation, a method in which the reaction solution after the polymerization reaction is added to a lower alcohol such as methanol to cause deposition of a precipitate which is then filtered before drying, and other methods, are used each singly or combined. When the purity of the polymer host is low, the polymer host can be purified by usual methods such as, for example, recrystallization, reprecipitation, continuous extraction with a Soxhlet extractor and column chromatography.

The composition comprising the metal complex of the present invention and a solvent (hereinafter, referred to as "ink") is suitable for fabrication of a light emitting device by using a printing method such as an inkjet printing method and a nozzle printing method.

The viscosity of the ink may be adjusted depending on the kind of the printing method, and when a solution goes through a discharge apparatus such as in an inkjet printing method, the viscosity is preferably in the range of 1 to 20 mPa·s at 25°C because clogging in discharging and curved aviation are less likely to occur.

As the solvent contained in the ink, those capable of dissolving or uniformly dispersing solid components in the ink are preferable. The solvent includes, for example, chlorine-based solvents such as 1,2-dichloroethane, 1,1,2-trichloroethane, chlorobenzene and o-dichlorobenzene; ether solvents such as THF, dioxane, anisole and 4-methylanisole; aromatic hydrocarbon solvents such as toluene, xylene, mesitylene, ethylbenzene, n-hexylbenzene and cyclohexylbenzene; aliphatic hydrocarbon solvents such as cyclohexane, methylcyclohexane, n-pentane, n-hexane, n-heptane, n-octane, n-nonane, n-decane, n-dodecane and bicyclohexyl; ketone solvents such as acetone, methylethylketone, cyclohexanone and acetophenone; ester solvents such as ethyl acetate, butyl acetate, ethylcellosolve acetate, methyl benzoate and phenyl acetate; poly-hydric alcohols such as ethylene glycol, glycerin and 1,2-hexanediol and derivatives thereof; alcohol solvents such as isopropylalcohol and cyclohexanol; sulfoxide solvents such as dimethyl sulfoxide; and amide solvents such as N-methyl-2-pyrrolidone and N,N-dimethylformamide. These solvents may be used singly or two or more of them may be used in combination.

In the ink, the compounding amount of the solvent is usually 1000 to 100000 parts by weight, preferably 2000 to 20000 parts by weight with respect to 100 parts by weight of the metal complex of the present invention.

[Hole transporting material]

The hole transporting material is classified into low molecular weight compounds and polymer compounds, and is preferably polymer compounds, more preferably polymer compounds having a crosslinkable group.

The polymer compound includes, for example, polyvinylcarbazole and derivatives thereof; polyarylene having an aromatic amine structure in the side chain or main chain and derivatives thereof. The polymer compound may also be a compound in which an electron accepting portion is linked. The electron accepting portion includes, for example, fullerene, tetrafluorotetracyanoquinodimethane, tetracyanoethylene, trinitrofluorenone, preferably fullerene.

In the composition of the present invention, the compounding amount of the hole transporting material is usually 1 to 400 parts by weight, preferably 5 to 150 parts by weight with respect to 100 parts by weight of the metal complex of the present invention.

The hole transporting material may be used singly or two or more hole transporting materials may be used in combination.

[Electron transporting material]

The electron transporting material is classified into lo w molecular weight compounds and polymer compounds. The elec tron transporting material optionally has a crosslinkable gr oup.

The low molecular weight compound includes, for example, a metal complex having 8-hydroxyquinoline as a ligand, oxadiazole, anthraquinodimethane, benzoquinone, naphthoquinone, anthraquinone, tetracyanoanthraquinodimethane, fluorenone, diphenyldicyanoethylene, diphenoquinone and derivatives thereof.

The polymer compound includes, for example, polyphenylene, polyfluorene and derivatives thereof. These polymer compounds may be doped with a metal.

In the composition of the present invention, the compounding amount of the electron transporting material is usually 1 to 400 parts by weight, preferably 5 to 150 parts by weight with respect to 100 parts by weight of the metal complex of the present invention.

The electron transporting material may be used singly or two or more electron transporting materials may be used in combination.

[Hole injection material and electron injection material]

The hole injection material and the electron injection m aterial are each classified into low molecular weight compou nds and polymer compounds. The hole injection material and the electron injection material optionally have a crosslinka ble group.

The low molecular weight compound includes, for example, metal phthalocyanines such as copper phthalocyanine; carbon; oxides of metals such as molybdenum and tungsten; metal fluorides such as lithium fluoride, sodium fluoride, cesium fluoride and potassium fluoride.

The polymer compound includes, for example, polyaniline, polythiophene, polypyrrole, polyphenylenevinylene, polythienylenevinylene, polyquinoline and polyquinoxaline, and derivatives thereof; electrically conductive polymers such as a polymer comprising an aromatic amine structure in the side chain or main chain.

In the composition of the present invention, the compounding amounts of the hole injection material and the electron injection material are each usually 1 to 400 parts by weight, preferably 5 to 150 parts by weight with respect to 100 parts by weight of the metal complex of the present invention.

The hole injection material and the electron injection material may each be used singly or two or more of them may be used in combination.

[Ion dope]

When the hole injection material or the electron injection material comprises an electrically conductive polymer, the electric conductivity of the electrically conductive polymer is preferably $1 \times 10^{-5}$ S/cm to $1 \times 10^{3}$ S/cm. For adjusting the electric conductivity of the electrically conductive polymer within such a range, the electrically conductive polymer can be doped with a suitable amount of ions.

The kind of the ion to be doped is an anion for a hole injection material and a cation for an electron injection material. The anion includes, for example, a polystyrenesulfonate ion, an alkylbenzenesulfonate ion and a camphorsulfonate ion. The cation includes, for example, a lithium ion, a sodium ion, a potassium ion and a tetrabutylammonium ion.

The ion to be doped may be used singly or two or more ions to be doped may be used.

[Light emitting material]

The light emitting material (the light emitting material is different form the metal complex of the present invention) is classified into low molecular weight compounds and polymer compounds. The light emitting material optionally has a crosslinkable group.

The low molecular weight compound includes, for example, naphthalene and derivatives thereof, anthracene and derivatives thereof, perylene and derivatives thereof, and, triplet light emitting complexes having iridium, platinum or europium as the central metal.

The polymer compound includes, for example, polymer compounds comprising a phenylene group, a naphthalenediyl group, a fluorenediyl group, a phenanthrenediyl group, dihydrophenanthrenediyl group, a group represented by the formula (X), a carbazolediyl group, a phenoxazinediyl group, a phenothiazinediyl group, an anthracenediyl group, a pyrenediyl group and the like.

The light emitting material preferably comprises a triplet light emitting complex and a polymer compound.

The triplet light emitting complex includes, for example, metal complexes listed below.

[Chemical Formula 101]

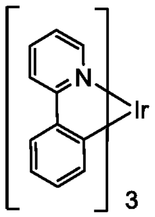
$Ir(ppy)_3$

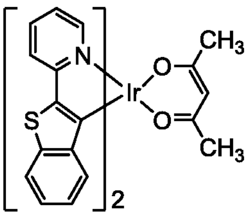
$Btp_2Ir(acac)$

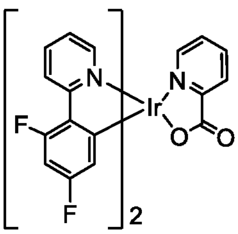
FIrpic

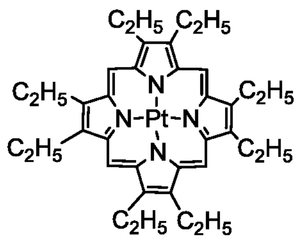
PtOEP

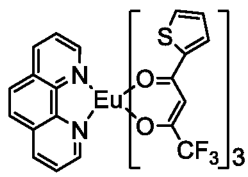
$Eu(TTA)_3phen$

[Chemical Formula 102]

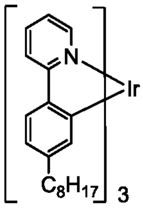
COM-1

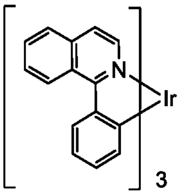
COM-2

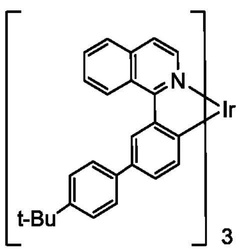
COM-3

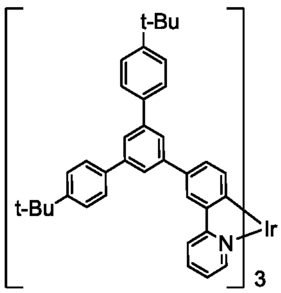
COM-4

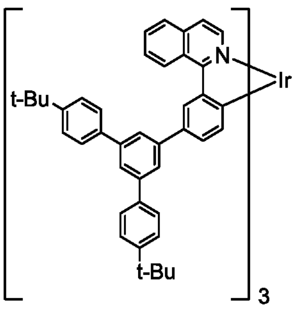
COM-5

[Chemical Formula 103]

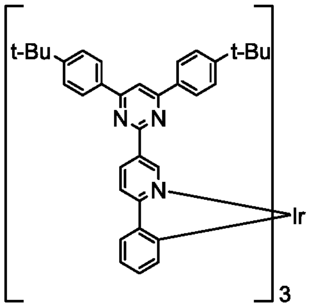

COM-6

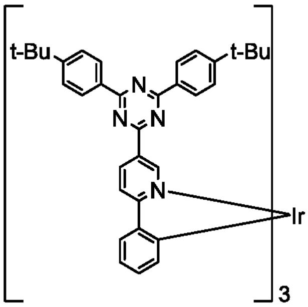

COM-7

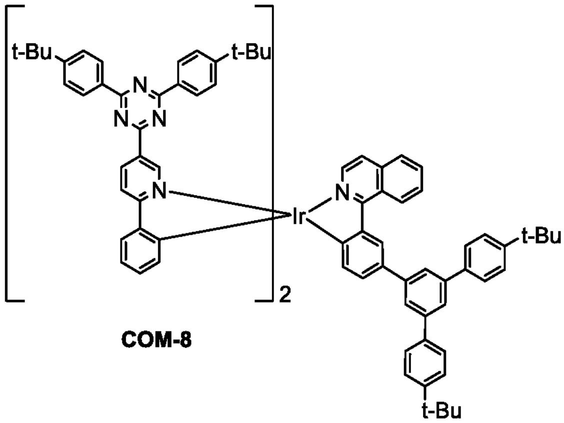

COM-8

[Chemical Formula 104]

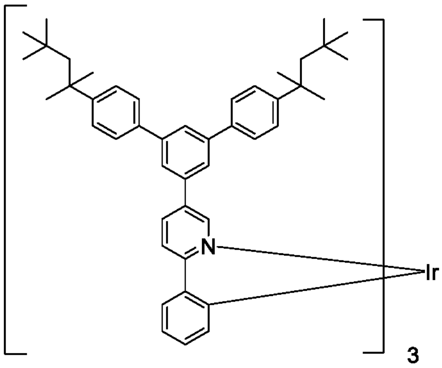

COM-9

In the composition of the present invention, the compounding amount of the light emitting material is usually 0.1 to 400 parts by weight with respect to 100 parts by weight of the metal complex of the present invention.

[Antioxidant]

The antioxidant may advantageously be one which is soluble in the same solvent as for the metal complex of the present invention and does not disturb light emission and charge transportation, and the examples thereof include phenol antioxidants and phosphorus-based antioxidants.

In the composition of the present invention, the compounding amount of the antioxidant is usually 0.001 to 10 parts by weight with respect to 100 parts by weight of the metal complex of the present invention.

The antioxidant may be used singly or two or more antioxidants may be used in combination.

<Film>

The film comprises the metal complex of the present inve ntion.

The film also includes an insolubilized film produced by insolubilizing the metal complex of the present invention in a solvent by crosslinking. The insolubilized film is a film produced by crosslinking the metal complex of the present invention by an external stimulus such as heating and light irradiation. The insolubilized film can be suitably used for lamination of a light emitting device because the insolubilized film is substantially insoluble in a solvent.

The heating temperature for crosslinking the film is usually 25 to 300°C, and because the external quantum efficiency is improved, preferably 50 to 250°C, more preferably 150 to 200°C.

The kind of light used in light irradiation for crosslinking the film includes, for example, ultraviolet light, near-ultraviolet light and visible light.

The film is suitable as a light emitting layer in a light emitting device.

The film can be fabricated, for example, by a spin coating method, a casting method, a micro gravure coating method, a gravure coating method, a bar coating method, a roll coating method, a wire bar coating method, a dip coating

method, a spray coating method, a screen printing method, a flexo printing method, an offset printing method, an inkjet printing method, a capillary coating method or a nozzle coating method, using the ink.
The thickness of the film is usually 1 nm to 10 $\mu$m.

<Light emitting device>

The light emitting device of the present invention is a light emitting device obtained by using the metal complex of the present invention. The light emitting device is, for example, a light emitting device containing the metal complex of the present invention or a light emitting device obtained by crosslinking the metal complex of the present invention intramolecularly, intermolecularly or in both modes when the metal complex of the present invention has a crosslinkable group, and, for example, a light emitting device containing the metal complex of the present invention when the metal complex of the present invention has no crosslinkable group.
The constitution of the light emitting device of the present invention has, for example, electrodes consisting of an anode and a cathode, and a layer obtained by using the metal complex of the present invention disposed between the electrodes.

[Layer constitution]

The layer produced by using the metal complex of the present invention is usually at least one selected from a light emitting layer, a hole transporting layer, a hole injection layer, an electron transporting layer and an electron injection layer, preferably a light emitting layer. These layers comprise a light emitting material, a hole transporting material, a hole injection material, an electron transporting material and an electron injection material, respectively. These layers can be formed by the same method as the above-described film fabrication using inks prepared by dissolving a light emitting material, a hole transporting material, a hole injection material, an electron transporting material and an electron injection material, respectively, in the solvent described above.
The light emitting device comprises a light emitting layer between an anode and a cathode. The light emitting device of the present invention preferably comprises at least one of a hole injection layer and a hole transporting layer between an anode and a light emitting layer from the standpoint of hole injectability and hole transportability, and preferably comprises at least one of an electron injection layer and an electron transporting layer between a cathode and a light emitting layer from the standpoint of electron injectability and electron transportability.
The material of a hole transporting layer, an electron transporting layer, a light emitting layer, a hole injection layer and an electron injection layer includes the above-described hole transporting materials, electron transporting materials, light emitting materials, hole injection materials and electron injection materials, respectively, in addition to the metal complex of the present invention.
When the material of a hole transporting layer, the material of an electron transporting layer and the material of a light emitting layer are soluble in a solvent which is used in forming a layer adjacent to the hole transporting layer, the electron transporting layer and the light emitting layer, respectively, in fabrication of a light emitting device, it is preferable that the materials have a crosslinkable group to avoid dissolution of the materials in the solvent. After forming the layers using the materials having a crosslinkable group, the layers can be insolubilized by crosslinking the crosslinkable group.
Methods of forming respective layers such as a light emitting layer, a hole transporting layer, an electron transporting layer, a hole injection layer and an electron injection layer in the light emitting device of the present invention include, for example, a method of vacuum vapor deposition from a powder and a method of film formation from solution or melted state when a low molecular weight compound is used, and, for example, a method of film formation from solution or melted state when a polymer compound is used.
The order and the number of layers to be laminated and the thickness of each layer may be controlled in view of external quantum efficiency and luminance life.

[Substrate/electrode]

The substrate in the light emitting device may advantageously be a substrate on which an electrode can be formed and which does not chemically change in forming an organic layer, and is a substrate made of a material such as, for example, glass, plastic and silicon. In the case of an opaque substrate, it is preferable that an electrode most remote from the substrate is transparent or semi-transparent.
The material of the anode includes, for example, electrically conductive metal oxides and semi-transparent metals, preferably, indium oxide, zinc oxide and tin oxide; electrically conductive compounds such as indium·tin·oxide (ITO) and indium·zinc·oxide; a composite of silver, palladium and copper (APC); NESA, gold, platinum, silver and copper.
The material of the cathode includes, for example, metals such as lithium, sodium, potassium, rubidium, cesium,

beryllium, magnesium, calcium, strontium, barium, aluminum, zinc and indium; alloys composed of two or more of them; alloys composed of one or more of them and at least one of silver, copper, manganese, titanium, cobalt, nickel, tungsten and tin; and graphite and graphite intercalation compounds. The alloy includes, for example, a magnesium-silver alloy, a magnesium-indium alloy, a magnesium-aluminum alloy, an indium-silver alloy, a lithium-aluminum alloy, a lithium-magnesium alloy, a lithium-indium alloy and a calcium-aluminum alloy.

The anode and the cathode may each take a lamination structure composed of two or more layers.

[Use]

For producing planar light emission by using a light emitting device, a planar anode and a planar cathode are disposed so as to overlap with each other. Patterned light emission can be produced by a method of placing a mask with a patterned window on the surface of a planer light emitting device, a method of forming extremely thick a layer intended to be a non-light emitting, thereby having the layer essentially no-light emitting or a method of forming an anode, a cathode or both electrodes in a patterned shape. By forming a pattern with any of these methods and disposing certain electrodes so as to switch ON/OFF independently, a segment type display capable of displaying numbers and letters and the like is provided. For producing a dot matrix display, both an anode and a cathode are formed in a stripe shape and disposed so as to cross with each other. Partial color display and multi-color display are made possible by a method of printing separately certain polymer compounds showing different emission or a method of using a color filter or a fluorescence conversion filter. The dot matrix display can be passively driven, or actively driven combined with TFT and the like. These displays can be used in computers, television sets, portable terminals and the like. The planar light emitting device can be suitably used as a planer light source for backlight of a liquid crystal display or as a planar light source for illumination. If a flexible substrate is used, it can be used also as a curved light source and a curved display.

EXAMPLES

The present invention will be illustrated further in detail by examples below, but the present invention is not limited to these examples. Examples falling outside the scope of the claims are included for reference purposes.

In the examples, the polystyrene-equivalent number average molecular weight (Mn) and the polystyrene-equivalent weight average molecular weight (Mw) of a polymer compound were measured by size exclusion chromatography (SEC) (manufactured by Shimadzu Corp., trade name: LC-10Avp). SEC measurement conditions are as described below.

[Measurement condition]

The polymer compound to be measured was dissolved in THF at a concentration of about 0.05 wt%, and 10 μL of the solution was injected into SEC. As the mobile phase of SEC, THF was used and allowed to flow at a flow rate of 2.0 mL/min. As the column, PLgel MIXED-B (manufactured by Polymer Laboratories) was used. As the detector, UV-VIS detector (manufactured by Shimadzu Corp., trade name: SPD-10Avp) was used.

Measurement of liquid chromatograph mass spectrometry (LC-MS) was carried out according to the following method.

A measurement sample was dissolved in chloroform or THF so as to give a concentration of about 2 mg/mL, and about 1 μL of the solution was injected into LC-MS (manufactured by Agilent Technologies, trade name: 1100LCMSD). As the mobile phase of LC-MS, acetonitrile and THF were used while changing the ratio thereof and allowed to flow at a flow rate of 0.2 mL/min. As the column, L-column 2 ODS (3 μm) (manufactured by Chemicals Evaluation and Research Institute, internal diameter: 2.1 mm, length: 100 mm, particle size: 3 μm) was used.

Measurement of NMR was carried out according to the following method.

5 to 10 mg of a measurement sample was dissolved in about 0.5 mL of deuterated chloroform ($CDCl_3$-$d_1$), deuterated dichloromethane ($CD_2Cl_2$-$d_2$), deuterated tetrahydrofuran (THF-$d_8$) or deuterated acetone ($(CD_3)_2CO$-$d_6$), and measurement was performed using an NMR apparatus (manufactured by Agilent, Inc., trade name: INOVA 300 or MERCURY 300).

As the index of the purity of a compound, a value of the high performance liquid chromatography (HPLC) area percentage was used. This value is a value in HPLC (manufactured by Shimadzu Corp., trade name: LC-20A) at 254 nm, unless otherwise stated. In this operation, the compound to be measured was dissolved in THF or chloroform so as to give a concentration of 0.01 to 0.2 wt%, and depending on the concentration, 1 to 10 μL of the solution was injected into HPLC. As the mobile phase of HPLC, acetonitrile and THF were used and allowed to flow at a flow rate of 1 mL/min as gradient analysis of acetonitrile/THF = 100/0 to 0/100 (volume ratio). As the column, Kaseisorb LC ODS 2000 (manufactured by Tokyo Chemical Industry Co., Ltd.) or an ODS column having an equivalent performance was used. As the detector, a photo diode array detector (manufactured by Shimadzu Corp., trade name: SPD-M20A) was used.

TLC-MS measurement was performed by the following method.

A measurement sample was dissolved in toluene, tetrahydrofuran or chloroform, the solution was applied on a TLC plate for DART (manufactured by Techno Applications, YSK5-100), and measurement was performed using TLC-MS (manufactured by JEOL Ltd., trade name: JMS-T100TD (The AccuTOF TLC)). The temperature of a helium gas in measurement was controlled in a range of 200 to 400°C.

<Evaluation of light emission stability>

[Apparatus for evaluating light emission stability]

In an apparatus for evaluating light emission stability, a measurement sample described later was irradiated with excitation light from the glass substrate side, thereby causing light emission of an organic layer contained in the measurement sample. As the excitation light source, Lightningcure LC-L1V3 (wavelength: 365 nm) manufactured by Hamamatsu Photonics K.K. was used. For measurement of light emission from the measurement sample, BM-9 manufactured by TOPCON Corporation as the light emission luminance measurement apparatus was used. At a photometric incident entrance of the light emission luminance measurement apparatus, a short wavelength-impermeable filter was installed, thereby blocking measurement of light having a wavelength of 400 nm or less.

[Regulation of excitation light intensity of excitation light source]

In evaluation of light emission stability, the excitation light intensity of an excitation light source was regulated in such a manner that the numbers of photons of light emission from respective measurement samples described later were the same.

The formula (11), the formula (12), the formula (13-1), the formula (13-2), the formula (14), the formula (15), the formula (16) and the formula (17) were used, for calculating conditions under which the numbers of photons of light emission from respective measurement samples were the same.

Firstly, the number of photons of light emission from a measurement sample was calculated by the formula (11). $Int_{PL}$ (λ) indicating the light emission spectrum intensity was measured by FP-6500 manufactured by JASCO Corporation using a sample obtained by forming an organic layer contained in a measurement sample described later on a quartz substrate.

$$N_{PL} = \sum_{\lambda} \frac{Int_{PL}(\lambda) \times \lambda}{1240 \times 1.6 \times 10^{-19}}$$

Formula (11)

[wherein,

$N_{PL}$ represents the number of photons of light emission.
λ represents wavelength [nm].
$Int_{PL}(\lambda)$ represents light emission spectrum intensity [W].]

Secondly, $N_{PL}$ indicating the number of photons of light emission calculated by the formula (11) was rewritten to the formula (12).

$$N_{PL} = \kappa_{\text{int}} \times n_{nrm-PL}$$

Formula (12)

[wherein,

$N_{PL}$ represents the same meaning as described above.
$K_{int}$ represents proportionality factor.
$n_{nrm-PL}$ represents standardized photon number.)]

$n_{nrm-PL}$ indicating standardized photon number in the formula (12) was calculated by the formula (13-1).

$$n_{nrm-PL} = \sum_{\lambda} \frac{Int_{nrm-PL}(\lambda) \times \lambda}{1240 \times 1.6 \times 10^{-19}}$$

Formula (13-1)

[wherein,

$\lambda$ and $n_{nrm\text{-}PL}$ represent the same meaning as described above .
$Int_{nrm\text{-}PL}(\lambda)$ represents standardized emission spectrum.]

$Int_{nrm\text{-}PL}(\lambda)$ indicating standardized emission spectrum in the formula (13-1) was calculated by the formula (13-2).

$$Int_{nrm-PL}(\lambda) = Int_{PL}(\lambda) / \max\left(Int_{PL}(\lambda)\right)$$

Formula (13-2)

[wherein, $\lambda$, $Int_{nrm\text{-}PL}(\lambda)$ and $Int_{PL}(\lambda)$ represent the same meaning as described above.)

Thirdly, standardized luminance was calculated from the formula (14) using $Int_{nrm\text{-}PL}(\lambda)$ indicating standardized emission spectrum.

$$l_{nrm} = \sum_{\lambda} \left(Int_{nrm-PL}(\lambda) \cdot Lf(\lambda)\right)$$

Formula (14)

[wherein,

$\lambda$ and $Int_{nrm\text{-}PL}(\lambda)$ represent the same meaning as described above.]
$l_{nrm}$ represents standardized luminance.
$Lf(\lambda)$ represents luminosity spectrum.]

Fourthly, light emission luminance was calculated from the formula (15) using $l_{nrm}$ indicating standardized luminance.

$$L_{PL} = \sum_{\lambda} \left(Int_{PL}(\lambda) \times Lf(\lambda)\right) = \kappa_{\mathrm{int}} \times \sum_{\lambda} \left(Int_{nrm-PL}(\lambda) \times Lf(\lambda)\right) = \kappa_{\mathrm{int}} \times l_{nrm}$$

Formula (15)

[wherein,

$L_{PL}$ represents light emission luminance [cd/m$^2$] .
$\lambda$, $Int_{PL}(\lambda)$, $Lf(\lambda)$, $K_{int}$, $Int_{nrm\text{-}PL}(\lambda)$ and $l_{nrm}$ represent the same meaning as described above.]

Fifthly, conditions under which the numbers of photons of light emission were the same were calculated from the formula (16) using the formula (12) and the formula (15). By using this formula (16), light emission luminances of measurement samples satisfying conditions under which the numbers of photons of light emission from measurement samples are the same can be calculated.

$$N_{PL} = \kappa_{\mathrm{int}} \times n_{nrm-PL} = \mathrm{constant}$$

Conditions for constant photon number of light emission [wherein, $N_{PL}$, $K_{int}$ and $n_{nrm-PL}$ represent the same meaning as described above.)

$$L_{eqv}[cd/m^2] = \mathrm{constant} \times \frac{l_{nrm}}{n_{nrm-PL}} = \kappa_{\mathrm{int}} \times l_{nrm}$$

Formula (16)

[wherein,

$L_{eqv}$ represents light emission luminance [cd/m$^2$].
$l_{nrm}$, $n_{nrm-PL}$ and $K_{int}$ represent the same meaning as described above.]

For example, when a sample A is allowed to emit light at luminance $L^A$, the light emission luminance of a sample B at which the photon number of light emission is the same as that of a sample A can be calculated from the formula (17) using the standardized photon numbers and the standardized luminances of a sample A and a sample B

$$L^B[cd/m^2] = \mathrm{L}^{\mathrm{A}} \times \frac{n^A_{nrm-PL}}{l^A_{nrm}} \times \frac{l^B_{nrm}}{n^B_{nrm-PL}}$$

Formula (17)

[wherein,

$L^A$ represents the light emission luminance [cd/m$^2$] of a sample A.
$L^B$ represents the light emission luminance [cd/m$^2$] of a sample B.
$n^A_{nrm-PL}$ represents the standardized photon number of a sample A.
$n^B_{nrm-PL}$ represents the standardized photon number of a sample B.
$l^A_{nrm}$ represents the standardized luminance of a sample A.
$l^B_{nrm}$ represents the standardized luminance of a sample B.]

<Comparative Example 1> Synthesis of metal complex MM1

[Chemical Formula 105]

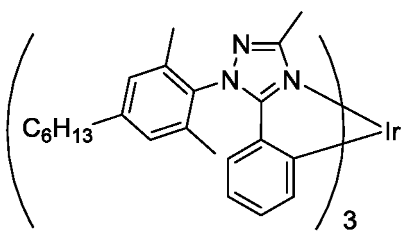

MM1

The metal complex MM1 was synthesized according to a method described in US Patent Application Publication No. 2014/0151659.

<Comparative Example 2> Synthesis of metal complex MM2

[Chemical Formula 106]

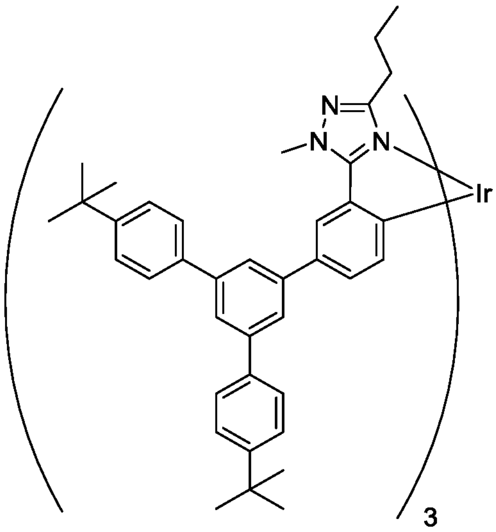

MM2

The metal complex MM2 was synthesized according to a method described in JP-A No. 2013-147551.

<Comparative Example 3> Synthesis of metal complex MM3

[Chemical Formula 107]

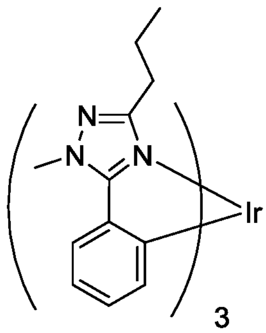

MM3

The metal complex MM3 was synthesized according to a method described in JP-A No. 2013-147551.

<Example 1> Synthesis of metal complex MC1

[Chemical Formula 108]

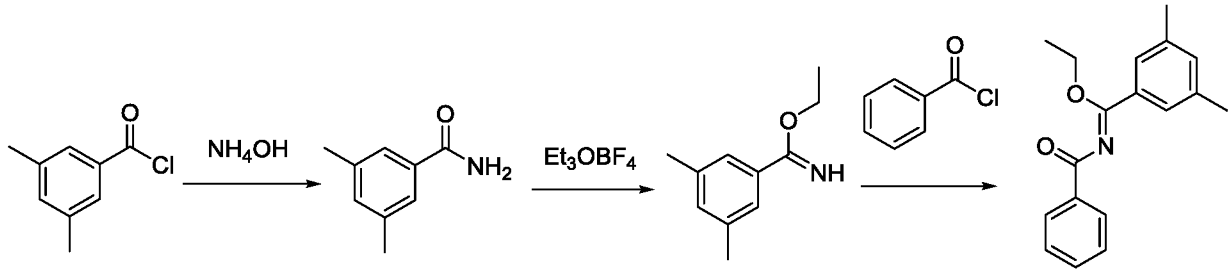


MC1-a MC1-b MC1-c MC1-d

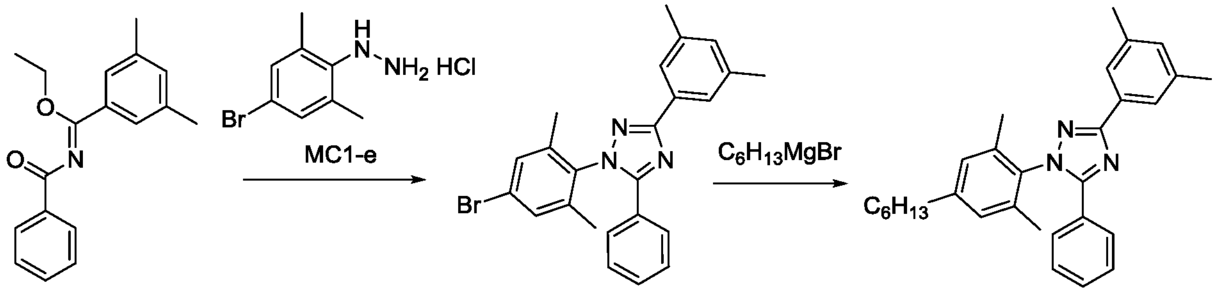


MC1-d MC1-f MC1-g

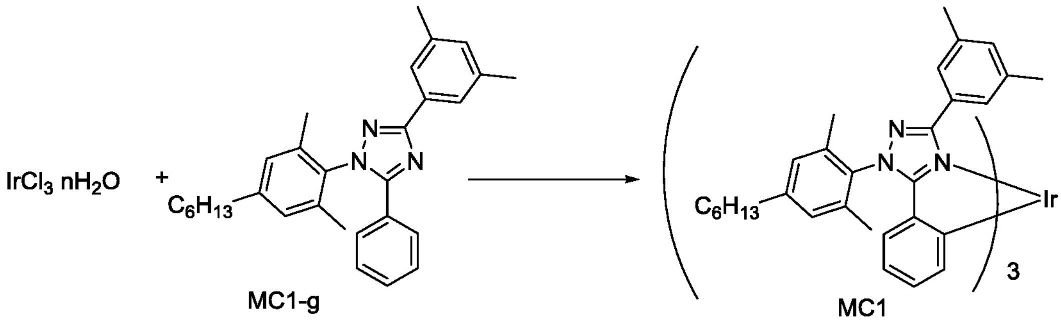


MC1-g MC1

An argon gas atmosphere was prepared in a reaction vessel, then, a compound MC1-a (33.7 g) and dichloromethane (400 mL) were added, and the reaction vessel was placed in an ice bath and cooled. Thereafter, to this was added a 25 wt% ammonia aqueous solution (40.8 g), and the mixture was stirred for 1 hour while cooling the reaction vessel in an ice bath. Thereafter, to this were added ion exchanged water (200 mL) and dichloromethane (150 mL), and the organic layer was extracted. The resultant organic layer was dried over anhydrous magnesium sulfate, then, heptane (400 mL) was added, and dichloromethane was concentrated under reduced pressure, thereby obtaining a solution containing a white solid. The resultant solution containing a white solid was filtered, then, the resultant white solid was dried under reduced pressure,thereby obtaining compound MC1-b (27.8 g, yield: 93%) as a white solid. The compound MC1-b showed a HPLC area percentage value of 99.3%. This operation was conducted repeatedly, thereby obtaining a necessary amount of the compound MC1-b.

TLC/MS (DART, positive): m/z = 150 $[M+H]^+$

An argon gas atmosphere was prepared in a reaction vessel, then, the compound MC1-b (34.3 g) and dichloromethane (1.38 L) were added. Thereafter, to this was added a dichloromethane solution of triethyloxonium tetrafluoroborate (1 mol/L, 276 mL), and the mixture was stirred for 34 hours at room temperature. Thereafter, to this was added a sodium hydrogen carbonate aqueous solution (1 mol/L, 352 mL), and the mixture was stirred for 30 minutes at room temperature. The organic layer of the resultant reaction solution was extracted, then, the resultant organic layer was washed with saturated saline (300 mL), thereby obtaining an organic layer. To the resultant organic layer was added heptane (200 mL), then, dichloromethane was concentrated under reduced pressure, thereby obtaining a solution containing a white solid. The resultant solution containing a white solid was filtered, then, the resultant filtrate was concentrated, thereby obtaining a compound MC1-c (33.6 g, yield: 82%) as a yellow oil. The compound MC1-c showed a HPLC area percentage value of 98.0%.

TLC/MS (DART, positive): m/z = 178 $[M+H]^+$

An argon gas atmosphere was prepared in a reaction vessel, then, the compound MC1-c (33.5 g), benzoyl chloride (26.6 g) and chloroform (570 mL) were added, then, triethylamine (26.4 mL) was added, and the mixture was

stirred for 66 hours at room temperature. The resultant reaction solution was concentrated under reduced pressure, to the resultant residue were added ion exchanged water (210 mL) and chloroform (210 mL), and the organic layer was extracted. The resultant organic layer was washed with saturated saline (150 mL), dried over anhydrous magnesium sulfate, then, concentrated under reduced pressure, thereby obtaining a compound MC1-d (54.2 g, yield: 88%) as an orange oil. The compound MC1-d showed a HPLC area percentage value of 86.0%.
TLC/MS (DART, positive): m/z = 282 $[M+H]^+$
$^1$H-NMR (300 MHz, $CDCl_3$-$d_1$) : $\delta$ (ppm) = 8.01-7.98 (m, 2H), 7.56-7.51 (m, 1H), 7.46-7.41 (m, 2H), 7.19 (s, 2H), 7.03 (s, 1H), 4.48-4.41 (m, 2H), 2.23 (s, 6H), 1.48 (t, 3H) .

An argon gas atmosphere was prepared in a reaction vessel, then, a compound MC1-e (55.8 g) and toluene (925 mL) were added, and the reaction vessel was placed in an ice bath and cooled. Thereafter, to this was added a sodium hydroxide aqueous solution (1 mol/L, 222 mL), and the mixture was stirred for 30 minutes while cooling the reaction vessel in an ice bath. The organic layer of the resultant reaction solution was extracted, thereby obtaining a toluene solution as an organic layer.

An argon gas atmosphere was prepared in a reaction vessel separately prepared, then, the compound MC1-d (52.0 g) and chloroform (925 mL) were added, and the reaction vessel was placed in an ice bath and cooled. Thereafter, to this was added the toluene solution obtained above. Thereafter, the mixture was stirred for 7 hours while cooling the reaction vessel in an ice bath, then, stirred at room temperature for 100 hours. To the resultant reaction solution was added ion exchanged water (500 mL), the organic layer was extracted, and the resultant organic layer was concentrated under reduced pressure. The resultant residue was purified by silica gel column chromatography (a mixed solvent of chloroform and hexane), then, recrystallization was performed using a mixed solvent of chloroform and heptane. Thereafter, the crystal was dried under reduced pressure at 50°C, thereby obtaining a compound MC1-f (17.6 g, yield: 22%) as a white solid. The compound MC1-f showed a HPLC area percentage value of 99.5% or more. This operation was conducted repeatedly, thereby obtaining a necessary amount of the compound MC1-f.
TLC/MS (DART, positive): m/z = 432 $[M+H]^+$
$^1$H-NMR (300 MHz, $CD_2Cl_2$-$d_2$) : $\delta$ (ppm) = 7.84 (s, 2H), 7.56-7.54 (m, 2H), 7.43-7.32 (m, 5H), 7.09 (s, 1H), 2.40 (s, 6H), 1.99 (s, 6H).

An argon gas atmosphere was prepared in a reaction vessel, then, the compound MC1-f (17.3 g), cyclopentyl methyl ether (240 mL) and [1,1'-bis(diphenylphosphino)ferrocene]palladium(II) dichloride (98 mg) were added, and the mixture was heated up to 50°C. Thereafter, to this was added a diethyl ether solution of hexylmagnesium bromide (2 mol/L, 40 mL), then, the mixture was stirred at 50°C for 2 hours. Thereafter, to this was added a hydrochloric acid aqueous solution (1 mol/L, 80 mL), and the organic layer was extracted. The resultant organic layer was washed with ion exchanged water (100 mL) twice, dried over anhydrous magnesium sulfate, then, filtered, and the resultant filtrate was concentrated under reduced pressure, thereby obtaining an oil. To the resultant oil were added toluene and activated carbon, and the mixture was stirred at 50°C for 30 minutes. Thereafter, the mixture was filtered through a filter paved with silica gel and celite, and the resultant filtrate was concentrated under reduced pressure, thereby obtaining a solid. The resultant solid was purified by silica gel column chromatography (a mixed solvent of hexane and ethyl acetate), then, recrystallization was performed using methanol. Thereafter, the crystal was dried under reduced pressure at 50°C, thereby obtaining a compound MC1-g (12.1 g, yield: 69%) as a white solid. The compound MC1-g showed a HPLC area percentage value of 99.5% or more.
TLC/MS (DART, positive): m/z = 438 $[M+H]^+$
$^1$H-NMR (300 MHz, $CD_2Cl_2$-$d_2$) $\delta$ (ppm) = 7.92 (s, 2H), 7.65-7.62 (m, 2H), 7.48-7.35 (m, 3H), 7.15 (s, 1H), 7.09 (s, 2H), 2.70 (t, 2H), 2.46 (s, 6H), 2.03 (s, 6H), 1.77-1.67 (m, 2H), 1.46-1.36 (m, 6H), 1.00-0.95 (m, 3H).

<1-6> Synthesis of metal complex MC1

An argon gas atmosphere was prepared in a reaction vessel, then, iridium chloride n-hydrate (2.50 g), the compound MC1-g (6.43 g), ion exchanged water (28 mL) and 2-ethoxyethanol (112 mL) were added, and the mixture was stirred for 25 hours under reflux with heating. Thereafter, to this was added toluene, and the mixture was washed with ion exchanged water. The organic layer of the resultant washing liquid was extracted, and the resultant organic layer was concentrated under reduced pressure, thereby obtaining a solid. The resultant solid was purified by silica gel column chromatography (a mixed solvent of toluene and methanol), threby obtaining a solid (4.82 g).

An argon gas atmosphere was prepared in a reaction vessel separately prepared, then, the solid obtained above (4.81 g), silver trifluoromethanesulfonate (1.43 g), the compound MC1-g (4.81 g) and tridecane (1.1 mL) were added, and the mixture was stirred with heating at 150°C for 15 hours. Thereafter, to this was added toluene, the mixture was filtered through a filter paved with silica gel and celite, and the resultant filtrate was washed with ion exchanged water, thereby obtaining an organic layer. The resultant organic layer was concentrated under reduced pressure, thereby obtaining a solid. The resultant solid was purified by silica gel column chromatography (a mixed solvent of hexane and toluene), then, recrystallization was performed using a mixed solvent of ethyl acetate and ethanol. Thereafter, the crystal

was dried under reduced pressure at 50°C, thereby obtaining a metal complex MC1 (2.32 g, yield: 35%) as a yellow solid. The metal complex MC1 showed a HPLC area percentage value of 99.5% or more.
LC-MS (APCI, positive): m/z = 1502.8 $[M+H]^+$
$^1$H-NMR (300 MHz, $CD_2Cl_2$-$d_2$) $\delta$ (ppm) = 7.96 (s, 6H), 7.07 (s, 6H), 6.91 (s, 3H), 6.60 (t, 3H), 6.51 (t, 3H), 6.41 (d, 3H), 6.29 (d, 3H), 2.70 (t, 6H), 2.09 (s, 18H), 1.85 (s, 9H), 1.76-1.67 (m, 6H), 1.60 (s, 9H), 1.44-1.35 (m, 18H), 1.00-0.95 (m, 9H).

<Example 2> Synthesis of metal complex MC2

[Chemical Formula 109]

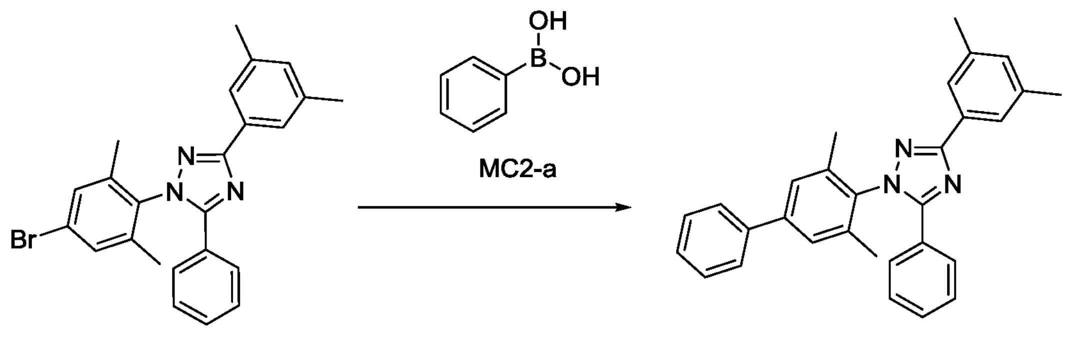

MC1-f MC2-a MC2-b

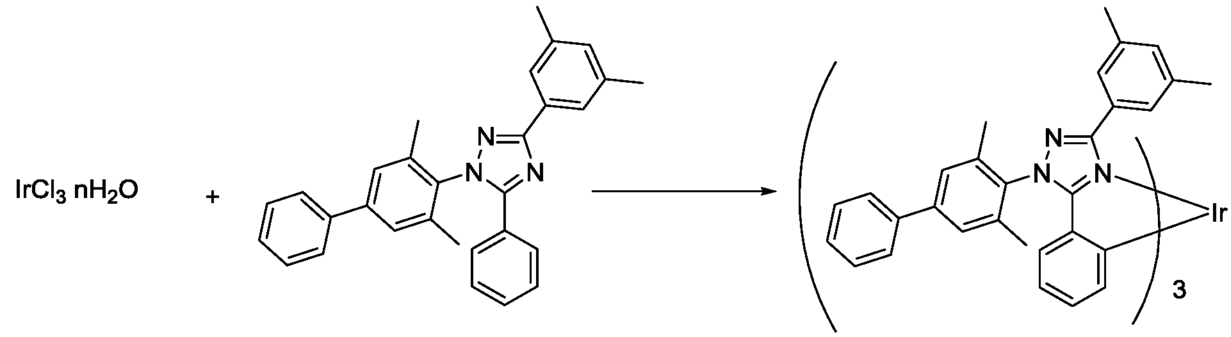


MC2-b MC2

An argon gas atmosphere was prepared in a reaction vessel, then, a compound MC1-f (2.00 g), a compound MC2-a (0.62 g), bis[tri(2-methoxyphenyl)phosphine]palladium(II) dichloride (41.0 mg), toluene (20.0 g) and a 20 wt% tetraethylammonium hydroxide aqueous solution (8.17 g) were added, and the mixture was stirred for 4 hours under reflux with heating. Thereafter, to this was added toluene, and the organic layer was extracted. The resultant organic layer was washed with ion exchanged water, thereby obtaining an organic layer. The resultant organic layer was dried over anhydrous sodium sulfate, then, filtered, and the resultant filtrate was concentrated under reduced pressure, thereby obtaining a solid. The resultant solid was purified by silica gel column chromatography (a mixed solvent of hexane and chloroform), then, recrystallization was performed using heptane. Thereafter, the crystal was dried under reduced pressure at 50°C, thereby obtaining a compound MC2-b (1.29 g, yield: 66%) as a white solid. The compound MC2-b showed a HPLC area percentage value of 99.5% or more. This operation was conducted repeatedly, thereby obtaining a necessary amount of the compound MC2-b.
$^1$H-NMR (300 MHz, $CD_2Cl_2$-$d_2$) $\delta$ (ppm) = 7.93 (s, 2H), 7.75-7.68 (m, 4H), 7.58-7.52 (m, 4H), 7.50-7.38 (m, 4H), 7.16 (s, 1H), 2.47 (s, 6H), 2.14 (s, 6H).

An argon gas atmosphere was prepared in a reaction vessel, then, iridium chloride n-hydrate (0.27 g), the compound MC2-b (0.68 g), ion exchanged water (5.35 g), 2-ethoxyethanol (16.0 g) and 1,4-dioxane (8.00 g) were added, and the mixture was stirred for 28 hours under reflux with heating. Thereafter, to this was added ethyl acetate, and the mixture was washed with ion exchanged water, thereby obtaining an organic layer. The resultant organic layer was concentrated under reduced pressure, thereby obtaining a solid (0.81 g).

An argon gas atmosphere was prepared in a reaction vessel separately prepared, then, the solid obtained above (0.81 g), silver trifluoromethanesulfonate (0.29 g), the compound MC2-b (0.645), diglyme (0.81 g) and 2,6-lutidine

(0.20 g) were added, and the mixture was stirred for 22 hours with heating at 150°C. Thereafter, to this was added toluene, the mixture was filtered through a filter paved with silica gel and celite, and the resultant filtrate was washed with ion exchanged water, thereby obtaining an organic layer. The resultant organic layer was concentrated under reduced pressure, thereby obtaining a solid. The resultant solid was purified by silica gel column chromatography (a mixed solvent of hexane and toluene), then, recrystallization was performed using a mixed solvent of toluene and heptane. Thereafter, the crystal was dried under reduced pressure at 50°C, thereby obtaining a metal complex MC2 (0.17 g, yield: 16%) as a yellow solid. The metal complex MC2 showed a HPLC area percentage value of 99.5% or more.
LC-MS (APCI, positive): m/z = 1478.6 $[M+H]^+$
$^1$H-NMR (300 MHz, $CD_2Cl_2$-$d_2$) $\delta$ (ppm) = 8.02 (s, 6H), 7.75 (d, 6H), 6.66-6.44 (m, 15H), 6.97 (s, 3H), 6.68-6.44 (m, 12H), 2.14 (s, 18H), 1.98 (s, 9H), 1.74 (s, 9H).

<Example 3> Synthesis of metal complex MC3

[Chemical Formula 110]

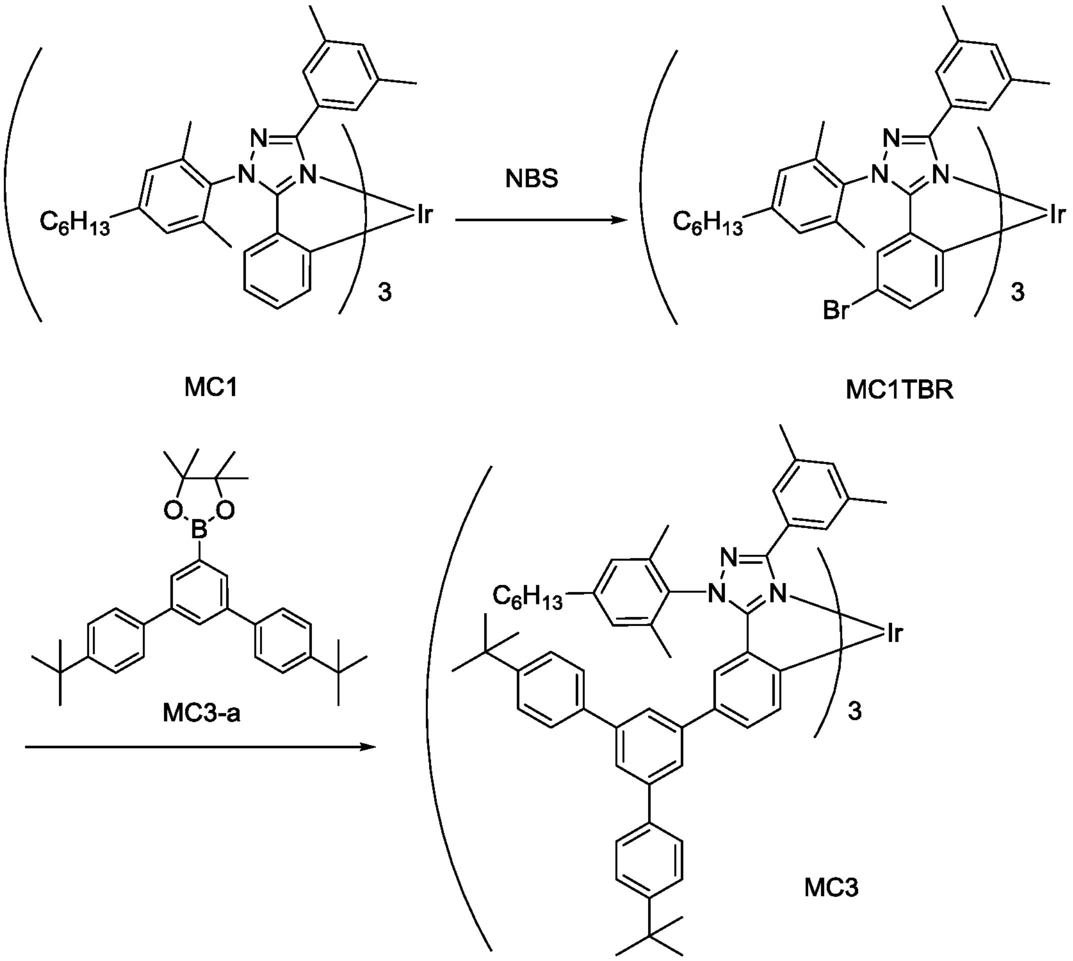


An argon gas atmosphere was prepared in a reaction vessel, then, the metal complex MC1 (0.50 g), dichloromethane (25 mL) and N-bromosuccinimide (203 mg) were added, and the mixture was stirred at room temperature for 27.5 hours. Thereafter, to this was added a 10 wt% sodium sulfite aqueous solution (4.20 g), then, ion exchanged water (8.40 mL) was added, and the mixture was stirred at room temperature for 30 minutes. The organic layer was extracted from the resultant reaction solution, and the resultant organic layer was filtered through a filter paved with silica gel. Methanol was added to the resultant filtrate, thereby causing deposition of a precipitate. The resultant precipitate was filtered, then, dried in vacuum at 50°C, thereby obtaining a metal complex MC1TBR (0.55 g, yield: 95%) as a yellow solid. The metal complex MC1TBR showed a HPLC area percentage value of 99.5% or more.
LC-MS (APCI, positive): m/z = 1736.5 $[M+H]^+$

$^1$H-NMR (300 MHz, $CD_2Cl_2$-$d_2$) δ (ppm) = 7.94 (s, 6H), 7.71 (d, 6H), 6.94 (s, 3H), 6.73-6.70 (m, 3H), 6.29 (d, 3H), 6.25 (d, 3H), 2.72 (t, 6H), 2.10 (s, 18H), 1.84 (s, 9H), 1.77-1.67 (m, 6H), 1.57 (s, 9H), 1.45-1.34 (m, 18H), 0.99-0.94 (m, 9H).

An argon gas atmosphere was prepared in a reaction vessel, then, the metal complex MC1TBR (0.50 g), a compound MC3-a (0.44 g), toluene (30 mL), tris(dibenzylideneacetone)dipalladium(0) (7.9 mg) and 2-dicyclohexylphosphino-2',6'-dimethoxybiphenyl (8.5 mg) were added, and the mixture was heated up to 80°C. Thereafter, to this was added a 20 wt% tetraethylammonium hydroxide aqueous solution (4.2 mL), and the mixture was stirred for 6 hours under reflux with heating. Thereafter, to this was added toluene, and the organic layer was extracted. The resultant organic layer was washed with ion exchanged water, dried over anhydrous magnesium sulfate, then, the mixture was filtered through a filter paved with silica gel and celite, and the resultant filtrate was concentrated under reduced pressure, thereby obtaining a solid. The resultant solid was purified by silica gel column chromatography (a mixed solvent of hexane and toluene), thereby obtaining a metal complex MC3 (0.54 g, yield: 74%) as a yellow solid. The metal complex MC3 showed a HPLC area percentage value of 99.5% or more.

LC-MS (APCI, positive): m/z = 2523.5 $[M+H]^+$

$^1$H-NMR (300 MHz, $CD_2Cl_2$-$d_2$) δ (ppm) = 8.05 (s(br), 6H), 7.70-7.50 (m, 27H), 7.38 (s(br), 6H), 7.13-7.01 (m, 9H), 6.95 (s, 3H), 6.82 (s(br), 3H), 6.65 (s(br), 3H), 2.25 (t, 6H), 2.11 (s, 18H), 2.02 (s, 9H), 1.71-1.64 (m, 9H), 1.48-1.20 (m, 78H), 0.96-0.86 (m, 9H).

<Example 4> Synthesis of metal complex MC4

[Chemical Formula 111]

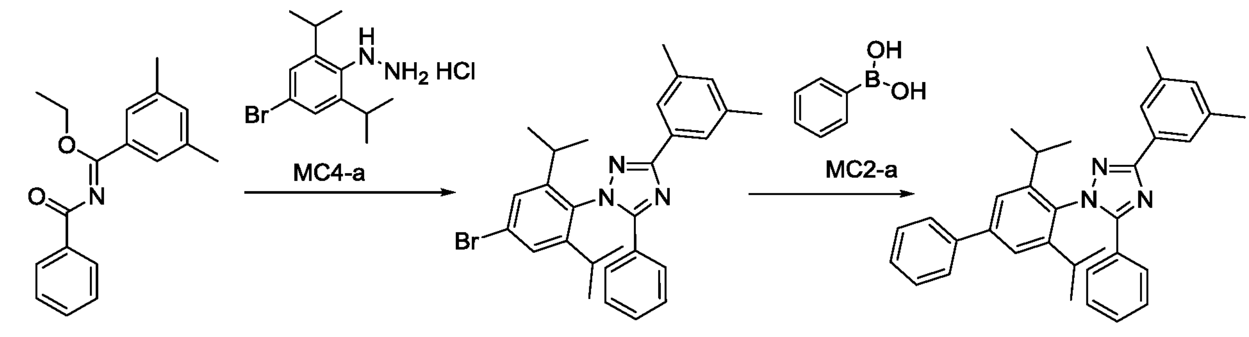


MC1-d MC4-b MC4-c

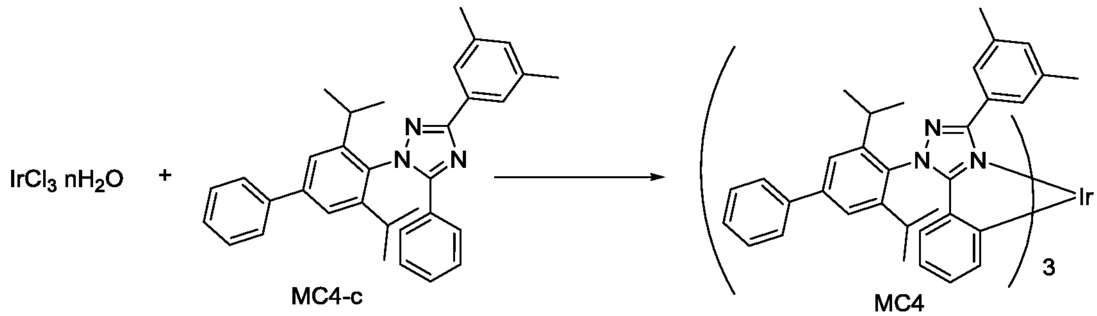


MC4-c MC4

An argon gas atmosphere was prepared in a reaction vessel, then, a compound MC4-a (13.1 g) and tert-butyl methyl ether (110 mL) were added, and the reaction vessel was placed in an ice bath and cooled. Thereafter, to this was added a sodium hydroxide aqueous solution (1 mol/L, 125 mL), and the mixture was stirred for 30 minutes while cooling the reaction vessel in an ice bath. The organic layer of the resultant reaction solution was extracted, thereby obtaining a tert-butyl methyl ether solution as an organic layer.

An argon gas atmosphere was prepared in a reaction vessel separately prepared, then, the compound MC1-d (11.0 g) and chloroform (220 mL) were added, and the reaction vessel was placed in an ice bath and cooled. Thereafter, to this was added the tert-butyl methyl ether solution obtained above. Thereafter, the mixture was stirred for 7 hours while cooling the reaction vessel in an ice bath, then, stirred at room temperature for 110 hours. To the resultant reaction solution was added ion exchanged water (330 mL), the organic layer was extracted, and the resultant organic layer was concentrated under reduced pressure. The resultant residue was purified by silica gel column chromatography (a mixed

solvent of chloroform and hexane), then, recrystallization was performed using a mixed solvent of chloroform and heptane. Thereafter, the crystal was dried under reduced pressure at 50°C, thereby obtaining a compound MC4-b (10.2 g, yield: 55%) as a white solid. The compound MC4-b showed a HPLC area percentage value of 99.5% or more.

LC-MS (ESI, positive): m/z = 488.2 $[M+H]^+$

$^1$H-NMR ($CD_2Cl_2$, 300 MHz) : δ (ppm) = 7.92 (s, 2H), 7.66-7.62 (m, 2H), 7.52 (s, 2H), 7.52-7.36 (m, 3H), 7.16 (s, 1H), 2.57-2.46 (m, 8H), 1.20 (d, 6H), 0.97 (d, 6H).

An argon gas atmosphere was prepared in a reaction vessel, then, the compound MC4-b (10.2 g), a compound MC2-a (2.8 g), bis[tri(2-methoxyphenyl)phosphine]palladium(II) dichloride (92.1 mg), toluene (102 mL) and a 20 wt% tetraethylammonium hydroxide aqueous solution (36.9 g) were added, and the mixture was stirred for 4 hours under reflux with heating. Thereafter, to this was added toluene, and the organic layer was extracted. The resultant organic layer was washed with ion exchanged water, thereby obtaining an organic layer. The resultant organic layer was dried over anhydrous sodium sulfate, then, silica gel (10 g) was added and filtration was performed, and the resultant filtrate was concentrated under reduced pressure, thereby obtaining a solid. The resultant solid was recrystallized using a mixed solvent of heptane and chloroform. Thereafter, the crystal was dried under reduced pressure at 50°C, thereby obtaining a compound MC4-c (8.55 g, yield: 84%) as a white solid. The compound MC4-c showed a HPLC area percentage value of 99.5% or more.

LC-MS (ESI, positive): m/z = 486.3 $[M+H]^+$

$^1$H-NMR ($CD_2Cl_2$, 300 MHz): δ (ppm) = 7.96 (s, 2H), 7.75 (t, 4H), 7.60-7.55 (m, 4H), 7.51-7.41 (m, 4H), 7.17 (s, 1H), 2.63-2.58 (m, 2H), 2.47 (d, 6H), 1.27 (d, 6H), 1.05 (d, 6H).

An argon gas atmosphere was prepared in a reaction vessel, then, iridium chloride n-hydrate (1.96 g), the compound MC4-c (5.61 g), ion exchanged water (20 mL) and diglyme (80 mL) were added, and the mixture was stirred for 18 hours with heating at 150°C. Thereafter, to this was added toluene, and the mixture was washed with ion exchanged water, thereby obtaining an organic layer. The resultant organic layer was concentrated under reduced pressure, thereby obtaining a solid. The resultant solid was purified by silica gel chromatography (a mixed solvent of toluene and methanol). Thereafter, the crystal was dried under reduced pressure at 50°C, thereby obtaining a solid (5.16 g).

An argon gas atmosphere was prepared in a reaction vessel separately prepared, then, the solid obtained above (4.5 g), silver trifluoromethanesulfonate (1.93 g), the compound MC4-c (2.78 g), diglyme (4.5 mL), decane (4.5 mL) and 2,6-lutidine (1.1 mL) were added, and the mixture was stirred for 31 hours with heating at 160°C. Thereafter, to this was added dichloromethane, and the mixture was filtered through a filter paved with celite, and the resultant filtrate was washed with ion exchanged water, thereby obtaining an organic layer. The resultant organic layer was dried over anhydrous magnesium sulfate, then, silica gel (18.6 g) was added and filtration was performed, and the resultant filtrate was concentrated under reduced pressure, thereby obtaining a solid. The resultant solid was purified by silica gel column chromatography (a mixed solvent of cyclohexane and dichloromethane), then, recrystallization was performed using a mixed solvent of toluene and acetonitrile. Thereafter, the crystal was dried under reduced pressure at 50°C, thereby obtaining a metal complex MC4 (1.9 g, yield: 24%) as a yellow solid. The metal complex MC4 showed a HPLC area percentage value of 98.9%.

LC-MS (APCI, positive): m/z = 1646.8 $[M+H]^+$

$^1$H-NMR ($CD_2Cl_2$, 300MHz): δ (ppm) = 9.12-7.10 (m, 27H), 7.00 (s, 3H), 6.72 (t, 3H), 6.62-6.33 (m, 9H), 2.74-1.67 (m, 24H), 1.25 (d, 9H), 1.15-1.00 (m, 18H), 0.84 (d, 9H).

<Example 5> Synthesis of metal complex MC5

[Chemical Formula 112]

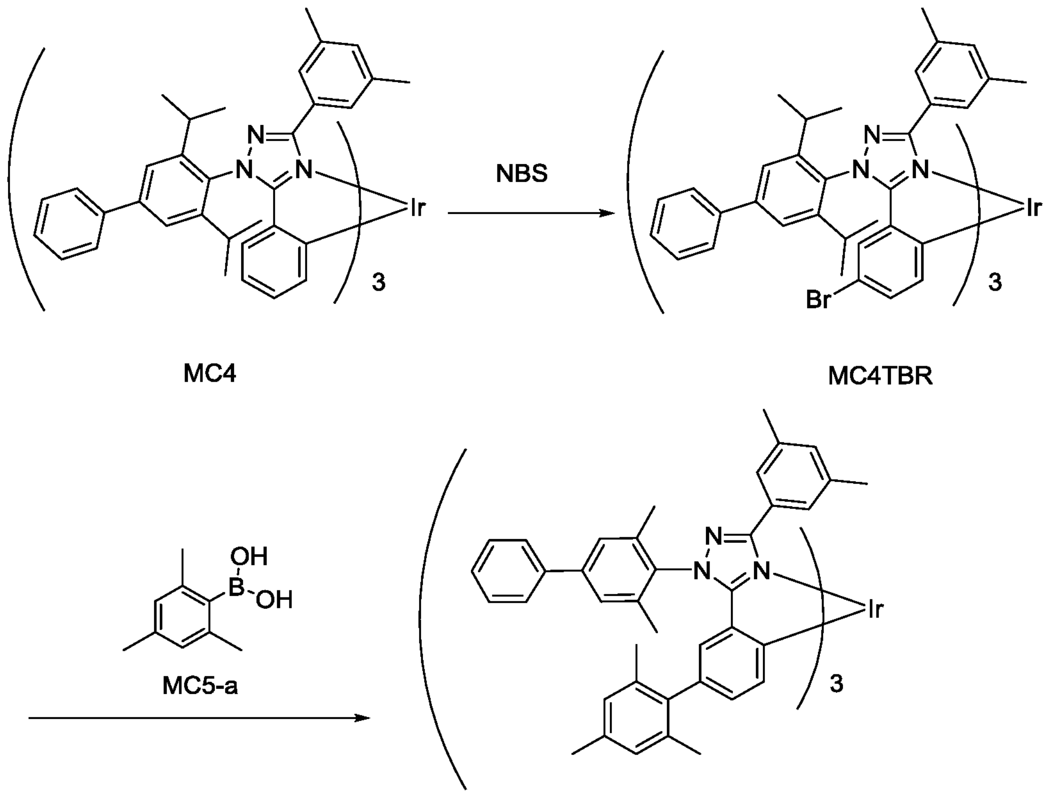


MC4 MC4TBR

MC5-a

MC5

An argon gas atmosphere was prepared in a reaction vessel, then, the metal complex MC4 (0.70 g), dichloromethane (35 mL) and N-bromosuccinimide (825 mg) were added, and the mixture was stirred at room temperature for 40 hours. Thereafter, to this was added a 10 wt% sodium sulfite aqueous solution (7.7 g), then, ion exchanged water (15 mL) was added, and the mixture was stirred at room temperature for 30 minutes. The organic layer was extracted from the resultant reaction solution, and the resultant organic layer was filtered through a filter paved with silica gel. Ethanol was added to the resultant filtrate, thereby causing deposition of a precipitate. The resultant precipitate was filtered, then, dried in vacuum at 50°C, thereby obtaining a metal complex MC4TBR (0.73 g, yield: 91%) as a yellow solid. The metal complex MC4TBR showed a HPLC area percentage value of 96%. This operation was conducted repeatedly, thereby obtaining a necessary amount of the compound MC4TBR.
LC-MS (APCI, positive): m/z = 1880.5 $[M+H]^+$
$^1$H-NMR ($CD_2Cl_2$, 300 MHz) : $\delta$ (ppm) = 8.25-7.83 (m, 6H), 7.76 (d, 6H),7.76-7.46 (m, 15H), 7.04 (s, 3H), 6.83 (d, 3H), 6.50 (s, 3H), 6.31 (d, 3H), 2.33-1.85 (m, 24H), 1.25 (d, 9H), 1.12-1.07 (m, 18H), 0.84 (d, 9H).

An argon gas atmosphere was prepared in a reaction vessel, then, the metal complex MC4TBR (0.60 g), a compound MC5-a (0.52 g), toluene (18 mL) and bis(di-tert-butyl(4-dimethylaminophenyl)phosphine)dichloropalladium(II) (6.8 mg) were added, and the mixture was heated up to 90°C. Thereafter, to this was added a 20 wt% tetraethylammonium hydroxide aqueous solution (9.1 mL), and the mixture was stirred for 19 hours under reflux with heating. Thereafter, to this was added toluene, and the organic layer was extracted. The resultant organic layer was washed with ion exchanged water, dried over anhydrous magnesium sulfate, then, filtered through a filter paved with silica gel, and the resultant filtrate was concentrated under reduced pressure, thereby obtaining a solid. The resultant solid was purified by silica gel column chromatography (a mixed solvent of cyclohexane and dichloromethane), then, recrystallization was performed using a mixed solvent of toluene and acetonitrile. Thereafter, the crystal was dried under reduced pressure at 50°C, thereby obtaining a metal complex MC5 (0.30 g, yield: 47%) as a yellow solid. The metal complex MC5 showed a HPLC area percentage value of 97.5%.
LC-MS (APCI, positive): m/z = 2001.1 $[M+H]^+$
$^1$H-NMR ($CD_2Cl_2$, 300 MHz) : $\delta$ (ppm) = 7.70-7.40 (m, 27H), 7.04 (s, 3H), 6.78 (s, 9H), 6.56-6.52 (m, 3H), 6.21 (s, 3H), 2.43-1.88 (m, 42H), 1.75 (s, 9H), 1.23 (d, 9H), 1.07-1.01 (m, 18H), 0.85 (d, 9H).

<Example 6> Synthesis of metal complex MC6

[Chemical Formula 113]

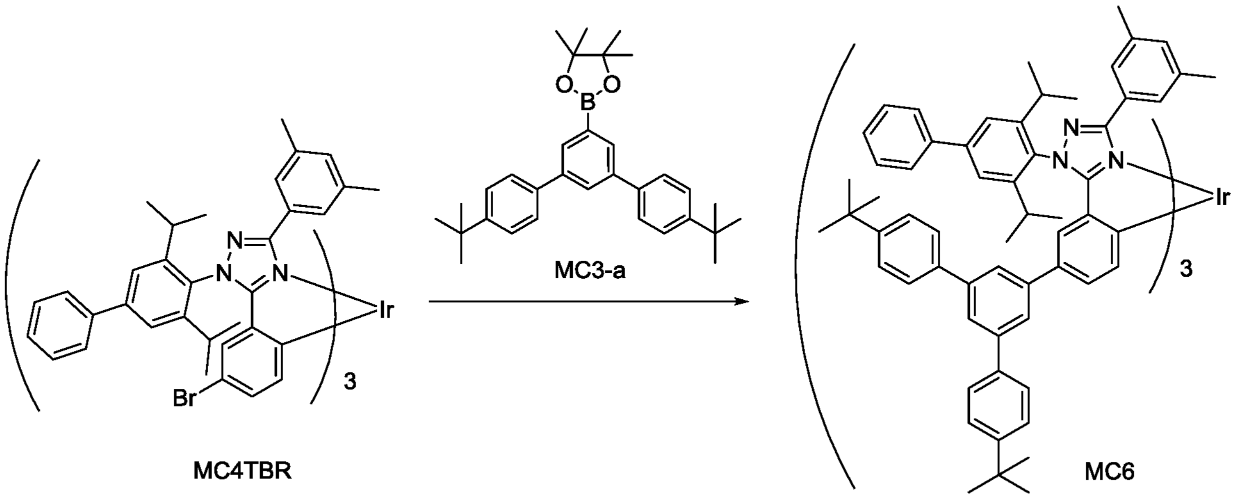


An argon gas atmosphere was prepared in a reaction vessel, then, the metal complex MC4TBR (0.31g), a compound MC3-a (0.31 g), toluene (9.3 mL) and bis (di-tert-butyl(4-dimethylaminophenyl)phosphine)dichlorop alladium(II) (3.5 mg) were added, and the mixture was heated up to 90°C. Thereafter, to this was added a 20 wt% tetraethylammonium hydroxide aqueous solution (2.7 mL), and the mixture was stirred for 5 hours under reflux with heating. Thereafter, to this was added toluene, and the organic layer was extracted. The resultant organic layer was washed with ion exchanged water, dried over anhydrous magnesium sulfate, then, filtered through a filter paved with silica gel, and the resultant filtrate was concentrated under reduced pressure, thereby obtaining a solid. The resultant solid was purified by silica gel column chromatography (a mixed solvent of cyclohexane and dichloromethane), then, recrystallization was performed using a mixed solvent of dichloromethane and hexane. Thereafter, the crystal was dried under reduced pressure at 50°C, thereby obtaining a metal complex MC6 (0.26 g, yield: 60%) as a yellow solid. The metal complex MC6 showed a HPLC area percentage value of 99.5% or more.
LC-MS (APCI, positive): m/z = 2667.5 $[M+H]^+$
$^1$H-NMR ($CD_2Cl_2$, 300 MHz) : δ (ppm) = 8.40-7.32 (m, 60H), 7.15 (d, 3H), 7.05-7.03 (m, 6H), 6.76 (s, 3H), 2.54-2.50 (m, 3H), 2.18-2.13 (m, 18H), 1.38 (s, 54H), 1.31-1.13 (m, 30H), 0.90 (d, 9H) .

<Example 7> Synthesis of metal complex MC7

[Chemical Formula 114]

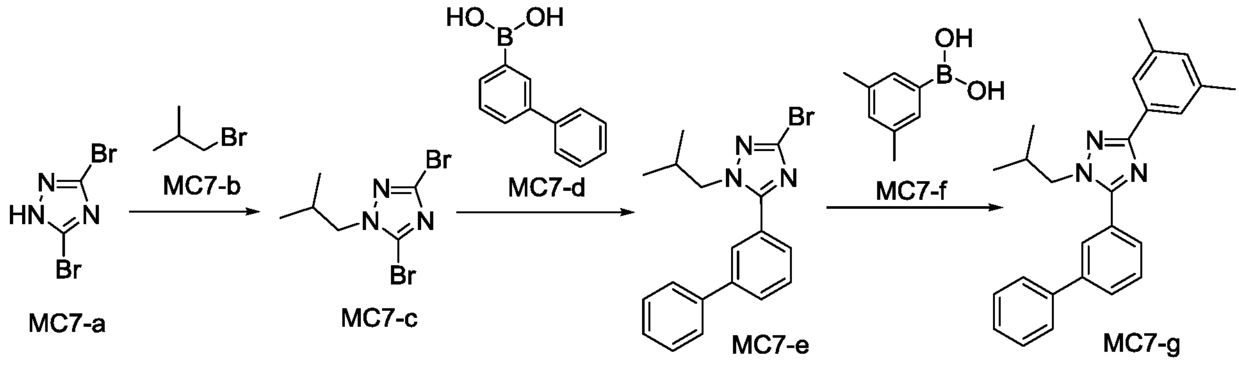


MC7-a MC7-c MC7-e MC7-g

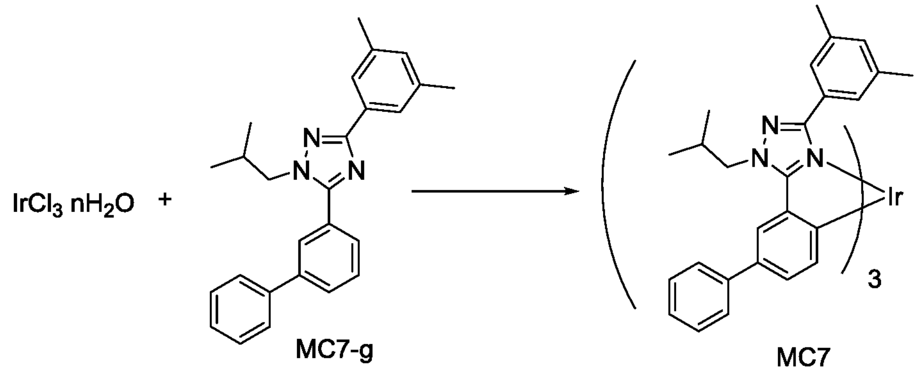


MC7-g MC7

An argon gas atmosphere was prepared in a reaction vessel, then, a compound MC7-a (100 g), potassium carbonate (110 g) and N,N'-dimethylformamide (500 mL) were added, and the mixture was heated up to 90°C. Thereafter, to this was added an N,N'-dimethylformamide (100 mL) solution containing a compound MC7-b (109 g), and the mixture was stirred at 100°C for 1 hour. Thereafter, the mixture was cooled down to room temperature, ion exchanged water and chloroform were added, and the organic layer was extracted. The resultant organic layer was washed with ion exchanged water, dried over anhydrous magnesium sulfate, then, filtered through a filter paved with silica gel, and the resultant filtrate was concentrated under reduced pressure, thereby obtaining an oil. The resultant oil was purified by silica gel column chromatography (a mixed solvent of heptane and ethyl acetate), then, dried under reduced pressure at 45°C, thereby obtaining a compound MC7-c (117 g, yield: 94%) as a colorless oil. The compound MC7-c showed a HPLC area percentage value of 99.5% or more. This operation was conducted repeatedly, threby obtaining a necessary amount of the compound MC7-c.
TLC/MS (DART, positive): m/z = 281.9 $[M+H]^+$
$^1$H-NMR ($CD_2Cl_2$, 300 MHz) : δ (ppm) = 3.94 (d, 2H), 2.32-2.23 (m, 1H), 0.95 (d, 6H).

An argon gas atmosphere was prepared in a reaction vessel, then, the compound MC7-c (127 g), a compound MC7-d (88.9 g), ethanol (380 mL), toluene (1140 mL) and tetrakis(triphenylphosphine)palladium(0) (15.6 g) were added, and the mixture was heated up to 55°C. Thereafter, to this was added a sodium carbonate aqueous solution (2 mol/L, 450 mL), and the mixture was stirred for 29 hours at 70°C. Thereafter, to this was added toluene, and the organic layer was extracted. The resultant organic layer was washed with ion exchanged water, dried over anhydrous magnesium sulfate, then, the resultant solution was concentrated under reduced pressure, thereby obtaining an oil. The resultant oil was purified by silica gel column chromatography (a mixed solvent of toluene and ethyl acetate) several times, then, dried under reduced pressure at 45°C, thereby obtaining a compound MC7-e (63.2 g, yield: 39%) as a colorless oil. The compound MC7-e showed a HPLC area percentage value of 99.5% or more.
TLC/MS (DART, positive): m/z = 356.1 $[M+H]^+$
$^1$H-NMR ($CD_2Cl_2$, 300 MHz): δ (ppm) = 7.83-7.82 (m, 1H), 7.76-7.74 (m, 1H), 7.63-7.53 (m, 4H), 7.56-7.46 (m, 2H), 7.42-7.39 (m, 1H),4.03 (d, 2H), 2.38-2.28 (m, 1H), 0.88 (d, 6H) .

An argon gas atmosphere was prepared in a reaction vessel, then, the compound MC7-e (25.0 g), a compound MC7-f (11.6 g), ethanol (75 mL), toluene (225 mL) and tetrakis (triphenylphosphine)palladium(0) (2.43 g) were added, and the mixture was heated up to 80°C. Thereafter, to this was added a sodium carbonate aqueous solution (2 mol/L, 70 mL), and the mixture was stirred at 80°C for 16 hours. Thereafter, to this was added toluene, and the organic layer was extracted. The resultant organic layer was washed with ion exchanged water, dried over anhydrous magnesium sulfate, then, the resultant solution was concentrated under reduced pressure, thereby obtaining an oil. The resultant oil was purified by silica gel column chromatography (a mixed solvent of heptane and ethyl acetate), then, dried under reduced pressure at 45°C, thereby obtaining a compound MC7-g (26.5 g, yield: 99%) as a colorless oil. The compound

MC7-g showed a HPLC area percentage value of 99.5% or more.
TLC/MS (DART, positive): m/z = 382.2 [M+H]$^+$
$^1$H-NMR ($CD_2Cl_2$, 300 MHz): δ (ppm) = 7.88-7.87 (m, 1H), 7.82-7.80 (m, 2H), 7.75-7.72 (m, 1H), 7.67-7.56 (m, 4H), 7.49-7.45 (m, 2H),7.41-7.37 (m, 1H), 7.05-7.04 (m, 1H), 4.06 (d, 2H), 2.42-2.38 (m, 7H), 0.88 (d, 6H).

An argon gas atmosphere was prepared in a reaction vessel, then, iridium chloride n-hydrate (1.43 g), the compound MC7-g (3.20 g), ion exchanged water (11 mL) and diglyme (35 mL) were added, and the mixture was stirred for 18 hours with heating at 140°C. Thereafter, to this was added toluene, and the mixture was washed with ion exchanged water, thereby obtaining an organic layer. The resultant organic layer was concentrated under reduced pressure, thereby obtaining a solid. The resultant solid was recrystallized using a mixed solvent of tert-butyl methyl ether and heptane, thereby obtaining a solid (2.5 g).

An argon gas atmosphere was prepared in a reaction vessel separately prepared, then, the solid obtained above (1.0 g), silver trifluoromethanesulfonate (0.58 g), the compound MC7-g (1.16 g) and 2,6-lutidine (0.9 mL) were added, and the mixture was stirred for 12 hours with heating at 160°C. Thereafter, to this was added dichloromethane, and the mixture was filtered through a filter paved with celite, and acetonitrile was added to the resultant filtrate, thereby observing generation of a precipitate. The resultant precipitate was filtered, thereby obtaining a solid. The resultant solid was dissolved in dichloromethane, silica gel was added, and the mixture was filtered. The resultant filtrate was concentrated under reduced pressure, purified by column chromatography (toluene), then, recrystallization was performed using a mixed solvent of toluene and methanol. Thereafter, the crystal was dried under reduced pressure at 50°C, thereby obtaining a metal complex MC7 (270 mg, yield: 20%) as a yellow solid. The metal complex MC7 showed a HPLC area percentage value of 88%.
LC-MS (APCI, positive): m/z = 1334.6 [M+H]$^+$
$^1$H-NMR ($CD_2Cl_2$, 300 MHz) : δ (ppm) = 7.75 (d, 3H), 7.67 - 7.64 (m, 6H), 7.49 (t, 6H), 7.39-7.34 (m, 3H), 7.12-7.08 (m, 3H), 6.96 (s, 3H), 6.86-6.83 (m, 3H), 6.50 (s, 6H), 4.53-4.46 (m, 3H), 4.14-4.00 (m, 3H), 2.45-2.32 (m, 3H), 2.23-2.18 (m, 18H), 1.08 (d, 9H), 0.91 (d, 9H).

<Example 8> Synthesis of metal complex MC8

[Chemical Formula 115]

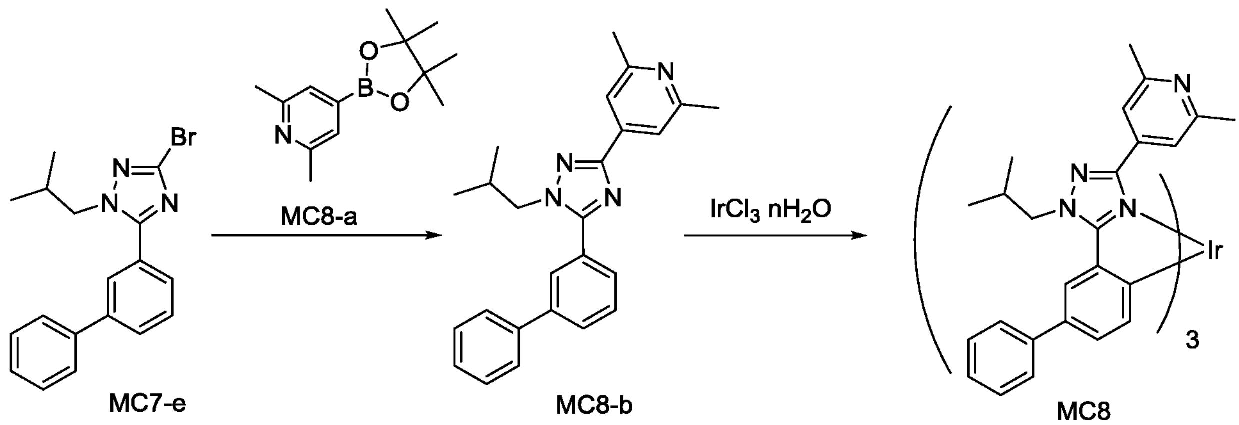

MC7-e MC8-b MC8

An argon gas atmosphere was prepared in a reaction vessel, then, the compound MC7-e (25.0 g), a compound MC8-a (18.0 g), ethanol (75 mL), toluene (225 mL) and tetrakis (triphenylphosphine)palladium(0) (2.43 g) were added, and the mixture was heated up to 80°C. Thereafter, to this was added a sodium carbonate aqueous solution (2 mol/L, 70 mL), and the mixture was stirred at 80°C for 48 hours. Thereafter, the mixture was cooled down to room temperature, toluene was added, and the organic layer was extracted. The resultant organic layer was washed with ion exchanged water, dried over anhydrous magnesium sulfate, then, the resultant solution was concentrated under reduced pressure, thereby obtaining an oil. The resultant oil was purified by silica gel column chromatography (a mixed solvent of toluene and ethyl acetate) several times, then, dried under reduced pressure at 45°C, thereby obtaining a compound MC8-b (24.2 g, yield: 90%) as a yellow oil. The compound MC8-b showed a HPLC area percentage value of 99.5% or more.
TLC/MS (DART, positive): m/z = 383.2 [M+H]$^+$
$^1$H-NMR ($CD_2Cl_2$, 300 MHz) : δ (ppm) = $^1$H-NMR ($CDCl_3$, 300 MHz) : δ (ppm) = 7.87 (s, 1H), 7.78-7.72 (m, 3H), 7.66-7.59 (m, 4H), 7.50-7.46 (m, 2H), 7.42-7.38 (m, 1H), 4.09 (d, 2H), 2.60 (m, 6H), 2.42-2.33 (m, 1H), 0.89 (d, 6H).

An argon gas atmosphere was prepared in a reaction vessel, then, iridium chloride n-hydrate (1.43 g), the compound MC8-b (3.21 g), ion exchanged water (11 mL) and diglyme (35 mL) were added, and the mixture was stirred for 18 hours under reflux with heating. Thereafter, to this was added dichloromethane, and the mixture was washed with saturated saline, thereby obtaining an organic layer. The resultant organic layer was dried over anhydrous magnesium sulfate, and the resultant filtrate was concentrated under reduced pressure, thereby obtaining an oil. Hexane was added to the resultant oil, threby causing deposition of a precipitate. The resultant precipitate was filtered, washed with cyclopentyl methyl ether, then, dried under reduced pressure at 50°C, thereby obtaining a solid (3.0 g).

An argon gas atmosphere was prepared in a reaction vessel separately prepared, then, the solid obtained above (1.5 g), silver trifluoromethanesulfonate (0.58 g), the compound MC8-b (0.87 g) and 2,6-lutidine (0.9 mL) were added, and the mixture was stirred for 12 hours with heating at 160°C. Thereafter, to this was added dichloromethane containing 1 vol% of methanol, then, silica gel was added, and the mixture was filtered through a filter paved with celite, and the resultant filtrate was concentrated under reduced pressure, thereby obtaining a solid. The resultant solid was purified by column chromatography (a mixed solvent of toluene and methanol), then, recrystallization was performed using a mixed solvent of toluene and acetonitrile . Thereafter, the crystal was dried under reduced pressure at 50°C, thereby obtaining a metal complex MC8 (130 mg, yield: 13%) as a yellow solid. The metal complex MC8 showed a HPLC area percentage value of 98.6%.

LC-MS (APCI, positive): m/z = 1337.6 $[M+H]^+$

$^1$H-NMR ($CD_2Cl_2$, 300 MHz) : δ (ppm) = 7.77 (d, 3H), 7.66-7.63 (m, 6H), 7.50 (t, 6H), 7.40-7.35 (m, 3H), 7.14-7.10 (m, 3H), 6.80 (d, 3H), 6.72-6.48 (m, 6H), 4.57-4.50 (m, 3H), 4.21-4.13 (m, 3H), 2.45-2.31 (m, 21H), 1.09 (d, 9H), 0.92 (d, 9H).

<Example 9> Synthesis of metal complex MC9

[Chemical Formula 116]

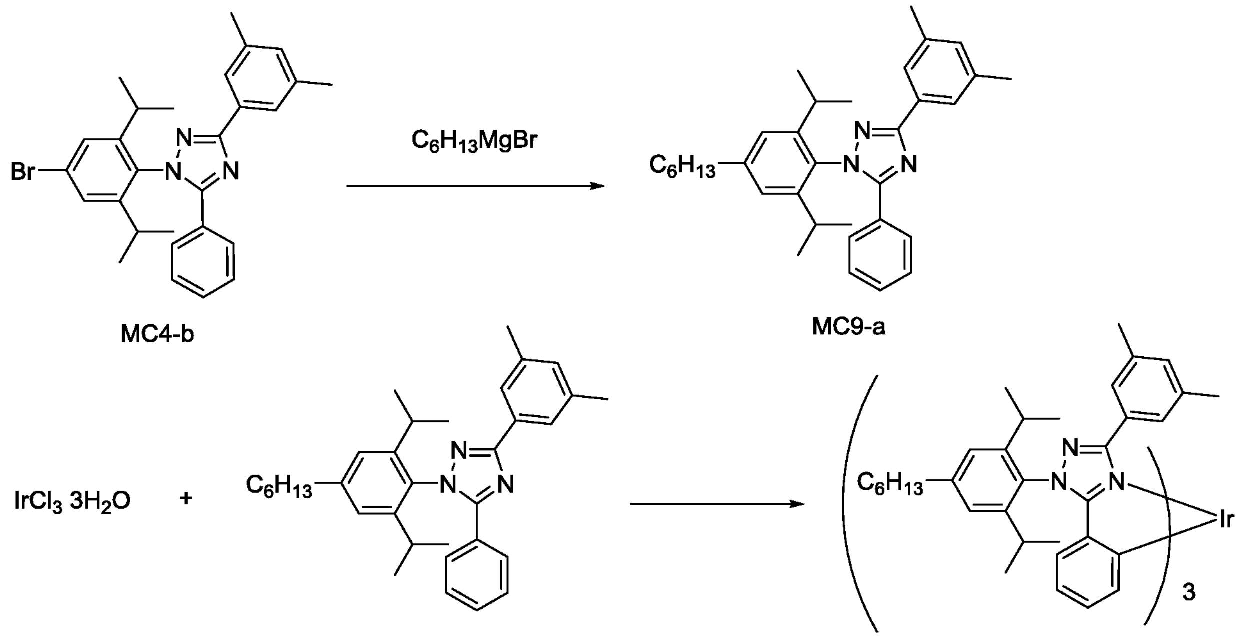


MC4-b MC9-a

MC9-a MC9

An argon gas atmosphere was prepared in a reaction vessel, then, the compound MC4-b (17.0 g), cyclopentyl methyl ether (150 mL) and [1,1'-bis(diphenylphosphino)ferrocene]palladium(II) dichloride (172 mg) were added, and the mixture was heated up to 50°C. Thereafter, to this was added a diethyl ether solution of hexylmagnesium bromide (2 mol/L, 35 mL), then, the mixture was stirred at 50°C for 5 hours. Thereafter, to this was added a hydrochloric acid aqueous solution (1 mol/L, 35 mL), and the organic layer was extracted. The resultant organic layer was washed with ion exchanged water (85 mL) twice, dried over anhydrous magnesium sulfate, then, filtered, and the resultant filtrate was concentrated under reduced pressure, thereby obtaining an oil. To the resultant oil were added toluene and silica gel, and the mixture was stirred at room temperature for 30 minutes. Thereafter, the mixture was filtered through a filter paved with celite, and the resultant filtrate was concentrated under reduced pressure, thereby obtaining a solid. The

resultant solid was recrystallized using acetonitrile. Thereafter, the crystal was dried under reduced pressure at 50°C, thereby obtaining a compound MC9-a (13.7 g, yield: 80%) as a white solid. The compound MC9-a showed a HPLC area percentage value of 99.5% or more.

TLC/MS (DART, positive): m/z = 494 $[M+H]^+$

$^1$H-NMR (300 MHz, $CD_2Cl_2$-$d_2$) δ (ppm) = 7.92 (s, 2H), 7.67-7.63 (m, 2H), 7.46-7.33 (m, 3H), 7.18 (s, 2H), 7.14 (s, 1H), 2.76 (t, 2H), 2.57-2.46 (m, 8H), 1.77-1.70 (m, 2H), 1.48-1.42 (m, 6H), 1.21-1.19 (m, 6H), 0.98-0.96 (m, 9H).

An argon gas atmosphere was prepared in a reaction vessel, then, iridium chloride n-hydrate (2.96 g), the compound MC9-a (8.65 g), ion exchanged water (30 mL) and diglyme (74 mL) were added, and the mixture was stirred for 18 hours under reflux with heating. Thereafter, the mixture was cooled down to room temperature, toluene was added, and the mixture was washed with ion exchanged water. The organic layer of the resultant washing liquid was extracted, and the resultant organic layer was concentrated under reduced pressure, thereby obtaining a solid. The resultant solid was purified by silica gel column chromatography (a mixed solvent of toluene and ethanol), thereby obtaining a solid (7.51 g).

An argon gas atmosphere was prepared in a reaction vessel separately prepared, then, the solid obtained above (7.40 g), silver trifluoromethanesulfonate (3.19 g), the compound MC9-a (4.59 g), 2,6-lutidine (1.66 g) and decane (15 mL) were added, and the mixture was stirred for 20 hours with heating at 150°C. Thereafter, the mixture was cooled down to room temperature, toluene was added, and the mixture was filtered through a filter paved with silica gel and celite, and the resultant filtrate was washed with ion exchanged water, thereby obtaining an organic layer. The resultant organic layer was concentrated under reduced pressure, thereby obtaining a solid. The resultant solid was purified by silica gel column chromatography (a mixed solvent of dichloromethane and cyclohexane), then, recrystallization was performed using a mixed solvent of toluene and methanol. Thereafter, the crystal was dried under reduced pressure at 50°C, thereby obtaining a metal complex MC9 (1.47 g, yield: 14%) as a yellow solid. The metal complex MC9 showed a HPLC area percentage value of 99.4%.

LC-MS (APCI, positive): m/z = 1671.0 $[M+H]^+$

$^1$H-NMR (300 MHz, $CD_2Cl_2$-$d_2$) δ (ppm) = 8.03 (br, 6H), 7.17 (s, 6H), 6.96 (s, 3H), 6.66 (t, 3H), 6.51-6.41 (m, 6H), 6.32 (d, 3H), 2.76 (t, 6H), 2.23-1.92 (m, 21H), 1.76-1.69 (m, 6H), 1.58 (s, 3H), 1.53-1.42 (m, 18H), 1.16 (d, 9H), 1.01-0.96 (m, 27H), 0.73 (d, 9H).

<Example 10> Synthesis of metal complex MC10

[Chemical Formula 117]

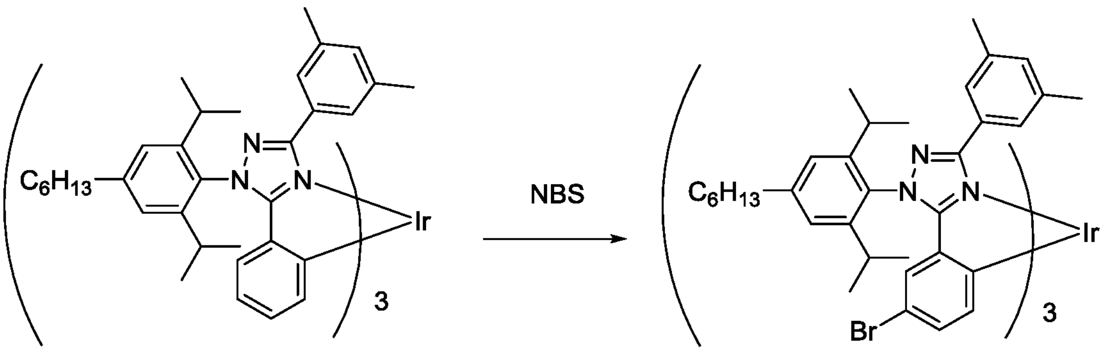


MC9

MC9TBR

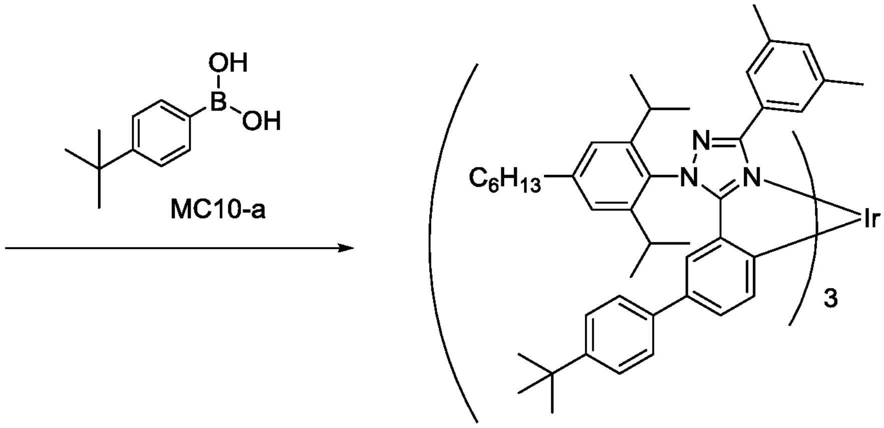


MC10

An argon gas atmosphere was prepared in a reaction vessel, then, the metal complex MC9 (1.36 g), dichloromethane (68 mL) and N-bromosuccinimide (1.23 g) were added, and the mixture was stirred at room temperature for 32 hours. Thereafter, to this was added a 10 wt% sodium sulfite aqueous solution (8.71 g), then, ion exchanged water (70 mL) was added, and the mixture was stirred at room temperature for 30 minutes. The organic layer was extracted from the resultant reaction solution, and the resultant organic layer was filtered through a filter paved with silica gel. The resultant filtrate was concentrated under reduced pressure, thereby obtaining a solid. The resultant solid was dissolved in toluene, then, methanol was added, thereby causing deposition of a precipitate. The resultant precipitate was filtered, then, dried in vacuum at 50°C, thereby obtaining a metal complex MC9TBR (1.47 g, yield: 95%) as a yellow solid. The metal complex MC9TBR showed a HPLC area percentage value of 99.5% or more.

LC-MS (APCI, positive): m/z = 1903.7 $[M+H]^+$

$^1$H-NMR (300 MHz, $CD_2Cl_2$-$d_2$) $\delta$ (ppm) = 8.00 (br, 6H), 7.20 (s, 6H), 6.99 (s, 3H), 6.67 (d, 3H), 6.36 (d, 3H), 6.25 (d, 3H), 2.78 (t, 6H), 2.06-1.69 (m, 30H), 1.46-1.41 (m, 18H), 1.16 (d, 9H), 1.03-0.94 (m, 27H), 0.74 (d, 9H).

An argon gas atmosphere was prepared in a reaction vessel, then, the metal complex MC9TBR (1.30 g), a compound MC10-a (0.44 g), toluene (65 mL) and (di-tert-butyl(4-dimethylaminophenyl)phosphine)dichloropall adium(II) (16 mg) were added, and the mixture was heated up to 80°C. Thereafter, to this was added a 20 wt% tetrabutylammonium hydroxide aqueous solution (23 mL), and the mixture was stirred for 36 hours under reflux with heating. Thereafter, the mixture was cooled down to room temperature, toluene was added, and the organic layer was extracted. The resultant organic layer was washed with ion exchanged water, dried over anhydrous magnesium sulfate, then, filtered through a filter paved with silica gel and celite, and the resultant filtrate was concentrated under reduced pressure, thereby obtaining a solid. The resultant solid was purified by silica gel column chromatography (a mixed solvent of dichloromethane and cyclohexane), then, recrystallization was performed using a mixed solvent of ethyl acetate and acetonitrile. Thereafter, the crystal was dried under reduced pressure at 50°C, thereby obtaining a metal complex MC10 (0.93 g, yield: 72%) as a yellow solid. The metal complex MC10 showed a HPLC area percentage value of 99.5% or more.

LC-MS (APCI, positive): m/z = 2067.3 $[M+H]^+$

$^1$H-NMR (300 MHz, $CD_2Cl_2$-$d_2$) $\delta$ (ppm) = 8.04 (br, 6H), 7.30-7.26 (m, 12H), 7.06-6.98 (m, 12H), 6.70 (s, 3H), 6.54 (d, 3H), 2.82 (t, 6H), 2.32-1.78 (m, 27H), 1.59-1.42 (m, 21H), 1.34 (s, 27H), 1.20 (d, 9H),1.10 (d, 9H), 1.04-0.98 (m, 18H), 0.73 (d, 9H).

<Example 11> Synthesis of metal complex MC11

[Chemical Formula 118]

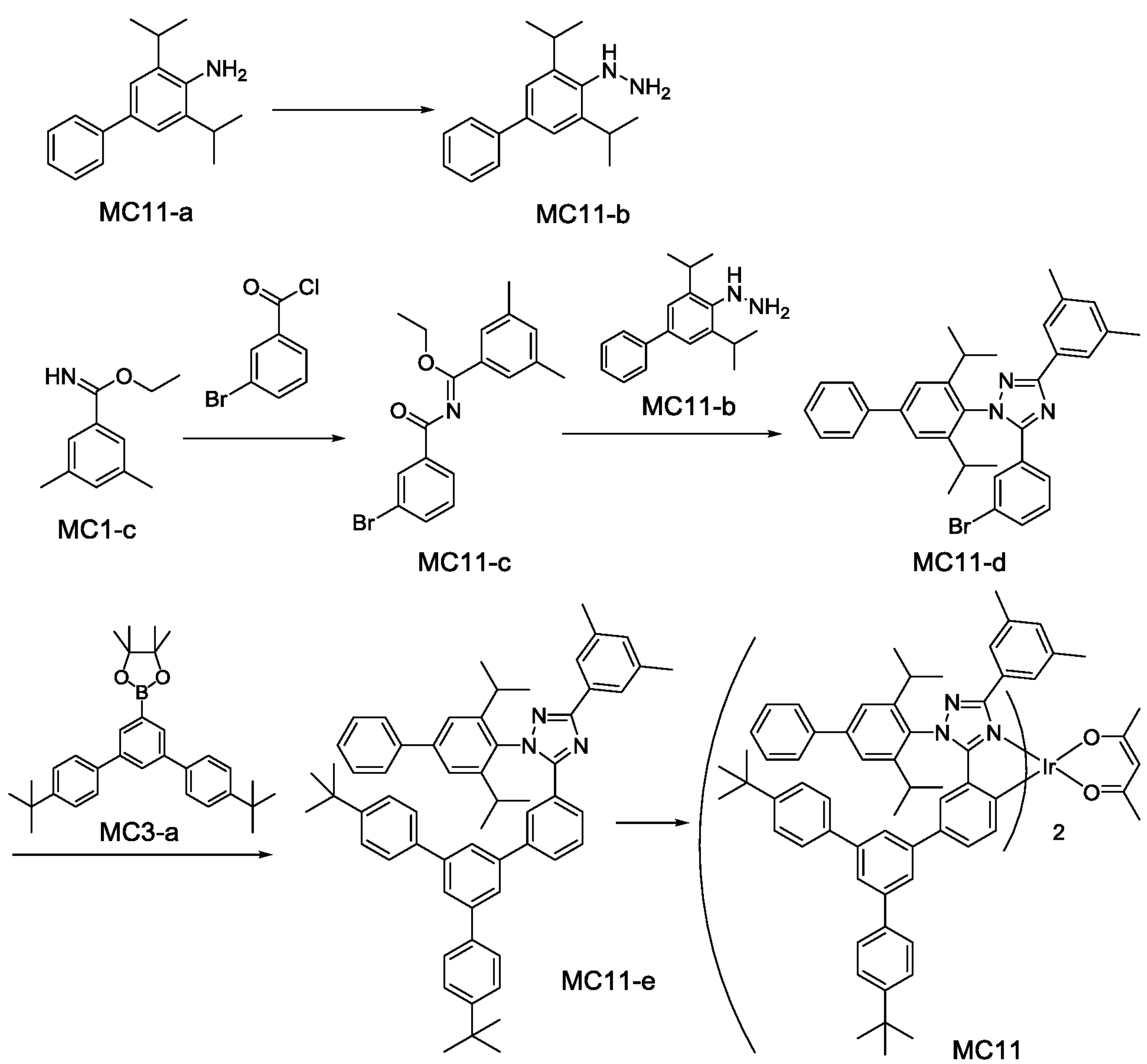


An argon gas atmosphere was prepared in a reaction vessel, then, a compound MC11-a (140 g) and concentrated hydrochloric acid (1.26 L) were added, and the reaction vessel was placed in an ice bath and cooled. Thereafter, to this was added sodium sulfite (50 g), and the mixture was stirred for 30 minutes while cooling the reaction vessel in an ice bath. Thereafter, to this was added tin(II) chloride (400 g), then, the mixture was stirred at room temperature for 18 hours. Thereafter, the resultant reaction liquid was concentrated under reduced pressure, and the resultant residue was washed with a mixed solvent of hexane and diethyl ether, thereby obtaining a solid. To the resultant solid were added tert-butyl methyl ether and a 10% sodium hydroxide aqueous solution, and the organic layer was extracted. The resultant organic layer was washed with ion exchanged water, dried over anhydrous sodium sulfate added, then, concentrated under reduced pressure, thereby obtaining a compound MC11-b (125 g, yield: 83%) as a white solid.

An argon gas atmosphere was prepared in a reaction vessel, then, the compound MC1-c (80 g), 3-bromobenzoyl chloride (100 g) and chloroform were added, then, triethylamine (94 mL) was added, and the mixture was stirred at room temperature for 16 hours. The resultant reaction solution was concentrated under reduced pressure, and to the resultant

residue was added heptane, thereby obtaining a solution containing a white solid. The resultant solution containing a white solid was filtered, then, the resultant filtrate was concentrated, thereby obtaining a compound MC11-c (90 g, yield: 55%).

An argon gas atmosphere was prepared in a reaction vessel, then, the compound MC11-c (90 g), the compound MC11-b (56 g), triethylamine (100 mL) and carbon tetrachloride were added, and the mixture was stirred at 50°C for 3 days. The resultant reaction mixture was purified by silica gel column chromatography (a mixed solvent of ethyl acetate and hexane), thereby obtaining a compound MC11-d (45 g, yield: 32%) as a white solid. The compound MC11-d showed a HPLC area percentage value of 94.8%. This operation was conducted repeatedly, thereby obtaining a necessary amount of the compound MC11-d.

An argon gas atmosphere was prepared in a reaction vessel, then, the compound MC11-d (60 g), a compound MC3-a (55 g), tris(dibenzylideneacetone)dipalladium(0) (980 mg), 2-dicyclohexylphosphino-2',6'-dimethoxybiphenyl (440 mg), toluene and a 40 wt% tetraethylammonium hydroxide aqueous solution (156 g) were added, and the mixture was stirred for 18 hours under reflux with heating. Thereafter, the mixture was cooled down to room temperature, the organic layer was extracted, and the resultant organic layer was concentrated under reduced pressure, thereby obtaining a solid. The resultant solid was purified by silica gel column chromatography (a mixed solvent of hexane and ethyl acetate), then, recrystallization was performed using a mixed solvent of toluene and acetonitrile. Thereafter, the crystal was dried under reduced pressure at 50°C, thereby obtaining a compound MC11-e (85 g, yield: 97%) as a white solid. The compound MC11-e showed a HPLC area percentage value of 99.5% or more.

LC-MS (ESI, positive): m/z = 826.5 $[M+H]^+$

$^1$H-NMR ($CD_2Cl_2$, 300 MHz): $\delta$ (ppm) = 8.00 (t, 1H), 7.96 (s, 2H), 7.87-7.82 (m, 3H), 7.68-7.46 (m, 18H), 7.17 (s, 1H), 2.71-2.62 (m, 2H), 2.47 (s, 6H), 1.42 (s, 18H), 1.29 (d, 6H), 1.07 (s, 6H) .

An argon gas atmosphere was prepared in a reaction vessel, then, iridium chloride n-hydrate (6.38 g), the compound MC11-e (31.1g), ion exchanged water (51 mL) and diglyme (151 mL) were added, and the mixture was stirred for 36 hours under reflux with heating. Thereafter, to this was added toluene, and the mixture was washed with ion exchanged water. The organic layer of the resultant washing liquid was extracted, and the resultant organic layer was concentrated under reduced pressure, thereby obtaining a solid. The resultant solid was purified by silica gel column chromatography (a mixed solvent of toluene and ethanol), thereby obtaining a solid (28.5 g).

An argon gas atmosphere was prepared in a reaction vessel separately prepared, then, the solid obtained above (0.60 g), acetylacetone (0.96 g), sodium carbonate (0.34 g) and 2-ethoxyethanol (18 mL) were added, and the mixture was stirred at 120°C for 2 hours, thereby causing deposition of a precipitate. The resultant precipitate was filtered, and washed with 2-ethoxyethanol (30 mL), ion exchanged water (30 mL) and methanol (30 mL) in this order, thereby obtaining a solid. The resultant solid was dissolved in dichloromethane (5 mL), then, the solution was filtered through a filter paved with silica gel (3 g), and the resultant filtrate was concentrated under reduced pressure, thereby obtaining a solid. The resultant solid was recrystallized using ethyl acetate, then, further, recrystallized using a mixed solvent of toluene and acetonitrile. Thereafter, the crystal was dried under reduced pressure at 50 °C, thereby obtaining a metal complex MC11 (0.40 g, yield: 65%) as a yellow solid. The metal complex MC11 showed a HPLC area percentage value of 97.9%.

LC-MS (ESI, positive): m/z = 1980.0 $[M+K]^+$

$^1$H-NMR (300 MHz, $CD_2Cl_2$ -$d_2$) $\delta$ (ppm) =7.78 (d, 4H), 7.69-7.65 (m, 10H), 7.53-7.50 (m, 18H), 7.36-7.30 (m, 12H), 7.07-7.04 (m, 4H), 4.71 (s, 1H), 3.15-3.06 (m, 2H), 2.86-2.77 (m, 2H), 2.25 (s, 12H), 1.46-1.26 (m, 66H).

<Example 12> Synthesis of metal complexes MC12, MC13 and MC14

[Chemical Formula 119]

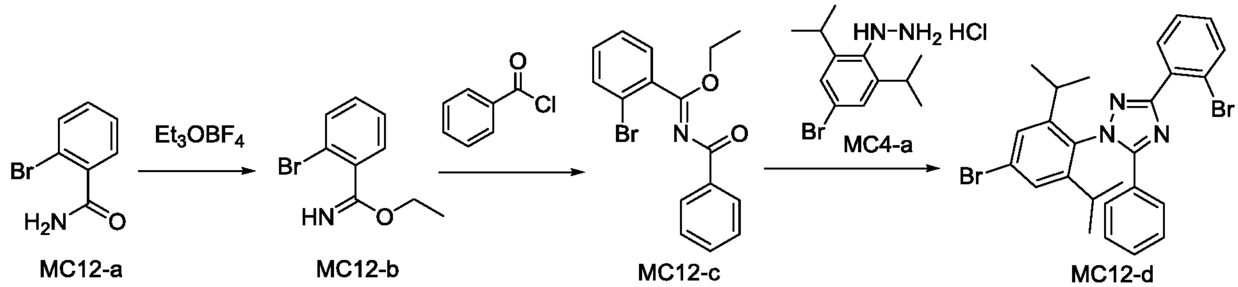


MC12-a MC12-b MC12-c MC12-d

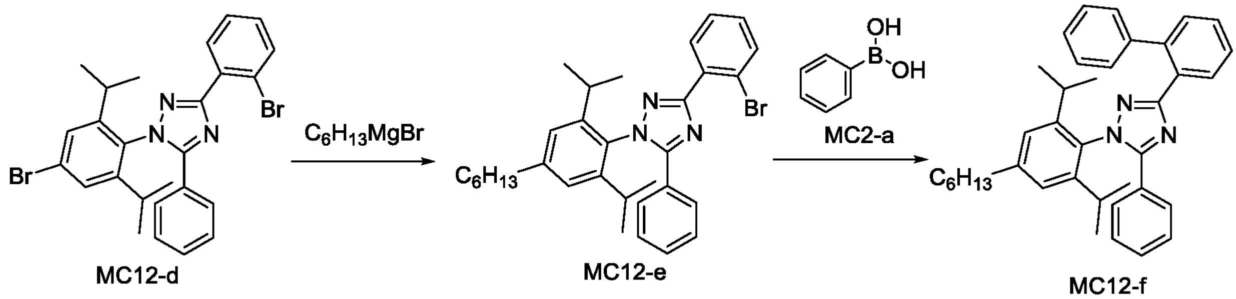


MC12-d MC12-e MC12-f

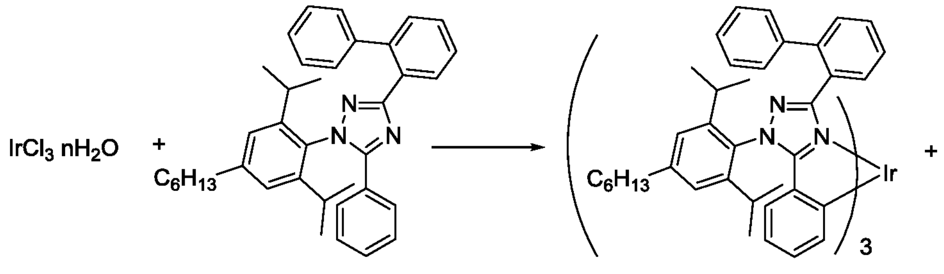

MC12

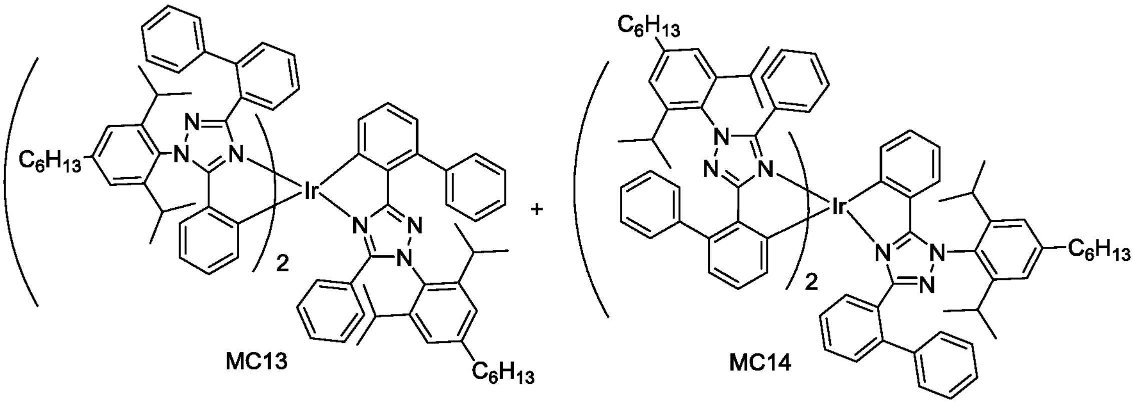

MC13 MC14

An argon gas atmosphere was prepared in a reaction vessel, then, a compound MC12-a (90.0 g) and dichloromethane (900 mL) were added. Thereafter, to this was added a dichloromethane solution of triethyloxonium tetrafluoroborate (1 mol/L, 525 mL), and the mixture was stirred at room temperature for 38 hours. Thereafter, to this was added a sodium hydrogen carbonate aqueous solution (1 mol/L, 525 mL), and the mixture was stirred for 30 minutes at room temperature. The organic layer of the resultant reaction solution was extracted, then, the resultant organic layer was washed with ion exchanged water, thereby obtaining an organic layer. To the resultant organic layer was added heptane (200 mL), then, dichloromethane was concentrated under reduced pressure, thereby obtaining a solution containing a white solid. The resultant solution containing a white solid was filtered, then, the resultant filtrate was concentrated, thereby obtaining a compound MC12-b (74.2 g, yield: 65%) as a yellow oil. The compound MC12-b showed a HPLC area percentage value of 98.6%.

TLC/MS (DART, positive): m/z = 228 $[M+H]^+$

An argon gas atmosphere was prepared in a reaction vessel, then, the compound MC12-b (33.5 g), benzoyl

chloride (52.4 g) and chloroform (730 mL) were added, then, triethylamine (52.0 mL) was added, and the mixture was stirred for 66 hours at room temperature. The resultant reaction solution was concentrated under reduced pressure, to the resultant residue was added cyclopentyl methyl ether (600 mL), and the mixture was filtered, thereby obtaining a filtrate. The resultant filtrate was concentrated under reduced pressure, and the resultant residue was purified by silica gel column chromatography (chloroform), thereby obtaining a compound MC12-c (88.0 g, yield: 78%) as a yellow oil. The compound MC12-c showed a HPLC area percentage value of 91.3%.
TLC/MS (DART, positive): m/z = 332 $[M+H]^+$

An argon gas atmosphere was prepared in a reaction vessel, then, a compound MC4-a (56.8 g) and tert-butyl methyl ether (570 mL) were added, the reaction vessel was cooled down to temperatures in the range of 0°C to 10°C using an ice bath. Thereafter, to this was added a sodium hydroxide aqueous solution (1 mol/L, 550 mL), and the mixture was stirred for 30 minutes while cooling the reaction vessel to temperatures in the range of 0°C to 10°C using an ice bath. The organic layer of the resultant reaction solution was extracted, thereby obtaining a tert-butyl methyl ether as an organic layer.

An argon gas atmosphere was prepared in a reaction vessel separately prepared, then, the compound MC12-c (60.0 g) and chloroform (1.20 L) were added, and the reaction vessel was placed in an ice bath and cooled. Thereafter, to this was added the tert-butyl methyl ether solution obtained above. Thereafter, the mixture was stirred for 6 hours while cooling the reaction vessel by an ice bath, then, stirred at room temperature for 100 hours, then, stirred for 200 hours under reflux with heating, then, the mixture was cooled down to room temperature. To the resultant reaction solution was added ion exchanged water (500 mL), the organic layer was extracted, and the resultant organic layer was concentrated under reduced pressure. The resultant residue was purified by silica gel column chromatography (toluene), then, recrystallization was performed using heptane. Thereafter, the crystal was dried under reduced pressure at 50°C, thereby obtaining a compound MC12-d (58.5 g, yield: 66%) as a white solid. The compound MC12-d showed a HPLC area percentage value of 99.5% or more.
LC-MS (ESI, positive): m/z = 538.1 $[M+H]^+$
$^1$H-NMR (300 MHz, $CD_2Cl_2$-$d_2$) : $\delta$ (ppm) = 8.06-8.04 (m, 1H), 7.82-7.79 (m, 1H), 7.68-7.62 (m, 2H), 7.53-7.36 (m, 7H), 2.63-2.49 (m, 2H), 1.22 (d, 6H), 1.00 (d, 6H).

An argon gas atmosphere was prepared in a reaction vessel, then, the compound MC12-d (30.0 g), cyclopentyl methyl ether (1.20 L) and [1,1'-bis(diphenylphosphino)ferrocene]palladium(II) dichloride (230 mg) were added, and the mixture was heated up to 40°C. Thereafter, to this was added a diethyl ether solution of hexylmagnesium bromide (2 mol/L, 33.4 mL), then, the mixture was stirred at 40°C for 3 hours. Thereafter, to this was added a hydrochloric acid aqueous solution (1 mol/L, 80 mL), and the organic layer was extracted. The resultant organic layer was washed with ion exchanged water (300 mL) three times, dried over anhydrous magnesium sulfate, then, silica gel (30 g) was added and filtration was performed, and the resultant filtrate was concentrated under reduced pressure, thereby obtaining an oil. The resultant oil was purified by silica gel column chromatography (a mixed solvent of hexane and ethyl acetate), to obtain a compound MC12-e (28.5 g, yield: 79%) as a colorless oil. The compound MC12-e showed a HPLC area percentage value of 84%.
LC-MS (ESI, positive): m/z = 544.2 $[M+H]^+$

An argon gas atmosphere was prepared in a reaction vessel, then, the compound MC12-e (23.0 g), a compound MC2-a (5.20 g), toluene (460 mL) and (di-tert-butyl(4-dimethylaminophenyl)phosphine)dichloropall adium(II) (251 mg) were added, and the mixture was heated up to 80°C. Thereafter, to this was added a 10 wt% tetrabutylammonium hydroxide aqueous solution (276 mL), and the mixture was stirred for 32 hours under reflux with heating. Thereafter, the mixture was cooled down to room temperature, toluene was added, and the organic layer was extracted. The resultant organic layer was washed with ion exchanged water, dried over anhydrous magnesium sulfate, then, the mixture was filtered through a filter paved with silica gel and celite, and the resultant filtrate was concentrated under reduced pressure, thereby obtaining an oil. The resultant oil was purified by silica gel column chromatography (a mixed solvent of hexane and ethyl acetate), then, recrystallization was performed using acetonitrile. Thereafter, the crystal was dried under reduced pressure at 50°C, thereby obtaining a compound MC12-f (15.2 g, yield: 79%) as a white solid. The compound MC12-f showed a HPLC area percentage value of 99.5% or more.
LC-MS (APCI, positive): m/z = 542.4 $[M+H]^+$
$^1$H-NMR (300 MHz, $CD_2Cl_2$-$d_2$) $\delta$ (ppm) = 7.96-7.93 (m, 1H), 7.63-7.53 (m, 3H), 7.45-7.27 (m, 10H), 7.14 (s, 2H), 2.75 (t, 2H), 2.46-2.33 (m, 2H), 1.78-1.68 (m, 2H), 1.48-1.38 (m, 6H), 1.12 (d, 6H), 1.01-0.94 (m, 9H).

An argon gas atmosphere was prepared in a reaction vessel, then, iridium chloride n-hydrate (3.14 g), the compound MC12-f (10.0 g), ion exchanged water (25 mL) and diglyme (78 mL) were added, and the mixture was stirred at 130°C for 42 hours, then, the mixture was cooled down to room temperature. Thereafter, to this was added toluene, and the mixture was washed with ion exchanged water, thereby obtaining an organic layer. The resultant organic layer was concentrated under reduced pressure, thereby obtaining a solid. The resultant solid was purified by silica gel column chromatography (a mixed solvent of toluene and ethanol), thereby obtaining a solid (10.0 g).

An argon gas atmosphere was prepared in a reaction vessel separately prepared, then, the solid obtained

above (10.0 g), silver trifluoromethanesulfonate (2.94 g) and acetonitrile (250 mL) were added, and the mixture was stirred for 2 hours under reflux with heating. Thereafter, the mixture was cooled down to room temperature, filtered through a filter paved with celite, and the resultant filtrate was concentrated under reduced pressure, thereby obtaining an oil. The resultant oil was purified by alumina column chromatography (acetonitrile), then, dried at room temperature using an argon gas, thereby obtaining a solid (9.94 g).

An argon gas atmosphere was prepared in a reaction vessel separately prepared, then, the solid obtained above (9.0 g), the compound MC12-f (4.54 g), 2,6-lutidine (3.5 mL) and pentadecane (4.5 mL) were added, and the mixture was stirred at 190°C for 70 hours. Thereafter, the mixture was cooled down to room temperature, dichloromethane (130 mL) was added, and the reaction mixture was dissolved in dichloromethane. Thereafter, to this was added 2-propanol (30 mL), and dichloromethane was concentrated under reduced pressure, thereby observing generation of a precipitate. The resultant precipitate was filtered, thereby obtaining a filtrate. The resultant filtrate was concentrated under reduced pressure, thereby obtaining an oil. The resultant oil was purified by silica gel column chromatography (a mixed solvent of toluene and hexane), then, further, purified by reversed phase column chromatography (a mixed solvent of acetonitrile and ethyl acetate) several times, thereby obtaining a metal complex MC12, a metal complex MC13 and a metal complex MC14 under individually separated condition.

The resultant metal complex MC12 was further recrystallized using acetonitrile, and the crystal was dried under reduced pressure at 50°C, threby obtaining a yellow solid (70 mg, yield: 0.6%). The metal complex MC12 showed a HPLC area percentage value of 99.5% or more. The resultant metal complex MC13 was further recrystallized using a mixed solvent of dichloromethane, acetonitrile and methanol, and the crystal was dried under reduced pressure at 50 °C, thereby obtaining a yellow solid (120 mg, yield: 1.1%). The metal complex MC13 showed a HPLC area percentage value of 99.5% or more. The resultant metal complex MC14 was further recrystallized using a mixed solvent of dichloromethane and acetonitrile, and the crystal was dried under reduced pressure at 50°C, thereby obtaining a yellow solid (230 mg, yield: 2.1%). The metal complex MC14 showed a HPLC area percentage value of 98.7%.

Metal complex MC12

LC-MS (APCI, positive): m/z = 1815.0 $[M+H]^+$
$^1$H-NMR (300 MHz, $CD_2Cl_2$-$d_2$) $\delta$ (ppm) = 9.19-9.16 (m, 3H), 7.39-7.26 (m, 9H), 6.97-6.88 (m, 15H), 6.72 (t, 3H), 6.61 (t, 3H), 6.52 (d, 3H), 6.44-6.35 (m, 6H), 6.22 (d, 3H), 2.54 (t, 6H), 1.89-1.83 (m, 3H), 1.60-1.50 (m, 6H), 1.43-1.34 (m, 3H), 1.30-1.24 (m, 18H), 0.86-0.72 (m, 27H), 0.55 (d, 9H), 0.47 (d, 18H) .

Metal complex MC13

LC-MS (ESI, positive): m/z = 1852.9 $[M+K]^+$
$^1$H-NMR (300 MHz, $CD_2Cl_2$-$d_2$ ) $\delta$ (ppm) = 7.96 (d, 1H), 7.46 (t, 1H), 7.37 (d, 1H), 7.29-6.36 (m, 41H), 6.22 (d, 1H), 2.62 (t, 2H), 2.53 (t, 2H), 2.48-2.31 (m, 4H), 2.21-2.06 (m, 1H), 1.90-1.74 (m, 1H), 1.67-1.57 (m, 2H), 1.37-1.15 (m, 27H), 1.04 (d, 3H), 0.96-0.91 (m, 6H), 0.87-0.73 (m, 15H), 0.65-0.51 (m, 12H), 0.35 (d, 3H), 0.26 (d, 3H).

Metal complex MC14

LC-MS (ESI, positive): m/z = 1852.9 $[M+K]^+$
$^1$H-NMR (300 MHz, $CD_2Cl_2$-$d_2$) $\delta$ (ppm) = 7.47-7.33 (m, 4H), 7.28-7.18 (m, 4H), 7.11-6.78 (25 H), 6.67-6.51 (m, 9H), 6.31 (d, 1H), 6.21 (d, 2H), 2.63-2.50 (m, 3H), 2.43-2.37 (m, 4H), 2.30-2.19 (m, 1H), 2.18-2.06 (m, 1H), 2.05-1.97 (m, 1H), 1.65-1.53 (m, 2H), 1.42-1.15 (m, 27H), 1.05-1.01 (m, 3H), 0.97-0.93 (m, 3H), 0.87-0.76 (m, 18H), 0.72-0.64 (m, 9H), 0.62-0.56 (m, 6H), 0.43 (d, 3H).

<Synthesis Example 1> Synthesis of monomer CM1

[Chemical Formula 120]

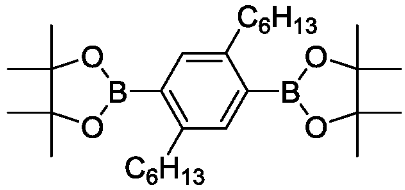

CM1

The monomer CM1 was synthesized according to a method described in JP-A No. 2010-189630.

<Synthesis Example 2> Synthesis of monomer CM2

[Chemical Formula 121]

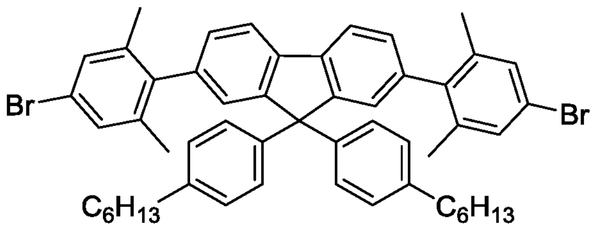

CM2

The monomer CM2 was synthesized according to a method described in International Publication WO2015/008851.

<Synthesis Example 3> Synthesis of polymer compound P1

A nitrogen gas atmosphere was prepared in a reaction vessel, then, a compound CM1 (1.28 g), a compound CM2 (2.18 g) and toluene (55 mL) were added, and the mixture was heated at 80°C. Thereafter, to this were added bis[tris(2-methoxyphenyl)phosphine]palladium dichloride (2.34 mg) and a 20 wt% tetraethylammonium hydroxide aqueous solution (9.1 g), and the mixture was stirred for 4 hours under argon gas reflux. Thereafter, to this were added 2-isopropylphenylboronic acid (0.0630 g), bis[tris(2-methoxyphenyl)phosphine]palladium dichloride (2.17 mg) and a 20 wt% tetraethylammonium hydroxide aqueous solution (9.1 g), and the mixture was stirred for 15.5 hours under argon gas reflux. Thereafter, to this was added a solution prepared by dissolving sodium N,N-diethyldithiocarbamate trihydrate (0.72 g) in ion exchanged water (14 mL), and the mixture was stirred at 85°C for 5 hours. The resultant organic layer was cooled, then, washed with 3.6 wt% hydrochloric acid twice, with 2.5 wt% ammonia water twice, and with ion exchanged water five times, in series. The resultant organic layer was dropped into methanol, thereby finding generation of a precipitate. The resultant precipitate was filtered, and dried, thereby obtaining a solid. The resultant solid was dissolved in toluene, and the solution was allowed to pass through a silica gel column and an alumina column through which toluene had passed previously. The resultant solution was dropped into methanol, thereby causing generation of a precipitate, and the precipitate was collected by filtration and dried, thereby obtaining a polymer compound P1 (2.279 g). The polymer compound P1 had a polystyrene equivalent number-average molecular weight (Mn) and a weight-average molecular weight (Mw) of $Mn=7.4\times10^4$ and $Mw=2.3x10^5$, respectively.

The polymer compound P1 is a copolymer constituted of constitutional units derived from respective monomers at a molar ratio shown in Table 2 below according to the theoretical values calculated from charged raw materials.

[Table 2]

| P1 | monomer | CM1 | CM2 |
|---|---|---|---|
| | molar ratio [mol%] | 50 | 50 |

<Measurement Example 1> Measurement of light emission stability

A metal complex MC1 and a compound represented by the formula (H-113) (hereinafter, referred to also as "compound H-113") (manufactured by Luminescence Technology, LT-N4013) were dissolved in toluene at a concentration of 2.0 wt%, thereby preparing a toluene solution (metal complex MC1:compound H-113 = 25 wt%:75 wt%) .

[Chemical Formula 122]

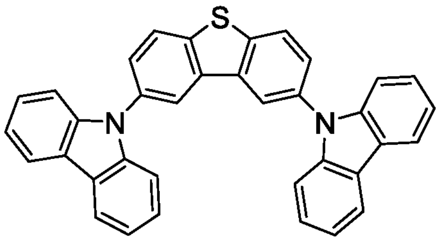

(H-113)

On a glass substrate, the toluene solution obtained above was spin-coated to form a film with a thickness of 75 nm, and the film was heated at 130°C for 10 minutes under a nitrogen gas atmosphere (oxygen concentration: 10 ppm or less, moisture concentration: 10 ppm or less), thereby forming an organic layer.

The substrate carrying the organic layer formed thereon was placed in a vapor deposition machine and the internal pressure was reduced to $1.0 \times 10^{-4}$ Pa or lower, then, aluminum was vapor-deposited thereon with a thickness of about 80 nm. After vapor deposition, encapsulating with a glass substrate was carried out under a nitrogen gas atmosphere (oxygen concentration: 10 ppm or less, moisture concentration: 10 ppm or less), thereby fabricating a measurement sample FL-1.

The excitation light intensity of an excitation light source was regulated in such a manner that the light emission luminance of the measurement sample FL-1 was 2130 cd/$m^2$ . Light emission observed from the measurement sample FL-1 showed the emission spectrum peak at 462 nm and had the chromaticity CIE (x, y) of (0.150, 0.224), indicating that the emission was light emission derived from the metal complex MC1.

Thereafter, the measurement sample FL-1 was allowed to emit light continuously while keeping the regulated excitation light intensity constant, and the time until the light emission luminance reached 85% based on the light emission luminance when initiating measurement (hereinafter, referred to as "LT85") was measured. The results are shown in Table 3.

<Measurement Example 2> Measurement of light emission stability

A measurement sample FL-2 was fabricated in the same manner as in Measurement Example 1, excepting that a metal complex MC2 was used instead of the metal complex MC1 in Measurement Example 1, and light emission stability thereof was measured.

The light emission luminance of the measurement sample FL-2 generating the same photon number as that of light emission of the measurement sample FL-1 was calculated according to the above-described formula (17), thereby finding a value of 2290 cd/$m^2$ .

The excitation light intensity of an excitation light source was regulated in such a manner that the light emission luminance of the measurement sample FL-2 was 2290 cd/$m^2$ . Light emission observed from the measurement sample FL-2 showed the emission spectrum peak at 466 nm and had the chromaticity CIE (x, y) of (0.154, 0.251), indicating that the emission was light emission derived from the metal complex MC2.

Thereafter, the measurement sample FL-2 was allowed to emit light continuously while keeping the regulated excitation light intensity constant, and LT85 thereof was measured. The results are shown in Table 3.

<Measurement Example 3> Measurement of light emission stability

A measurement sample FL-3 was fabricated in the same manner as in Measurement Example 1, excepting that a metal complex MC3 was used instead of the metal complex MC1 in Measurement Example 1, and light emission stability thereof was measured.
The light emission luminance of the measurement sample FL-3 generating the same photon number as that of light emission of the measurement sample FL-1 was calculated according to the above-described formula (17), thereby finding a value of 2570 cd/$m^2$ .
The excitation light intensity of an excitation light source was regulated in such a manner that the light emission luminance of the measurement sample FL-3 was 2570 cd/$m^2$ . Light emission observed from the measurement sample FL-3 showed the emission spectrum peak at 473 nm and had the chromaticity CIE (x, y) of (0.150, 0.315), indicating that the emission was light emission derived from the metal complex MC3.
Thereafter, the measurement sample FL-3 was allowed to emit light continuously while keeping the regulated excitation light intensity constant, and LT85 thereof was measured. The results are shown in Table 3.

<Measurement Example 4> Measurement of light emission stability

A measurement sample FL-4 was fabricated in the same manner as in Measurement Example 1, excepting that a metal complex MC4 was used instead of the metal complex MC1 in Measurement Example 1, and light emission stability thereof was measured.
The light emission luminance of the measurement sample FL-4 generating the same photon number as that of light emission of the measurement sample FL-1 was calculated according to the above-described formula (17), thereby finding a value of 2010 cd/$m^2$ .
The excitation light intensity of an excitation light source was regulated in such a manner that the light emission luminance of the measurement sample FL-4 was 2010 cd/$m^2$ . Light emission observed from the measurement sample FL-4 showed the emission spectrum peak at 455 nm and had the chromaticity CIE (x, y) of (0.149, 0.204), indicating that the emission was light emission derived from the metal complex MC4.
Thereafter, the measurement sample FL-4 was allowed to emit light continuously while keeping the regulated excitation light intensity constant, and LT85 thereof was measured. The results are shown in Table 3.

<Measurement Example 5> Measurement of light emission stability

A measurement sample FL-5 was fabricated in the same manner as in Measurement Example 1, excepting that a metal complex MC5 was used instead of the metal complex MC1 in Measurement Example 1, and light emission stability thereof was measured.
The light emission luminance of the measurement sample FL-5 generating the same photon number as that of light emission of the measurement sample FL-1 was calculated according to the above-described formula (17), thereby finding a value of 2280 cd/$m^2$ .
The excitation light intensity of an excitation light source was regulated in such a manner that the light emission luminance of the measurement sample FL-5 was 2280 cd/$m^2$ . Light emission observed from the measurement sample FL-5 showed the emission spectrum peak at 464 nm and had the chromaticity CIE (x, y) of (0.150, 0.253), indicating that the emission was light emission derived from the metal complex MC5.
Thereafter, the measurement sample FL-5 was allowed to emit light continuously while keeping the regulated excitation light intensity constant, and LT85 thereof was measured. The results are shown in Table 3.

<Measurement Example 6> Measurement of light emission stability

A measurement sample FL-6 was fabricated in the same manner as in Measurement Example 1, excepting that a metal complex MC6 was used instead of the metal complex MC1 in Measurement Example 1, and light emission stability thereof was measured.
The light emission luminance of the measurement sample FL-6 generating the same photon number as that of light emission of the measurement sample FL-1 was calculated according to the above-described formula (17), thereby finding a value of 2460 cd/$m^2$ .
The excitation light intensity of an excitation light source was regulated in such a manner that the light emission luminance of the measurement sample FL-6 was 2460 cd/$m^2$ . Light emission observed from the measurement sample FL-6 showed the emission spectrum peak at 472 nm and had the chromaticity CIE (x, y) of (0.147, 0.296), indicating that the emission was light emission derived from the metal complex MC6.
Thereafter, the measurement sample FL-6 was allowed to emit light continuously while keeping the regulated

excitation light intensity constant, and LT85 thereof was measured. The results are shown in Table 3.

<Measurement Example 7> Measurement of light emission stability

A measurement sample FL-7 was fabricated in the same manner as in Measurement Example 1, excepting that a metal complex MC7 was used instead of the metal complex MC1 in Measurement Example 1, and light emission stability thereof was measured.

The light emission luminance of the measurement sample FL-7 generating the same photon number as that of light emission of the measurement sample FL-1 was calculated according to the above-described formula (17), thereby finding a value of 2560 cd/$m^2$ .

The excitation light intensity of an excitation light source was regulated in such a manner that the light emission luminance of the measurement sample FL-7 was 2560 cd/$m^2$ . Light emission observed from the measurement sample FL-7 showed the emission spectrum peak at 474 nm and had the chromaticity CIE (x, y) of (0.150, 0.315), indicating that the emission was light emission derived from the metal complex MC7.

Thereafter, the measurement sample FL-7 was allowed to emit light continuously while keeping the regulated excitation light intensity constant, and LT85 thereof was measured. The results are shown in Table 3.

<Measurement Example 8> Measurement of light emission stability

A measurement sample FL-8 was fabricated in the same manner as in Measurement Example 1, excepting that a metal complex MC8 was used instead of the metal complex MC1 in Measurement Example 1, and light emission stability thereof was measured.

The light emission luminance of the measurement sample FL-8 generating the same photon number as that of light emission of the measurement sample FL-1 was calculated according to the above-described formula (17), thereby finding a value of 2480 cd/$m^2$ .

The excitation light intensity of an excitation light source was regulated in such a manner that the light emission luminance of the measurement sample FL-8 was 2480 cd/$m^2$ . Light emission observed from the measurement sample FL-8 showed the emission spectrum peak at 472 nm and had the chromaticity CIE (x, y) of (0.150, 0.300), indicating that the emission was light emission derived from the metal complex MC8.

Thereafter, the measurement sample FL-8 was allowed to emit light continuously while keeping the regulated excitation light intensity constant, and LT85 thereof was measured. The results are shown in Table 3.

<Measurement Example 9> Measurement of light emission stability

A measurement sample FL-9 was fabricated in the same manner as in Measurement Example 1, excepting that a metal complex MC9 was used instead of the metal complex MC1 in Measurement Example 1, and light emission stability thereof was measured.

The light emission luminance of the measurement sample FL-9 generating the same photon number as that of light emission of the measurement sample FL-1 was calculated according to the above-described formula (17), thereby finding a value of 1890 cd/$m^2$ .

The excitation light intensity of an excitation light source was regulated in such a manner that the light emission luminance of the measurement sample FL-9 was 1890 cd/$m^2$ . Light emission observed from the measurement sample FL-9 showed the emission spectrum peak at 454 nm and had the chromaticity CIE (x, y) of (0.149, 0.190), indicating that the emission was light emission derived from the metal complex MC9.

Thereafter, the measurement sample FL-9 was allowed to emit light continuously while keeping the regulated excitation light intensity constant, and LT85 thereof was measured. The results are shown in Table 3.

<Measurement Example 10> Measurement of light emission stability

A measurement sample FL-10 was fabricated in the same manner as in Measurement Example 1, excepting that a metal complex MC10 was used instead of the metal complex MC1 in Measurement Example 1, and light emission stability thereof was measured.

The light emission luminance of the measurement sample FL-10 generating the same photon number as that of light emission of the measurement sample FL-1 was calculated according to the above-described formula (17), thereby finding a value of 2530 cd/$m^2$.

The excitation light intensity of an excitation light source was regulated in such a manner that the light emission luminance of the measurement sample FL-10 was 2530 cd/$m^2$ . Light emission observed from the measurement sample FL-10 showed the emission spectrum peak at 473 nm and had the chromaticity CIE (x, y) of (0.149, 0.309), indicating

that the emission was light emission derived from the metal complex MC10.

Thereafter, the measurement sample FL-10 was allowed to emit light continuously while keeping the regulated excitation light intensity constant, and LT85 thereof was measured. The results are shown in Table 3.

<Measurement Example 11> Measurement of light emission stability

A measurement sample FL-11 was fabricated in the same manner as in Measurement Example 1, excepting that a metal complex MC12 was used instead of the metal complex MC1 in Measurement Example 1, and light emission stability thereof was measured.

The light emission luminance of the measurement sample FL-11 generating the same photon number as that of light emission of the measurement sample FL-1 was calculated according to the above-described formula (17), thereby finding a value of 1950 cd/$m^2$.

The excitation light intensity of an excitation light source was regulated in such a manner that the light emission luminance of the measurement sample FL-11 was 1950 cd/$m^2$. Light emission observed from the measurement sample FL-11 showed the emission spectrum peak at 455 nm and had the chromaticity CIE (x, y) of (0.157, 0.199), indicating that the emission was light emission derived from the metal complex MC12.

Thereafter, the measurement sample FL-11 was allowed to emit light continuously while keeping the regulated excitation light intensity constant, and LT85 thereof was measured. The results are shown in Table 3.

<Measurement Example 12> Measurement of light emission stability

A measurement sample FL-12 was fabricated in the same manner as in Measurement Example 1, excepting that a metal complex MC13 was used instead of the metal complex MC1 in Measurement Example 1, and light emission stability thereof was measured.

The light emission luminance of the measurement sample FL-12 generating the same photon number as that of light emission of the measurement sample FL-1 was calculated according to the above-described formula (17), thereby finding a value of 1870 cd/$m^2$.

The excitation light intensity of an excitation light source was regulated in such a manner that the light emission luminance of the measurement sample FL-12 was 1870 cd/$m^2$. Light emission observed from the measurement sample FL-12 showed the emission spectrum peak at 456 nm and had the chromaticity CIE (x, y) of (0.148, 0.192), indicating that the emission was light emission derived from the metal complex MC13.

Thereafter, the measurement sample FL-12 was allowed to emit light continuously while keeping the regulated excitation light intensity constant, and LT85 thereof was measured. The results are shown in Table 3.

<Measurement Example 13> Measurement of light emission stability

A measurement sample FL-13 was fabricated in the same manner as in Measurement Example 1, excepting that a metal complex MC14 was used instead of the metal complex MC1 in Measurement Example 1, and light emission stability thereof was measured.

The light emission luminance of the measurement sample FL-13 generating the same photon number as that of light emission of the measurement sample FL-1 was calculated according to the above-described formula (17), thereby finding a value of 1910 cd/$m^2$.

The excitation light intensity of an excitation light source was regulated in such a manner that the light emission luminance of the measurement sample FL-13 was 1910 cd/$m^2$. Light emission observed from the measurement sample FL-13 showed the emission spectrum peak at 455 nm and had the chromaticity CIE (x, y) of (0.148, 0.196), indicating that the emission was light emission derived from the metal complex MC14.

Thereafter, the measurement sample FL-13 was allowed to emit light continuously while keeping the regulated excitation light intensity constant, and LT85 thereof was measured. The results are shown in Table 3.

<Comparative Measurement Example 1> Measurement of light emission stability

A measurement sample CFL-1 was fabricated in the same manner as in Measurement Example 1, excepting that a metal complex MM1 was used instead of the metal complex MC1 in Measurement Example 1, and light emission stability thereof was measured.

The light emission luminance of the measurement sample CFL-1 generating the same photon number as that of light emission of the measurement sample FL-1 was calculated according to the above-described formula (17), thereby finding a value of 1980 cd/$m^2$.

The excitation light intensity of an excitation light source was regulated in such a manner that the light emission

luminance of the measurement sample CFL-1 was 1980 cd/$m^2$. Light emission observed from the measurement sample CFL-1 showed the emission spectrum peak at 461 nm and had the chromaticity CIE (x, y) of (0.146, 0.203), indicating that the emission was light emission derived from the metal complex MM1.

Thereafter, the measurement sample CFL-1 was allowed to emit light continuously while keeping the regulated excitation light intensity constant, and LT85 thereof was measured. The results are shown in Table 3.

<Comparative Measurement Example 2> Measurement of light emission stability

A measurement sample CFL-2 was fabricated in the same manner as in Measurement Example 1, excepting that a metal complex MM2 was used instead of the metal complex MC1 in Measurement Example 1, and light emission stability thereof was measured.

The light emission luminance of the measurement sample CFL-2 generating the same photon number as that of light emission of the measurement sample FL-1 was calculated according to the above-described formula (17), thereby finding a value of 2490 cd/$m^2$.

The excitation light intensity of an excitation light source was regulated in such a manner that the light emission luminance of the measurement sample CFL-2 was 2490 cd/$m^2$. Light emission observed from the measurement sample CFL-2 showed the emission spectrum peak at 474 nm and had the chromaticity CIE (x, y) of (0.149, 0.299), indicating that the emission was light emission derived from the metal complex MM2.

Thereafter, the measurement sample CFL-2 was allowed to emit light continuously while keeping the regulated excitation light intensity constant, and LT85 thereof was measured. The results are shown in Table 3.

<Comparative Measurement Example 3> Measurement of light emission stability

A measurement sample CFL-3 was fabricated in the same manner as in Measurement Example 1, excepting that a metal complex MM3 was used instead of the metal complex MC1 in Measurement Example 1, and light emission stability thereof was measured.

The light emission luminance of the measurement sample CFL-3 generating the same photon number as that of light emission of the measurement sample FL-1 was calculated according to the above-described formula (17), thereby finding a value of 2070 cd/$m^2$.

The excitation light intensity of an excitation light source was regulated in such a manner that the light emission luminance of the measurement sample CFL-3 was 2070 cd/$m^2$. Light emission observed from the measurement sample CFL-3 showed the emission spectrum peak at 455 nm and had the chromaticity CIE (x, y) of (0.153, 0.214), indicating that the emission was light emission derived from the metal complex MM3.

Thereafter, the measurement sample CFL-3 was allowed to emit light continuously while keeping the regulated excitation light intensity constant, and LT85 thereof was measured. The results are shown in Table 3.

<Measurement Example 14> Measurement of light emission stability

A measurement sample FL-14 was fabricated in the same manner as in Measurement Example 1, excepting that a metal complex MC11 was used instead of the metal complex MC1 in Measurement Example 1, and light emission stability thereof was measured.

The excitation light intensity of an excitation light source was regulated so that the light emission luminance of the measurement sample FL-14 was 430 cd/$m^2$. Light emission observed from the measurement sample FL-14 showed the emission spectrum peak at 480 nm and had the chromaticity CIE (x, y) of (0.164, 0.300), indicating that the emission was light emission derived from the metal complex MC11.

Thereafter, the measurement sample FL-14 was allowed to emit light continuously while keeping the regulated excitation light intensity constant, and LT85 thereof was measured. The results are shown in Table 4.

<Comparative Measurement Example 4> Measurement of light emission stability

A measurement sample CFL-4 was fabricated in the same manner as in Measurement Example 1, excepting that a metal complex MM3 was used instead of the metal complex MC1 in Measurement Example 1, and light emission stability thereof was measured.

The light emission luminance of the measurement sample CFL-4 generating the same photon number as that of light emission of the measurement sample FL-14 was calculated according to the above-described formula (17), thereby finding a value of 430 cd/$m^2$.

The excitation light intensity of an excitation light source was regulated in such a manner that the light emission luminance of the measurement sample CFL-4 was 430 cd/$m^2$. Light emission observed from the measurement sample

CFL-4 showed the emission spectrum peak at 455 nm and had the chromaticity CIE (x, y) of (0.153, 0.214), indicating that the emission was light emission derived from the metal complex MM3.

Thereafter, the measurement sample CFL-4 was allowed to emit light continuously while keeping the regulated excitation light intensity constant, and LT85 thereof was measured. The results are shown in Table 4.

<Measurement Example 15> Measurement of light emission stability

A measurement sample FL-15 was fabricated in the same manner as in Measurement Example 1, excepting that a metal complex MC6 and a polymer compound P1 were used instead of the metal complex MC1 and the compound H-113 in Measurement Example 1, and light emission stability thereof was measured.

The excitation light intensity of an excitation light source was regulated in such a manner that the light emission luminance of the measurement sample FL-15 was 2460 cd/$m^2$. Light emission observed from the measurement sample FL-15 showed the emission spectrum peak at 472 nm and had the chromaticity CIE (x, y) of (0.143, 0.265), indicating that the emission was light emission derived from the metal complex MC6.

Thereafter, the measurement sample FL-15 was allowed to emit light continuously while keeping the regulated excitation light intensity constant, and LT85 thereof was measured. The results are shown in Table 5.

<Comparative Measurement Example 5> Measurement of light emission stability

A measurement sample CFL-5 was fabricated in the same manner as in Measurement Example 1, excepting that a metal complex MM2 and a polymer compound P1 were used instead of the metal complex MC1 and the compound H-113 in Measurement Example 1, and light emission stability thereof was measured.

The light emission luminance of the measurement sample CFL-5 generating the same photon number as that of light emission of the measurement sample FL-15 was calculated according to the above-described formula (17), thereby finding a value of 2490 cd/$m^2$.

The excitation light intensity of an excitation light source was regulated in such a manner that the light emission luminance of the measurement sample CFL-5 was 2490 cd/$m^2$. Light emission observed from the measurement sample CFL-5 showed the emission spectrum peak at 474 nm and had the chromaticity CIE (x, y) of (0.147, 0.271), indicating that the emission was light emission derived from the metal complex MM2.

Thereafter, the measurement sample CFL-5 was allowed to emit light continuously while keeping the regulated excitation light intensity constant, and LT85 thereof was measured. The results are shown in Table 5.

[Table 3]

| measure -ment sample | metal complex | weight [%] | low molecular weight host | weight [%] | LT85 [hr] | light emission peak wavelength [nm] | chromaticity coordinate CIE (x, y) | |
|---|---|---|---|---|---|---|---|---|
| FL-1 | MC1 | 25 | compound H-113 | 75 | 10.5 | 462 | (0.150, 0.224) | example |
| FL-2 | MC2 | 25 | compound H-113 | 75 | 8.88 | 466 | (0.154, 0.251) | example |
| FL-3 | MC3 | 25 | compound H-113 | 75 | 29.0 | 473 | (0.150, 0.315) | example |
| FL-4 | MC4 | 25 | compound H-113 | 75 | 6.27 | 455 | (0.149, 0.204) | example |
| FL-5 | MC5 | 25 | compound H-113 | 75 | 8.90 | 464 | (0.150, 0.253) | example |
| FL-6 | MC6 | 25 | compound H-113 | 75 | 29.7 | 472 | (0.147, 0.296) | example |
| FL-7 | MC7 | 25 | compound H-113 | 75 | 13.8 | 474 | (0.150, 0.315) | example |

(continued)

| measure -ment sample | metal complex | weight [%] | low molecular weight host | weight [%] | LT85 [hr] | light emission peak wavelength [nm] | chromaticity coordinate CIE (x, y) | |
|---|---|---|---|---|---|---|---|---|
| FL-8 | MC8 | 25 | compound H-113 | 75 | 5.27 | 472 | (0.150, 0.300) | example |
| FL-9 | MC9 | 25 | compound H-113 | 75 | 4.78 | 454 | (0.149, 0.190) | example |
| FL-10 | MC10 | 25 | compound H-113 | 75 | 27.2 | 473 | (0.149, 0.309) | example |
| FL-11 | MC12 | 25 | compound H-113 | 75 | 2.23 | 455 | (0.157, 0.199) | example |
| FL-12 | MC13 | 25 | compound H-113 | 75 | 5.79 | 456 | (0.148, 0.192) | example |
| FL-13 | MC14 | 25 | compound H-113 | 75 | 3.38 | 455 | (0.148, 0.196) | example |
| CFL-1 | MM1 | 25 | compound H-113 | 75 | 0.97 | 461 | (0.146, 0.203) | comparative example |
| CFL-2 | MM2 | 25 | compound H-113 | 75 | 1.46 | 474 | (0.149, 0.299) | comparative example |
| CFL-3 | MM3 | 25 | compound H-113 | 75 | 0.05 | 455 | (0.153, 0.214) | comparative example |

[Table 4]

| measure -ment sample | metal complex | weight [%] | low Molecular weight host | weight [%] | LT85 [hr] | light emission peak wavelength [nm] | chromaticity coordinate CIE (x, y) | |
|---|---|---|---|---|---|---|---|---|
| FL-14 | MC11 | 25 | compound H-113 | 75 | 23.3 | 480 | (0.164, 0.300) | example |
| CFL-4 | MM3 | 25 | compound H-113 | 75 | 1.26 | 455 | (0.153, 0.214) | Comparative example |

[Table 5]

| measure -ment sample | metal complex | weight [%] | polymer host | weight [%] | LT85 [hr] | light emission peak wavelength [nm] | chromaticity coordinate CIE (x, y) | |
|---|---|---|---|---|---|---|---|---|
| FL-15 | MC6 | 25 | P1 | 75 | 0.44 | 472 | (0.143, 0.265) | example |
| CFL-5 | MM2 | 25 | P1 | 75 | 0.11 | 474 | (0.147, 0.271) | Comparative example |

It is understood from these results that the metal complexes of the present invention (the metal complex MC1,

the metal complex MC2, the metal complex MC3, the metal complex MC4, the metal complex MC5, the metal complex MC6, the metal complex MC7, the metal complex MC8, the metal complex MC9, the metal complex MC10, the metal complex MC11, the metal complex MC12, the metal complex MC13 and the metal complex MC14) are excellent in light emission stability as compared with the metal complex MM1, the metal complex MM2 and the metal complex MM3.

Industrial Applicability

According to the present invention, a metal complex excellent in light emission stability can be provided. Further, according to the present invention, a composition comprising the metal complex and a light emitting device produced by using the metal complex can be provided. A light emitting device obtained by using the metal complex has excellent luminance life because the metal complex of the present invention is excellent in light emission stability.

## Claims

1. A metal complex represented by the following formula (1-b) :

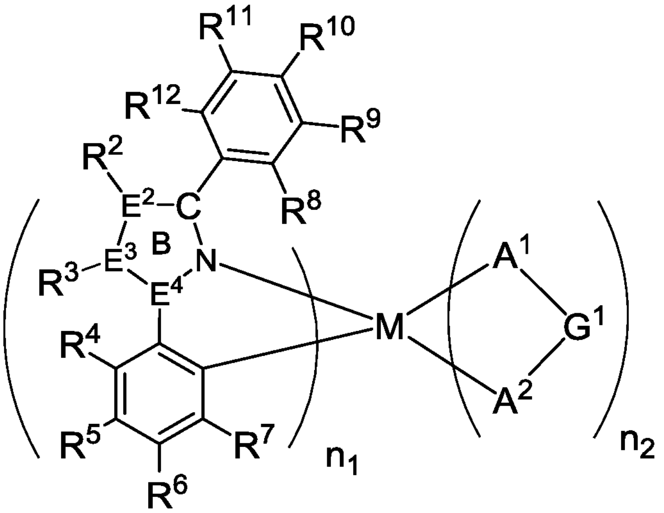

(1-b)

wherein

M represents an iridium atom or a platinum atom,
$n_1$ represents 1, 2 or 3, $n_2$ represents 0, 1 or 2, and $n_1$+$n_2$ is 3 when M is an iridium atom, while $n_1$+$n_2$ is 2 when M is a platinum atom,
$E^2$ and $E^3$ represent a nitrogen atom, and $E^4$ represents a carbon atom, and $R^2$ and $R^3$ may be either present or not present,
$R^2$ and $R^3$ each independently represent a hydrogen atom, an alkyl group, a cycloalkyl group, an alkoxy group, a cycloalkoxy group, an aryl group, an aryloxy group, a monovalent heterocyclic group or a halogen atom and these groups each optionally have a substituent, and when a plurality of $R^2$ and $R^3$ are present, they may be the same or different at each occurrence,
$R^4$, $R^5$, $R^6$ and $R^7$ each independently represent a hydrogen atom, an alkyl group, a cycloalkyl group, an alkoxy group, a cycloalkoxy group, an aryl group, an aryloxy group, a monovalent heterocyclic group or a halogen atom and these groups each optionally have a substituent, and when a plurality of $R^4$, $R^5$, $R^6$ and $R^7$ are present, they may be the same or different at each occurrence, and $R^4$ and $R^5$ may be combined together to form a ring together with the carbon atoms to which they are attached, $R^5$ and $R^6$ may be combined together to form a ring together with the carbon atoms to which they are attached, and $R^6$ and $R^7$ may be combined together to form a ring together with the carbon atoms to which they are attached,
$R^8$, $R^{10}$ and $R^{12}$ each independently represent a hydrogen atom, an alkyl group, a cycloalkyl group, an alkoxy group, a cycloalkoxy group, an aryl group, an aryloxy group, a monovalent heterocyclic group or a halogen atom and these groups each optionally have a substituent, and
$R^9$ and $R^{11}$ each independently represent an alkyl group and this alkyl group optionally has a substituent, and when a plurality of $R^8$ , $R^9$ , $R^{10}$ , $R^{11}$ and $R^{12}$ are present, they may be the same or different at each occurrence,

the ring B represents a triazole ring, and
$A^1$-$G^1$-$A^2$ represents an anionic bidentate ligand, $A^1$ and $A^2$ each independently represent a carbon atom, an oxygen atom or a nitrogen atom and these atoms each may be an atom constituting a ring, $G^1$ represents a single bond or an atomic group constituting the bidentate ligand together with $A^1$ and $A^2$, and when a plurality of $A^1$-$G^1$-$A^2$ are present, they may be the same or different.

**2.** The metal complex according to claim 1 represented by the following formula (1-c):

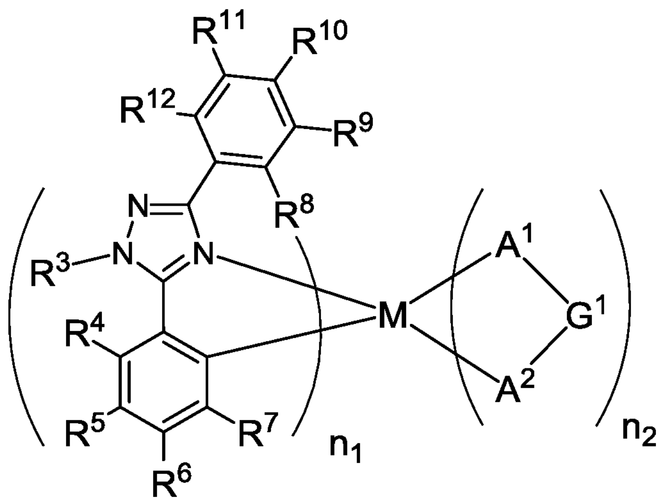

(1-c)

wherein M, $n_1$, $n_2$, $R^3$, $R^4$, $R^5$, $R^6$, $R^7$, $R^8$, $R^9$, $R^{10}$, $R^{11}$, $R^{12}$ and $A^1$-$G^1$-$A^2$ are as defined in claim 1.

**3.** The metal complex according to claim 1 represented by the following formula (1-d):

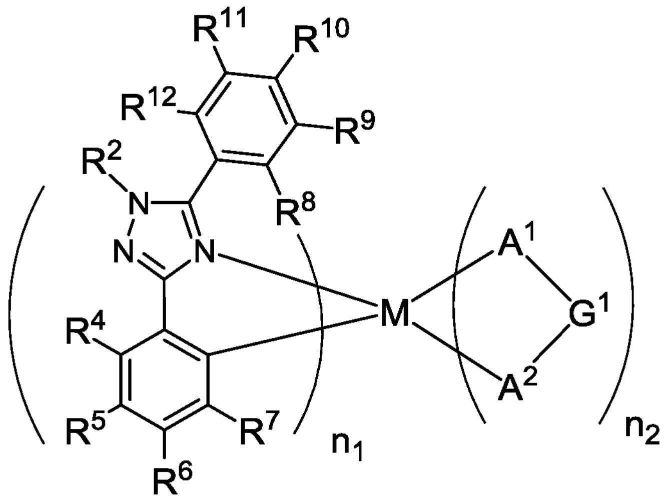

(1-d)

wherein M, $n_1$, $n_2$, $R^2$, $R^4$, $R^5$, $R^6$, $R^7$, $R^8$, $R^9$, $R^{10}$, $R^{11}$, $R^{12}$ and $A^1$-$G^1$-$A^2$ are as defined in claim 1.

**4.** The metal complex according to claim 2 represented by the following formula (1-e):

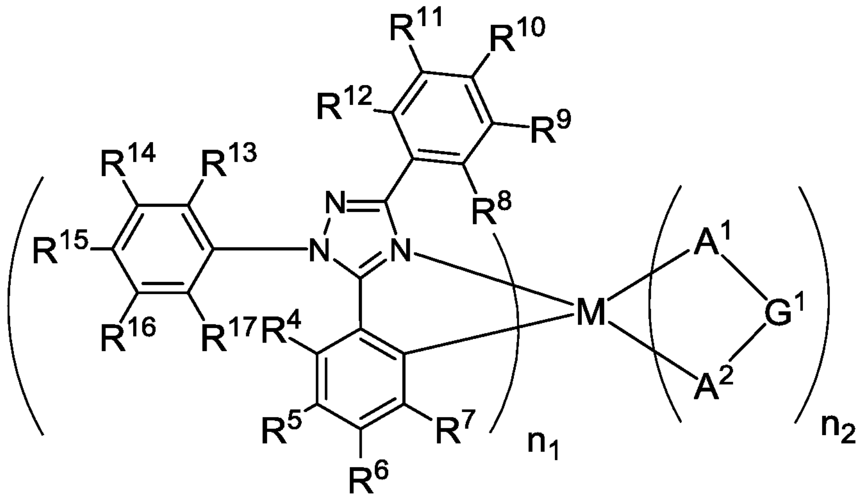

(1-e)

wherein

M, $n_1$, $n_2$, $R^4$, $R^5$, $R^6$, $R^7$, $R^8$, $R^9$, $R^{10}$, $R^{11}$, $R^{12}$ and $A^1$-$G^1$-$A^2$ are as defined in claim 1, and
$R^{13}$, $R^{14}$, $R^{15}$, $R^{16}$ and $R^{17}$ each independently represent a hydrogen atom, an alkyl group, a cycloalkyl group, an alkoxy group, a cycloalkoxy group, an aryl group, an aryloxy group, a monovalent heterocyclic group or a halogen atom and these groups each optionally have a substituent, and when a plurality of $R^{13}$, $R^{14}$, $R^{15}$, $R^{16}$ and $R^{17}$ are present, they may be the same or different at each occurrence, and $R^{13}$ and $R^{14}$ may be combined together to form a ring together with the carbon atoms to which they are attached, $R^{14}$ and $R^{15}$ may be combined together to form a ring together with the carbon atoms to which they are attached, $R^{15}$ and $R^{16}$ may be combined together to form a ring together with the carbon atoms to which they are attached, and $R^{16}$ and $R^{17}$ may be combined together to form a ring together with the carbon atoms to which they are attached.

5. The metal complex according to any one of claims 1 to 4, wherein at least one selected from the group consisting of $R^2$, $R^3$, $R^5$, $R^6$, $R^{10}$ and $R^{15}$ is a dendron.

6. The metal complex according to claim 5, wherein at least one selected from the group consisting of $R^2$, $R^3$, $R^5$, $R^6$, $R^{10}$ and $R^{15}$ is a group represented by the following formula (D-A) or (D-B):

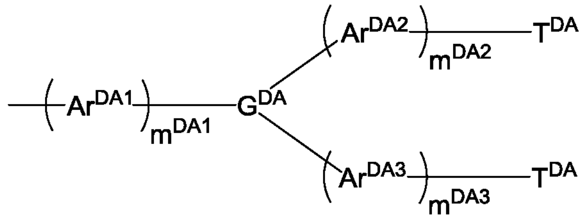

(D-A)

wherein

$m^{DA1}$, $m^{DA2}$ and $m^{DA3}$ each independently represent an integer of 0 or more,
$G^{DA}$ represents an aromatic hydrocarbon group or a heterocyclic group and these groups each optionally have a substituent,
$Ar^{DA1}$, $Ar^{DA2}$ and $Ar^{DA3}$ each independently represent an arylene group or a divalent heterocyclic group and these groups each optionally have a substituent, and when a plurality of $Ar^{DA1}$, $Ar^{DA2}$ and $Ar^{DA3}$ are present, they may be the same or different at each occurrence, and
$T^{DA}$ represents an aryl group or a monovalent heterocyclic group and these groups each optionally have a substituent, and the plurality of $T^{DA}$ may be the same or different:

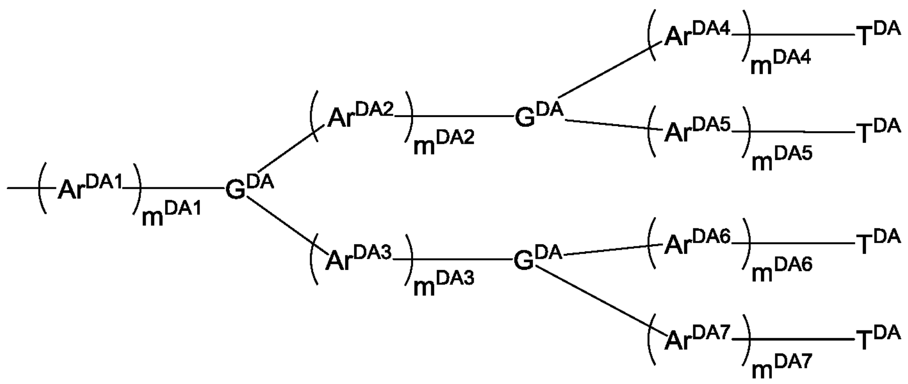

(D-B)

wherein

$m^{DA1}$, $m^{DA2}$, $m^{DA3}$, $m^{DA4}$, $m^{DA5}$, $m^{DA6}$ and $m^{DA7}$ each independently represent an integer of 0 or more,
$G^{DA}$ represents an aromatic hydrocarbon group or a heterocyclic group and these groups each optionally have a substituent, and the plurality of $G^{DA}$ may be the same or different,
$Ar^{DA1}$, $Ar^{DA2}$, $Ar^{DA3}$, $Ar^{DA4}$, $Ar^{DA5}$, $Ar^{DA6}$ and $Ar^{DA7}$ each independently represent an arylene group or a divalent heterocyclic group and these groups each optionally have a substituent, and when a plurality of $Ar^{DA1}$, $Ar^{DA2}$, $Ar^{DA3}$, $Ar^{DA4}$, $Ar^{DA5}$, $Ar^{DA6}$ and $Ar^{DA7}$ are present, they may be the same or different at each occurrence, and
$T^{DA}$ represents an aryl group or a monovalent heterocyclic group and these groups each optionally have a substituent, and the plurality of $T^{DA}$ may be the same or different.

**7.** The metal complex according to claim 6, wherein the group represented by the formula (D-A) is a group represented by the following formula (D-A1), (D-A2) or (D-A3) :

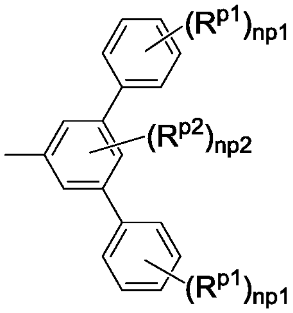

(D-A1)

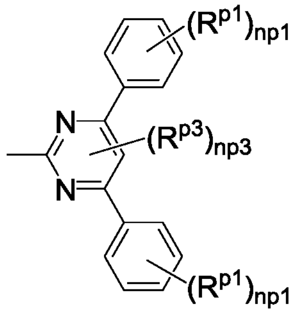

(D-A2)

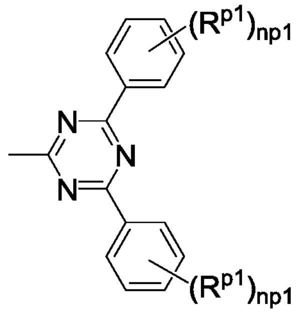

(D-A3)

wherein

$R^{p1}$, $R^{p2}$ and $R^{p3}$ each independently represent an alkyl group, a cycloalkyl group or a halogen atom, and when a plurality of $R^{p1}$ and $R^{p2}$ are present, they may be the same or different at each occurrence, and at least one selected from among the plurality of $R^{p1}$ is an alkyl group having 4 or more carbon atoms, and
np1 represents an integer of 1 to 5, np2 represents an integer of 0 to 3, and np3 represents 0 or 1, and the plurality of np1 may be the same or different.

**8.** The metal complex according to claim 7, wherein the group represented by the formula (D-A) is a group represented by the formula (D-A1).

**9.** The metal complex according to any one of claims 1 to 8, wherein M is an iridium atom.

**10.** The metal complex according to claim 9, wherein $n_1$ is 3.

**11.** A composition comprising the metal complex according to any one of claims 1 to 10 and either a compound represented by the following formula (H-1):

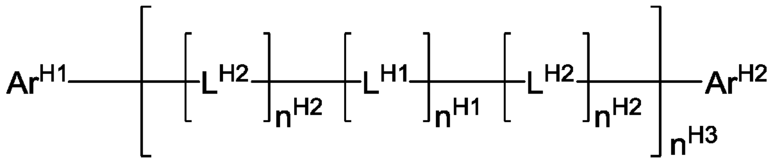

(H-1)

wherein

$Ar^{H1}$ and $Ar^{H2}$ each independently represent an aryl group or a monovalent heterocyclic group and these groups each optionally have a substituent,
$n^{H1}$ and $n^{H2}$ each independently represent 0 or 1, and when a plurality of $n^{H1}$ are present, they may be the same or different, and the plurality of $n^{H2}$ may be the same or different,
$n^{H3}$ represents an integer of 0 or more,
$L^{H1}$ represents an arylene group, a divalent heterocyclic group or a group represented by - $[C(R^{H11})_2]n^{H11}$-, and these groups each optionally have a substituent, and when a plurality of $L^{H1}$ are present, they may be the same or different,
$n^{H11}$ represents an integer of 1 to 10, and $R^{H11}$ represents a hydrogen atom, an alkyl group, a cycloalkyl group, an alkoxy group, a cycloalkoxy group, an aryl group or a monovalent heterocyclic group and these groups each optionally have a substituent, and the plurality of $R^{H11}$ may be the same or different and may be combined together to form a ring together with the carbon atoms to which they are attached,
$L^{H2}$ represents a group represented by $-N(-L^{H21}-R^{H21})-$, and when a plurality of $L^{H2}$ are present, they may be the same or different, and
$L^{H21}$ represents a single bond, an arylene group or a divalent heterocyclic group and these groups each optionally have a substituent, and $R^{H21}$ represents a hydrogen atom, an alkyl group, a cycloalkyl group, an aryl group or a monovalent heterocyclic group and these groups each optionally has a substituent, or
a polymer compound comprising a constitutional unit represented by the following formula (Y):

$$-[Ar^{Y1}]- \qquad (Y)$$

wherein $Ar^{Y1}$ represents an arylene group, a divalent heterocyclic group or a divalent group in which at least one arylene group and at least one divalent heterocyclic group are bonded directly to each other, and these groups each optionally have a substituent, or
at least one material selected from the group consisting of a hole transporting material, a hole injection material, an electron transporting material, an electron injection material, a light emitting material, an antioxidant and a solvent.

**12.** A light emitting device produced by using the metal complex according to any one of claims 1 to 10.

## Patentansprüche

**1.** Metallkomplex, dargestellt durch die folgende Formel (1-b):

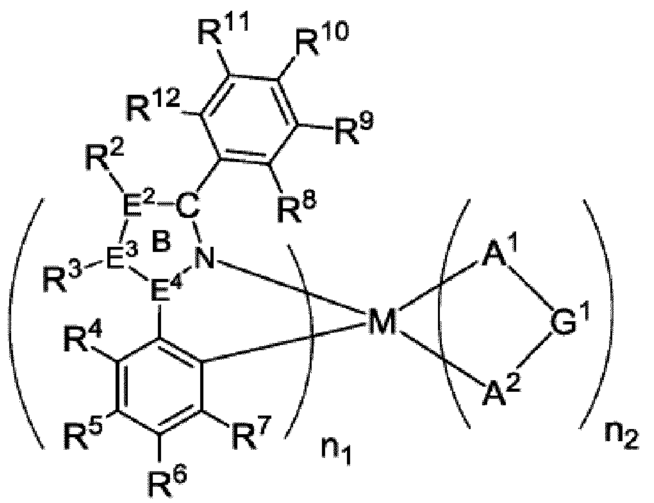

(1-b)

wobei

M für ein Iridiumatom oder ein Platinatom steht,
$n_1$ für 1, 2 oder 3 steht, $n_2$ für 0, 1 oder 2 steht, und $n_1+n_2$ 3 ist, wenn M ein Iridiumatom ist, wohingegen $n_1+n_2$ 2 ist, wenn M ein Platinatom ist,
$E^2$ und $E^3$ für ein Stickstoffatom stehen, und $E^4$ für ein Kohlenstoffatom steht, und $R^2$ und $R^3$ entweder vorhanden oder nicht vorhanden sein können,
$R^2$ und $R^3$ jeweils unabhängig für ein Wasserstoffatom, eine Alkylgruppe, eine Cycloalkylgruppe, eine Alkoxygruppe, eine Cycloalkoxygruppe, eine Arylgruppe, eine Aryloxygruppe, eine einwertige heterocyclische Gruppe oder ein Halogenatom stehen und diese Gruppen jeweils wahlweise einen Substituenten aufweisen, und wenn mehrere $R^2$ und $R^3$ vorhanden sind, diese gleich oder verschieden bei jedem Auftreten sein können,
$R^4$, $R^5$, $R^6$ und $R^7$ jeweils unabhängig für ein Wasserstoffatom, eine Alkylgruppe, eine Cycloalkylgruppe, eine Alkoxygruppe, eine Cycloalkoxygruppe, eine Arylgruppe, eine Aryloxygruppe, eine einwertige heterocyclische Gruppe oder ein Halogenatom stehen und diese Gruppen jeweils wahlweise einen Substituenten aufweisen, und wenn mehrere $R^4$, $R^5$, $R^6$ und $R^7$ vorhanden sind, diese gleich oder verschieden bei jedem Auftreten sein können, und $R^4$ und $R^5$ miteinander kombiniert sein können, damit sie zusammen mit den Kohlenstoffatomen, an die sie gebunden sind, einen Ring bilden, $R^5$ und $R^6$ miteinander kombiniert sein können, damit sie zusammen mit den Kohlenstoffatomen, an die sie gebunden sind, einen Ring bilden, und $R^6$ und $R^7$ miteinander kombiniert sein können, damit sie zusammen mit den Kohlenstoffatomen, an die sie gebunden sind, einen Ring bilden,
$R^8$, $R^{10}$ und $R^{12}$ jeweils unabhängig für ein Wasserstoffatom, eine Alkylgruppe, eine Cycloalkylgruppe, eine Alkoxygruppe, eine Cycloalkoxygruppe, eine Arylgruppe, eine Aryloxygruppe, eine einwertige heterocyclische Gruppe oder ein Halogenatom stehen und diese Gruppen jeweils wahlweise einen Substituenten aufweisen, und $R^9$ und $R^{11}$ jeweils unabhängig für eine Alkylgruppe stehen und diese Alkylgruppe wahlweise einen Substituenten aufweist, und
wenn mehrere $R^8$, $R^9$, $R^{10}$, $R^{11}$ und $R^{12}$ vorhanden sind, diese gleich oder verschieden bei jedem Auftreten sein können,
der Ring B für einen Triazolring steht, und
$A^1$-$G^1$-$A^2$ für einen anionischen zweizähnigen Liganden steht, $A^1$ und $A^2$ jeweils unabhängig für ein Kohlenstoffatom, ein Sauerstoffatom oder ein Stickstoffatom stehen und diese Atome jeweils ein Atom sein können, das einen Ring bildet, $G^1$ für eine Einfachbindung oder eine Atomgruppe steht, die den zweizähnigen Liganden zusammen mit $A^1$ und $A^2$ bildet, und wenn mehrere $A^1$-$G^1$-$A^2$ vorhanden sind, diese gleich oder verschieden sein können.

2. Metallkomplex nach Anspruch 1, dargestellt durch die folgende Formel (1-c):

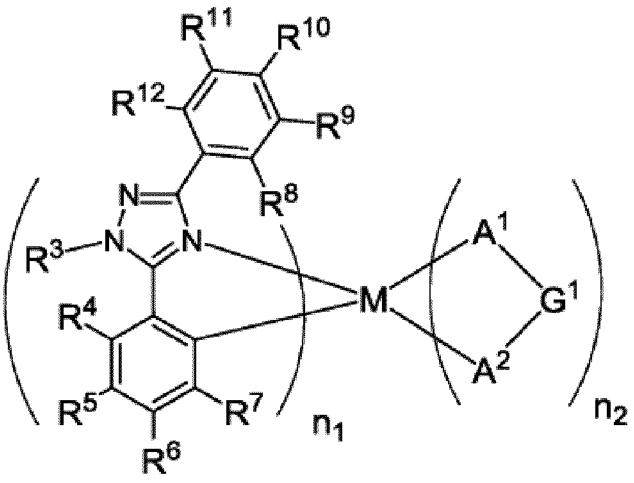

(1-c)

wobei M, $n_1$, $n_2$, $R^3$, $R^4$, $R^5$, $R^6$, $R^7$, $R^8$, $R^9$, $R^{10}$, $R^{11}$, $R^{12}$ und $A^1$-$G^1$-$A^2$ wie in Anspruch 1 definiert sind.

**3.** Metallkomplex nach Anspruch 1, dargestellt durch die folgende Formel (1-d):

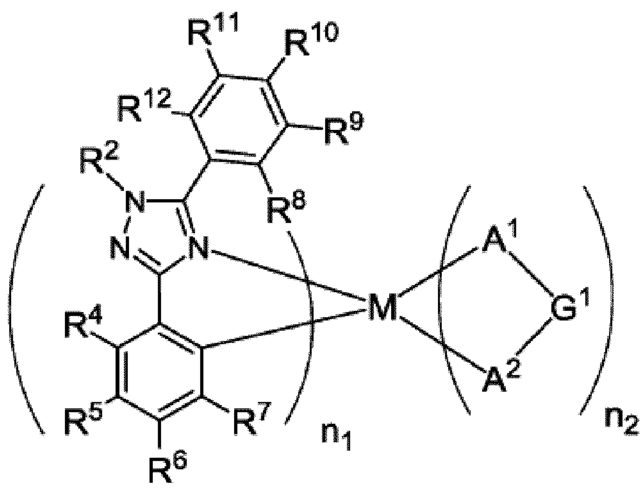

(1-d)

wobei M, $n_1$, $n_2$, $R^2$, $R^4$, $R^5$, $R^6$, $R^7$, $R^8$, $R^9$, $R^{10}$, $R^{11}$, $R^{12}$ und $A^1$-$G^1$-$A^2$ wie in Anspruch 1 definiert sind.

**4.** Metallkomplex nach Anspruch 2, dargestellt durch die folgende Formel (1-e):

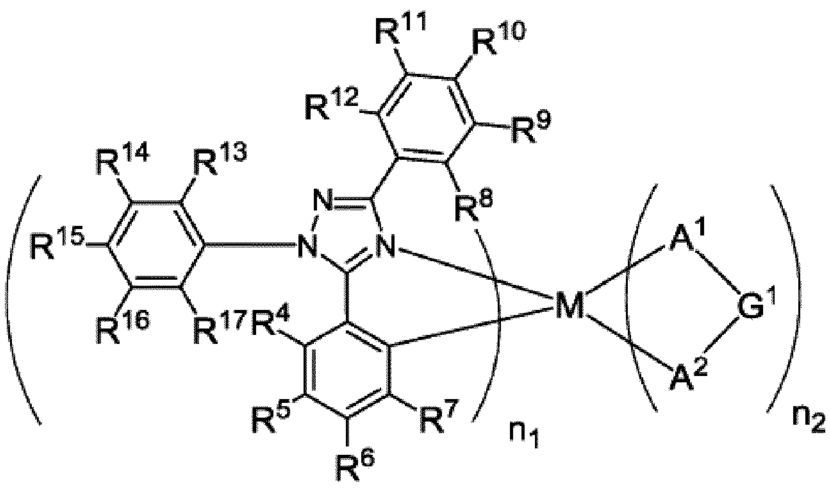

(1-e)

wobei

M, $n_1$, $n_2$, $R^4$, $R^5$, $R^6$, $R^7$, $R^8$, $R^9$, $R^{10}$, $R^{11}$, $R^{12}$ und $A^1$-$G^1$-$A^2$ wie in Anspruch 1 definiert sind, und
$R^{13}$, $R^{14}$, $R^{15}$, $R^{16}$ und $R^{17}$ jeweils unabhängig für ein Wasserstoffatom, eine Alkylgruppe, eine Cycloalkylgruppe, eine Alkoxygruppe, eine Cycloalkoxygruppe, eine Arylgruppe, eine Aryloxygruppe, eine einwertige heterocyclische Gruppe oder ein Halogenatom stehen und diese Gruppen jeweils wahlweise einen Substituenten aufweisen, und wenn mehrere $R^{13}$, $R^{14}$, $R^{15}$, $R^{16}$ und $R^{17}$ vorhanden sind, diese gleich oder verschieden bei jedem Auftreten sein können, und $R^{13}$ und $R^{14}$ miteinander kombiniert sein können, damit sie zusammen mit den Kohlenstoffatomen, an die sie gebunden sind, einen Ring bilden, $R^{14}$ und $R^{15}$ miteinander kombiniert sein können, damit sie zusammen mit den Kohlenstoffatomen, an die sie gebunden sind, einen Ring bilden, $R^{15}$ und $R^{16}$ miteinander kombiniert sein können, damit sie zusammen mit den Kohlenstoffatomen, an die sie gebunden sind, einen Ring bilden, und $R^{16}$ und $R^{17}$ miteinander kombiniert sein können, damit sie zusammen mit den Kohlenstoffatomen, an die sie gebunden sind, einen Ring bilden.

**5.** Metallkomplex nach einem der Ansprüche 1 bis 4, wobei zumindest eines, das aus der Gruppe, bestehend aus $R^2$, $R^3$, $R^5$, $R^6$, $R^{10}$ und $R^{15}$, ausgewählt ist, ein Dendron ist.

**6.** Metallkomplex nach Anspruch 5, wobei zumindest eines, das aus der Gruppe, bestehend aus $R^2$, $R^3$, $R^5$, $R^6$, $R^{10}$ und $R^{15}$, ausgewählt ist, eine Gruppe ist, die durch die folgende Formel (D-A) oder (D-B) dargestellt ist:

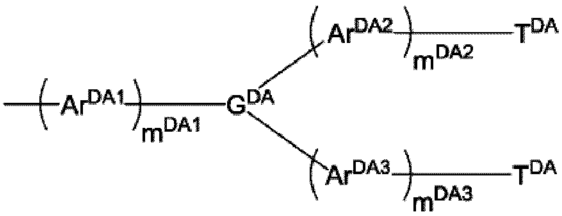

**(D-A)**

wobei

$m^{DA1}$, $m^{DA2}$ und $m^{DA3}$ jeweils unabhängig für eine ganze Zahl von 0 oder mehr stehen,
$G^{DA}$ für eine aromatische Kohlenwasserstoffgruppe oder eine heterocyclische Gruppe steht und diese Gruppen jeweils wahlweise einen Substituenten aufweisen,
$Ar^{DA1}$, $Ar^{DA2}$ und $Ar^{DA3}$ jeweils unabhängig für eine Arylengruppe oder eine zweiwertige heterocyclische Gruppe stehen und diese Gruppen jeweils wahlweise einen Substituenten aufweisen, und wenn mehrere $Ar^{DA1}$, $Ar^{DA2}$ und $Ar^{DA3}$ vorhanden sind, diese gleich oder verschieden bei jedem Auftreten sein können, und
$T^{DA}$ für eine Arylgruppe oder eine einwertige heterocyclische Gruppe steht und diese Gruppen jeweils wahlweise einen Substituenten aufweisen, und die mehreren $T^{DA}$ gleich oder verschieden sein können:

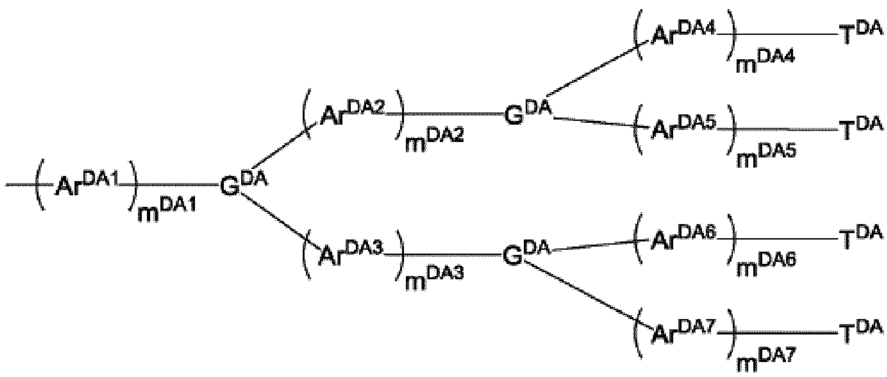

**(D-B)**

wobei

$m^{DA1}$, $m^{DA2}$, $m^{DA3}$ , $m^{DA4}$, $m^{DA5}$, $m^{DA6}$ und $m^{DA7}$ jeweils unabhängig für eine ganze Zahl von 0 oder mehr stehen,
$G^{DA}$ für eine aromatische Kohlenwasserstoffgruppe oder eine heterocyclische Gruppe steht und diese Gruppen jeweils wahlweise einen Substituenten aufweisen, und die mehreren $G^{DA}$ gleich oder verschieden

sein können,
$Ar^{DA1}$, $Ar^{DA2}$, $Ar^{DA3}$, $Ar^{DA4}$, $Ar^{DA5}$, $Ar^{DA6}$ und $Ar^{DA7}$ jeweils unabhängig für eine Arylengruppe oder eine zweiwertige heterocyclische Gruppe stehen und diese Gruppen jeweils wahlweise einen Substituenten aufweisen, und wenn mehrere $Ar^{DA1}$, $Ar^{DA2}$, $Ar^{DA3}$, $Ar^{DA4}$, $Ar^{DA5}$, $Ar^{DA6}$ und $Ar^{DA7}$ vorhanden sind, diese gleich oder verschieden bei jedem Auftreten sein können, und
$T^{DA}$ für eine Arylgruppe oder eine einwertige heterocyclische Gruppe steht und diese Gruppen jeweils wahlweise einen Substituenten aufweisen, und die mehreren $T^{DA}$ gleich oder verschieden sein können.

7. Metallkomplex nach Anspruch 6, wobei die durch die Formel (D-A) dargestellte Gruppe eine durch die folgende Formel (D-A1), (D-A2) oder (D-A3) dargestellte Gruppe ist:

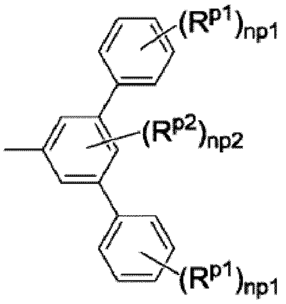
(D-A1)

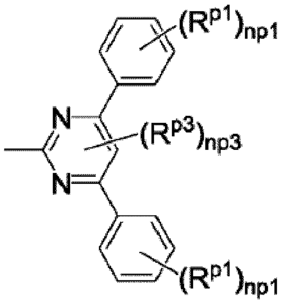
(D-A2)

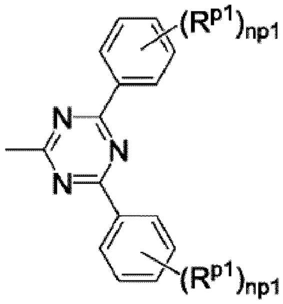
(D-A3)

wobei

$R^{p1}$, $R^{p2}$ und $R^{p3}$ jeweils unabhängig für eine Alkylgruppe, eine Cycloalkylgruppe oder ein Halogenatom stehen, und wenn mehrere $R^{p1}$ und $R^{p2}$ vorhanden sind, diese gleich oder verschieden bei jedem Auftreten sein können, und zumindest eines, das aus den mehreren $R^{p1}$ ausgewählt ist, eine Alkylgruppe mit 4 oder mehr Kohlenstoffatomen ist, und
np1 für eine ganze Zahl von 1 bis 5 steht, np2 für eine ganze Zahl von 0 bis 3 steht, und np3 für 0 oder 1 steht, und die mehreren np1 gleich oder verschieden sein können.

8. Metallkomplex nach Anspruch 7, wobei die durch die Formel (D-A) dargestellte Gruppe eine durch die Formel (D-A1) dargestellte Gruppe ist.

9. Metallkomplex nach einem der Ansprüche 1 bis 8, wobei M ein Iridiumatom ist.

10. Metallkomplex nach Anspruch 9, wobei $n_1$ 3 ist.

11. Zusammensetzung, umfassend
den Metallkomplex nach einem der Ansprüche 1 bis 10 und entweder
eine Verbindung, dargestellt durch die folgende Formel (H-1):

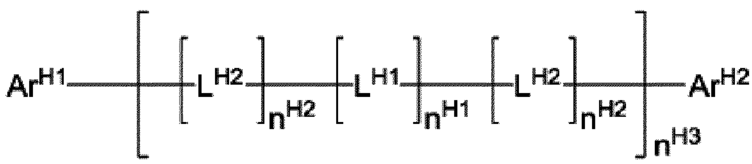
(H-1)

wobei

$Ar^{H1}$ und $Ar^{H2}$ jeweils unabhängig für eine Arylgruppe oder eine einwertige heterocyclische Gruppe stehen und diese Gruppen jeweils wahlweise einen Substituenten aufweisen,
$n^{H1}$ und $n^{H2}$ jeweils unabhängig für 0 oder 1 stehen, und wenn mehrere $n^{H1}$ vorhanden sind, diese gleich oder verschieden sein können, und die mehreren $n^{H2}$ gleich oder verschieden sein können,
$n^{H3}$ für eine ganze Zahl von 0 oder mehr steht,

$L^{H1}$ für eine Arylengruppe, eine zweiwertige heterocyclische Gruppe oder eine durch $-[C(R^{H11})_2]n^{H11}-$ dargestellte Gruppe steht, und diese Gruppen jeweils wahlweise einen Substituenten aufweisen, und wenn mehrere $L^{H1}$ vorhanden sind, diese gleich oder verschieden sein können,
$n^{H11}$ für eine ganze Zahl von 1 bis 10 steht, und $R^{H11}$ für ein Wasserstoffatom, eine Alkylgruppe, eine Cycloalkylgruppe, eine Alkoxygruppe, eine Cycloalkoxygruppe, eine Arylgruppe oder eine einwertige heterocyclische Gruppe steht und diese Gruppen jeweils wahlweise einen Substituenten aufweisen, und die mehreren $R^{H11}$ gleich oder verschieden sein können und miteinander kombiniert sein können, damit sie zusammen mit den Kohlenstoffatomen, an die sie gebunden sind, einen Ring bilden,
$L^{H2}$ für eine durch $-N(-L^{H21}-R^{H21})-$ dargestellte Gruppe steht, und wenn mehrere $L^{H2}$ vorhanden sind, diese gleich oder verschieden sein können, und
$L^{H21}$ für eine Einfachbindung, eine Arylengruppe oder eine zweiwertige heterocyclische Gruppe steht und diese Gruppen jeweils wahlweise einen Substituenten aufweisen, und $R^{H21}$ für ein Wasserstoffatom, eine Alkylgruppe, eine Cycloalkylgruppe, eine Arylgruppe oder eine einwertige heterocyclische Gruppe steht und diese Gruppen jeweils wahlweise einen Substituenten aufweisen, oder
eine Polymerverbindung, umfassend eine konstitutionelle Einheit, dargestellt durch die folgende Formel (Y):

$$\left[Ar^{Y1}\right] \qquad (Y)$$

wobei $Ar^{Y1}$ für eine Arylengruppe, eine zweiwertige heterocyclische Gruppe oder eine zweiwertige Gruppe steht, in der zumindest eine Arylengruppe und zumindest eine zweiwertige heterocyclische Gruppe direkt aneinander gebunden sind, und diese Gruppen jeweils wahlweise einen Substituenten aufweisen, oder
zumindest ein Material, ausgewählt aus der Gruppe, bestehend aus einem Löcher transportierenden Material, einem Löcherinjektionsmaterial, einem Elektronen transportierenden Material, einem Elektroneninjektionsmaterial, einem lichtemittierenden Material, einem Antioxidans und einem Lösungsmittel.

**12.** Lichtemittierende Vorrichtung, hergestellt durch Verwenden des Metallkomplexes nach einem der Ansprüche 1 bis 10.

## Revendications

**1.** Complexe métallique représenté par la formule (1-b) suivante :

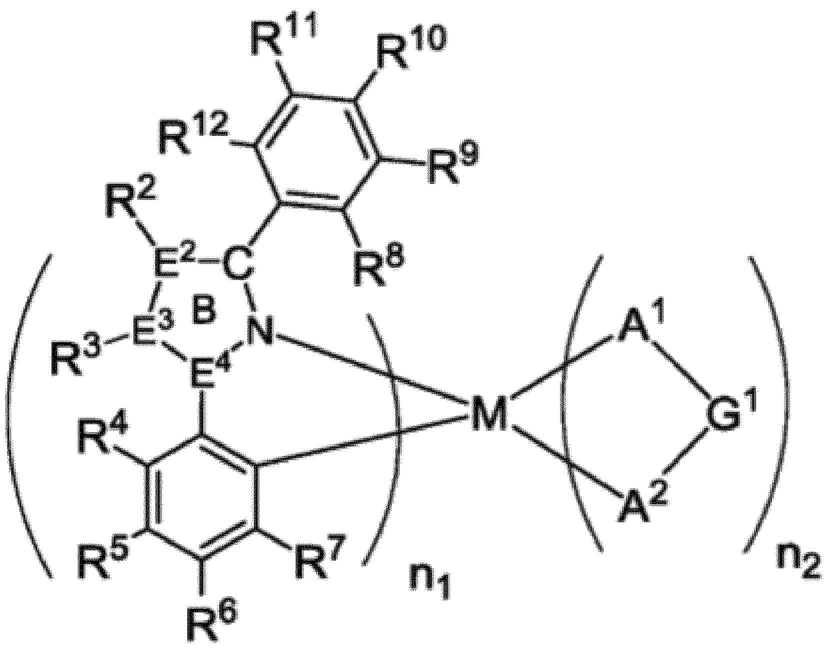

(1-b)

dans laquelle

M représente un atome d'iridium ou un atome de platine,
$n_1$ représente 1, 2 ou 3, $n_2$ représente 0, 1 ou 2, et $n_1+n_2 = 3$ lorsque M est un atome d'iridium, tandis que $n_1+n_2 = 2$ lorsque M est un atome de platine,
$E^2$ et $E^3$ représentent un atome d'azote, et $E^4$ représente un atome de carbone, et $R^2$ et $R^3$ peuvent être soit présents, soit non présents,
$R^2$ et $R^3$ représentent chacun indépendamment un atome d'hydrogène, un groupe alkyle, un groupe cycloalkyle, un groupe alcoxy, un groupe cycloalcoxy, un groupe aryle, un groupe aryloxy, un groupe hétérocyclique monovalent ou un atome d'halogène, et ces groupes comprennent chacun éventuellement un substituant, et lorsqu'une pluralité de $R^2$ et $R^3$ sont présents, ils peuvent être identiques ou différents à chaque occurrence,
$R^4$, $R^5$, $R^6$ et $R^7$ représentent chacun indépendamment un atome d'hydrogène, un groupe alkyle, un groupe cycloalkyle, un groupe alcoxy, un groupe cycloalcoxy, un groupe aryle, un groupe aryloxy, un groupe hétérocyclique monovalent ou un atome d'halogène, et ces groupes comprennent chacun éventuellement un substituant, et lorsqu'une pluralité de $R^4$, $R^5$, $R^6$ et $R^7$ sont présents, ils peuvent être identiques ou différents à chaque occurrence, et $R^4$ et $R^5$ peuvent être combinés ensemble pour former un cycle conjointement avec les atomes de carbone auxquels ils sont attachés, $R^5$ et $R^6$ peuvent être combinés ensemble pour former un cycle conjointement avec les atomes de carbone auxquels ils sont attachés, et $R^6$ et $R^7$ peuvent être combinés ensemble pour former un cycle conjointement avec les atomes de carbone auxquels ils sont attachés,
$R^8$, $R^{10}$ et $R^{12}$ représentent chacun indépendamment un atome d'hydrogène, un groupe alkyle, un groupe cycloalkyle, un groupe alcoxy, un groupe cycloalcoxy, un groupe aryle, un groupe aryloxy, un groupe hétérocyclique monovalent ou un atome d'halogène, et ces groupes comprennent chacun éventuellement un substituant, et
$R^9$ et $R^{11}$ représentent chacun indépendamment un groupe alkyle, et ce groupe alkyle comprend éventuellement un substituant, et
lorsqu'une pluralité de $R^8$, $R^9$, $R^{10}$, $R^{11}$ et $R^{12}$ sont présents, ils peuvent être identiques ou différents à chaque occurrence,
le cycle B représente un cycle triazole, et
$A^1$-$G^1$-$A^2$ représente un ligand bidentate anionique, $A^1$ et $A^2$ représentent chacun indépendamment un atome de carbone, un atome d'oxygène ou un atome d'azote, et ces atomes peuvent chacun être un atome constituant un cycle, $G^1$ représente une simple liaison ou un groupe atomique constituant le ligand bidentate conjointement avec $A^1$ et $A^2$, et, lorsqu'une pluralité de $A^1$-$G^1$-$A^2$ sont présents, ils peuvent être identiques ou différents.

2. Complexe métallique selon la revendication 1, représenté par la formule (1-c) suivante :

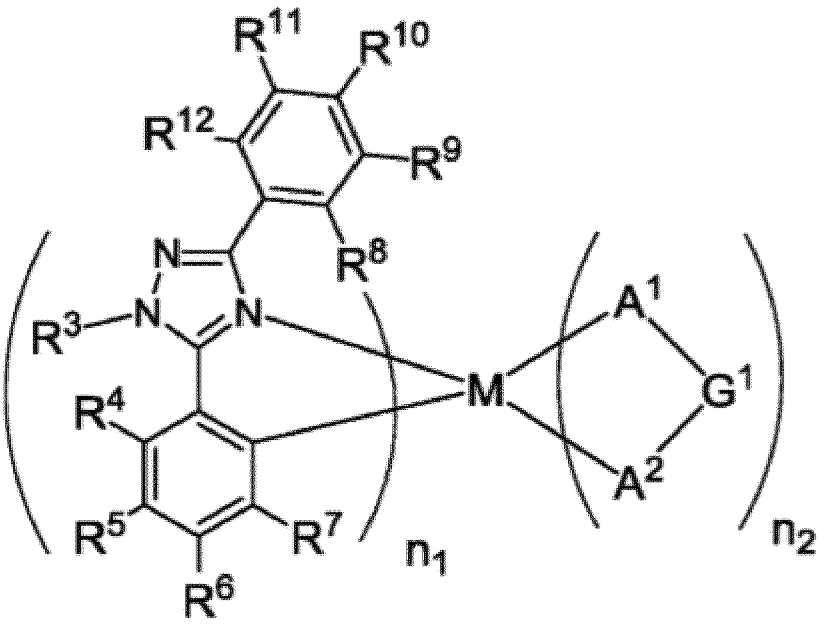

(1-c)

dans laquelle M, $n_1$, $n_2$, $R^3$, $R^4$, $R^5$, $R^6$, $R^7$, $R^8$ , $R^9$, $R^{10}$, $R^{11}$, $R^{12}$ et $A^1$-$G^1$-$A^2$ sont tels que définis dans la revendication 1.

**3.** Complexe métallique selon la revendication 1, représenté par la formule (1-d) suivante :

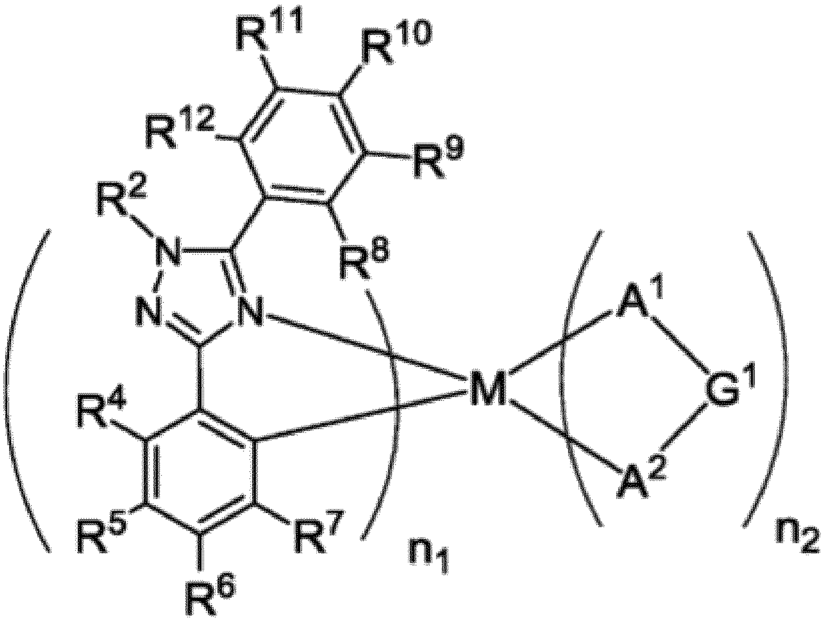

(1-d)

dans laquelle M, $n_1$, $n_2$, $R^3$, $R^4$, $R^5$, $R^6$, $R^7$, $R^8$ , $R^9$, $R^{10}$, $R^{11}$, $R^{12}$ et $A^1$- $G^1$-$A^2$ sont tels que définis dans la revendication 1.

**4.** Complexe métallique selon la revendication 2, représenté par la formule (1-e) suivante :

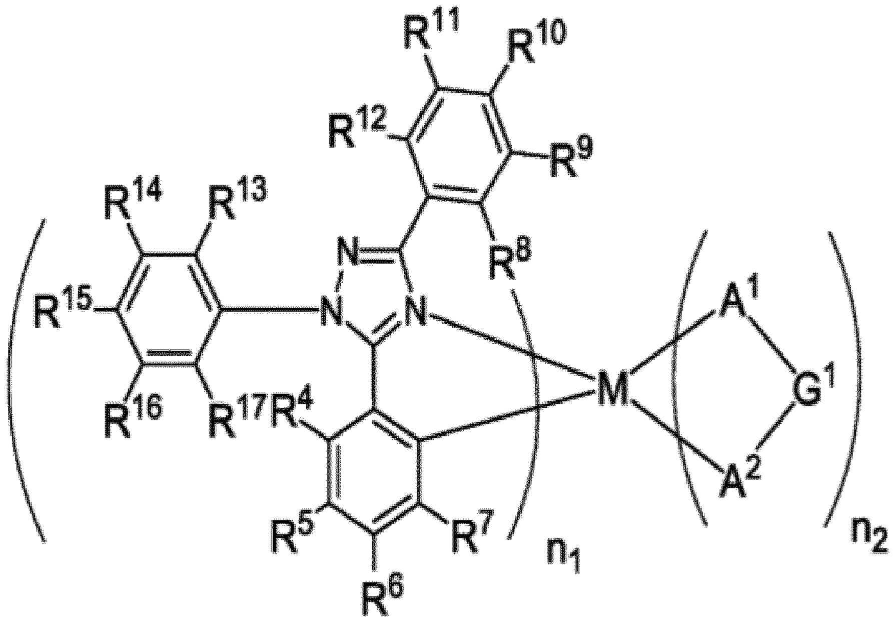

(1-e)

dans laquelle

M, $n_1$, $n_2$, $R^4$, $R^5$, $R^6$, $R^7$, $R^8$ , $R^9$, $R^{10}$, $R^{11}$, $R^{12}$ et $A^1$- $G^1$-$A^2$ sont tels que définis dans la revendication 1, et $R^{13}$, $R^{14}$, $R^{15}$, $R^{16}$ et $R^{17}$ représentent chacun indépendamment un atome d'hydrogène, un groupe alkyle, un groupe cycloalkyle, un groupe alcoxy, un groupe cycloalcoxy, un groupe aryle, un groupe aryloxy, un groupe hétérocyclique monovalent ou un atome d'halogène, et ces groupes comprennent chacun éventuellement un

substituant, et lorsqu'une pluralité de $R^{13}$, $R^{14}$, $R^{15}$, $R^{16}$ et $R^{17}$ sont présents, ils peuvent être identiques ou différents à chaque occurrence, et $R^{13}$ et $R^{14}$ peuvent être combinés ensemble pour former un cycle conjointement avec les atomes de carbone auxquels ils sont attachés, $R^{14}$ et $R^{15}$ peuvent être combinés ensemble pour former un cycle conjointement avec les atomes de carbone auxquels ils sont attachés, $R^{15}$ et $R^{16}$ peuvent être combinés ensemble pour former un cycle conjointement avec les atomes de carbone auxquels ils sont attachés, et $R^{16}$ et $R^{17}$ peuvent être combinés ensemble pour former un cycle conjointement avec les atomes de carbone auxquels ils sont attachés.

**5.** Complexe métallique selon l'une quelconque des revendications 1 à 4, dans lequel au moins un radical choisi dans le groupe constitué par $R^2$, $R^3$, $R^5$, $R^6$, $R^{10}$ et $R^{15}$ est un dendron.

**6.** Complexe métallique selon la revendication 5, dans lequel au moins un radical choisi dans le groupe constitué par $R^2$, $R^3$, $R^5$, $R^6$, $R^{10}$ et $R^{15}$ est un groupe représenté par la formule (D-A) ou (D-B) suivante :

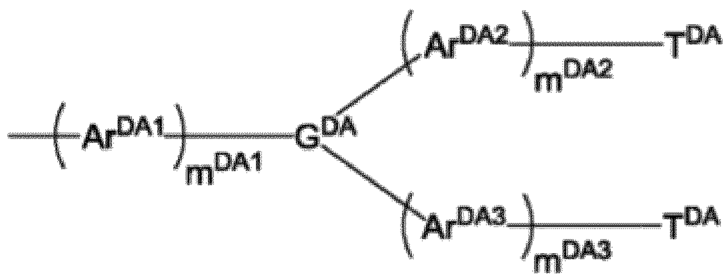

(D-A)

dans laquelle

$m^{DA1}$, $m^{DA2}$ et $m^{DA3}$ représentent chacun indépendamment un entier supérieur ou égal à 0,
$G^{DA}$ représente un groupe hydrocarboné aromatique ou un groupe hétérocyclique, et ces groupes comprennent chacun éventuellement un substituant,
$Ar^{DA1}$, $Ar^{DA2}$ et $Ar^{DA3}$ représentent chacun indépendamment un groupe arylène ou un groupe hétérocyclique bivalent, et ces groupes comprennent chacun éventuellement un substituant, et lorsqu'une pluralité d'$Ar^{DA1}$, $Ar^{DA2}$ et $Ar^{DA3}$ sont présents, ils peuvent être identiques ou différents à chaque occurrence, et
$T^{DA}$ représente un groupe aryle ou un groupe hétérocyclique monovalent, et ces groupes comprennent chacun éventuellement un substituant, et la pluralité de $T^{DA}$ peuvent être identiques ou différents,

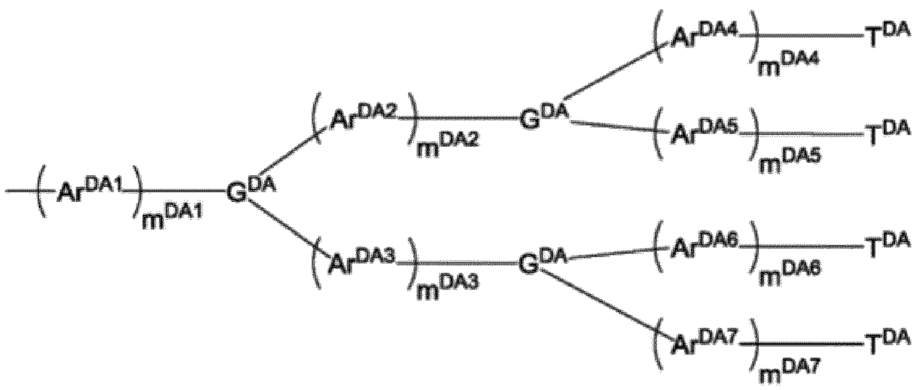

(D-B)

dans laquelle

$m^{DA1}$ $m^{DA2}$ , $m^{DA3}$, $m^{DA4}$, $m^{DA5}$ , $m^{DA6}$ et $m^{DA7}$ représentent chacun indépendamment un entier supérieur ou égal à 0,
$G^{DA}$ représente un groupe hydrocarboné aromatique ou un groupe hétérocyclique, et ces groupes comprennent chacun éventuellement un substituant, et la pluralité de $G^{DA}$ peuvent être identiques ou différents,
$Ar^{DA1}$, $Ar^{DA2}$, $Ar^{DA3}$, $Ar^{DA4}$, $Ar^{DA5}$, $Ar^{DA6}$ et $Ar^{DA7}$ représentent chacun indépendamment un groupe arylène ou un groupe hétérocyclique bivalent, et ces groupes comprennent chacun éventuellement un substituant, et, lorsqu'une pluralité d'$Ar^{DA1}$, $Ar^{DA2}$, $Ar^{DA3}$, $Ar^{DA4}$, $Ar^{DA5}$, $Ar^{DA6}$ et $Ar^{DA7}$ sont présents, ils peuvent être identiques

ou différents à chaque occurrence, et
$T^{DA}$ représente un groupe aryle ou un groupe hétérocyclique monovalent, et ces groupes comprennent chacun éventuellement un substituant, et la pluralité de $T^{DA}$ peuvent être identiques ou différents.

**7.** Complexe métallique selon la revendication 6, dans lequel le groupe représenté par la formule (D-A) est un groupe représenté par la formule (D-A1), (D-A2) ou (D-A3) suivante :

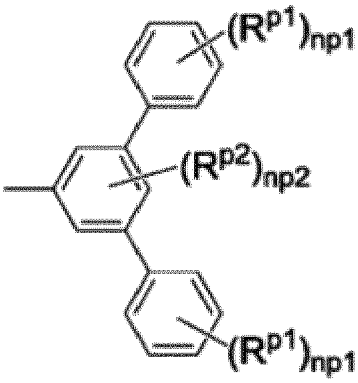
(D-A1)

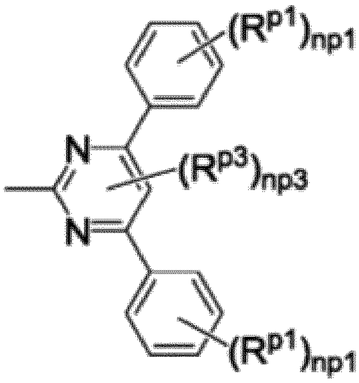
(D-A2)

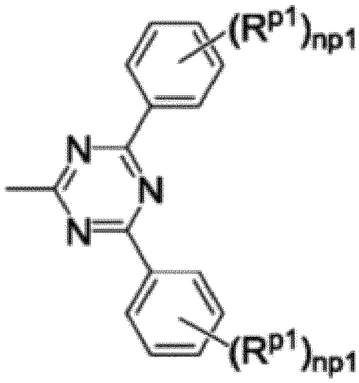
(D-A3)

dans lesquelles

$R^{P1}$, $R^{P2}$ et $R^{P3}$ représentent chacun indépendamment un groupe alkyle, un groupe cycloalkyle ou un atome d'halogène, et, lorsqu'une pluralité de $R^{P1}$ et $R^{P2}$ sont présents, ils peuvent être identiques ou différents à chaque occurrence, et au moins un radical choisi parmi la pluralité de $R^{P1}$ représente un groupe alkyle contenant 4 atomes de carbone ou plus, et
np1 représente un entier de 1 à 5, np2 représente un entier de 0 à 3, et np3 représente 0 ou 1, et la pluralité de np1 peuvent être identiques ou différents.

**8.** Complexe métallique selon la revendication 7, dans lequel le groupe représenté par la formule (D-A) est un groupe représenté par la formule (D-A1).

**9.** Complexe métallique selon l'une quelconque des revendications 1 et 8, dans lequel M est un atome d'iridium.

**10.** Complexe métallique selon la revendication 9, dans lequel $n_1$ représente 3.

**11.** Composition comprenant

le complexe métallique selon l'une quelconque des revendications 1 à 10, et soit
un composé représenté par la formule (H-1)

suivante :

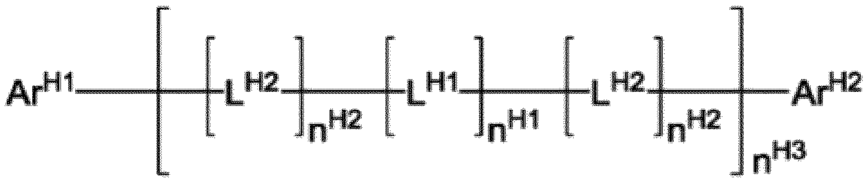
(H-1)

dans laquelle

$Ar^{H1}$ et $Ar^{H2}$ représentent chacun indépendamment un groupe aryle ou un groupe hétérocyclique monovalent, et ces groupes comprennent chacun éventuellement un substituant,
$n^{H1}$ et $n^{H2}$ représentent chacun indépendamment 0 ou 1, et, lorsqu'une pluralité de $n^{H1}$ sont présents, ils peuvent

être identiques ou différents, et la pluralité de $n^{H2}$ peuvent être identiques ou différents,
$n^{H3}$ représente un entier supérieur ou égal à 0,
$L^{H1}$ représente un groupe arylène, un groupe hétérocyclique bivalent ou un groupe représenté par $-[C(R^{H11})_2]n^{H11}-$ et ces groupes comprennent chacun éventuellement un substituant, et lorsqu'une pluralité de $L^{H1}$ sont présents, ils peuvent être identiques ou différents,
$n^{H11}$ représente un entier de 1 à 10, et $R^{H11}$ représente un atome d'hydrogène, un groupe alkyle, un groupe cycloalkyle, un groupe alcoxy, un groupe cycloalcoxy, un groupe aryle ou un groupe hétérocyclique monovalent, et ces groupes peuvent chacun éventuellement comprendre un substituant, et la pluralité de $R^{H11}$ peuvent être identiques ou différents, et peuvent être combinés ensemble pour former un cycle conjointement avec les atomes de carbone auxquels ils sont attachés,
$L^{H2}$ représente un groupe représenté par $-N(-L^{H21}-R^{H21})-$, et lorsqu'une pluralité de $L^{H2}$ sont présents, ils peuvent être identiques ou différents,
$L^{H21}$ représente une simple liaison, un groupe arylène ou un groupe hétérocyclique bivalent, et ces groupes comprennent chacun éventuellement un substituant, et $R^{H21}$ représente un atome d'hydrogène, un groupe alkyle, un groupe cycloalkyle, un groupe aryle ou un groupe hétérocyclique monovalent, et ces groupes comprennent chacun éventuellement un substituant, soit
un composé polymère comprenant une unité constitutionnelle représentée par la formule (Y) suivante :

$$\left[ Ar^{Y1} \right] \qquad (Y)$$

dans laquelle $Ar^{Y1}$ représente un groupe arylène, un groupe hétérocyclique bivalent ou un groupe bivalent dans lequel au moins un groupe arylène et au moins un groupe hétérocyclique bivalent sont reliés directement l'un à l'autre, et ces groupes comprennent chacun éventuellement un substituant, soit
au moins un matériau choisi dans le groupe constitué par un matériau de transport de trous, un matériau d'injection de trous, un matériau de transport d'électrons, un matériau d'injection d'électrons, un matériau d'émission de lumière, un antioxydant et un solvant.

**12.** Dispositif d'émission de lumière produit en utilisant le complexe métallique selon l'une quelconque des revendications 1 à 10.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*


### Patent documents cited in the description

- US 20140151659 A
- JP 2013147551 A
- US 2014167001 A
- WO 02067343 A
- JP 2003231692 A
- WO 2003079736 A
- WO 2006097717 A
- WO 2002067343 A
- JP 2010189630 A
- WO 2015008851 A

### Non-patent literature cited in the description

- *Journal of the American Chemical Society,* 2009, vol. 131, 16681
- *Tetrahedron Letters,* 1968, 325
- *Bioorganic & Medicinal Chemistry,* 2004, vol. 12, 2013
- *European Journal of Organic Chemistry,* 2011, 3197
- *Chem. Rev.,* 2009, vol. 109, 897-1091